(19) **Europäisches Patentamt**

**European Patent Office**

**Office européen des brevets**

(11) **EP 1 079 635 A1**

(12) **EUROPEAN PATENT APPLICATION**
published in accordance with Art. 158(3) EPC

(43) Date of publication:
28.02.2001 Bulletin 2001/09

(51) Int. Cl.$^7$: **H04N 7/28**, H03M 7/30

(21) Application number: 99914764.8

(86) International application number:
PCT/JP99/02049

(22) Date of filing: 19.04.1999

(87) International publication number:
WO 99/55093 (28.10.1999 Gazette 1999/43)

(84) Designated Contracting States:
**DE FR GB NL SE**

(30) Priority: 17.04.1998 JP 12428498
17.04.1998 JP 12428698
23.07.1998 JP 20836698
23.07.1998 JP 20836498
27.10.1998 JP 30533698
12.03.1999 JP 6708699

(71) Applicants:
• **Ultraclean Technology Research Institute, Co. Ltd**
**Tokyo 113-0033 (JP)**
• **Ohmi, Tadahiro**
**Sendai-shi, Miyagi-ken 980-0813 (JP)**

(72) Inventors:
• **OHMI, Tadahiro**
**Sendai-shi, Miyagi 980-0813 (JP)**
• **KOTANI, Koji**
**Chiba-shi, Chiba 261-0005 (JP)**
• **NAKADA, Akira**
**Tokyo 121-0055 (JP)**
• **IMAI, Makoto,**
**Tohoku University**
**Sendai-shi, Miyagi 980-8579 (JP)**

• **KONDA, Masahiro,**
**Tohoku University**
**Sendai-shi, Miyagi 980-8579 (JP)**
• **MORIMOTO, Tatsuo,**
**Tohoku University**
**Sendai-shi, Miyagi 980-8579 (JP)**
• **YONEZAWA, Takemi,**
**Tohoku University**
**Sendai-shi, Miyagi 980-8579 (JP)**
• **NOZAWA, Toshiyuki,**
**Tohoku University**
**Sendai-shi, Miyagi 980-8579 (JP)**
• **NAKAYAMA, Takahiro,**
**Tohoku University**
**Sendai-shi, Miyagi 980-8579 (JP)**
• **FUJIBAYASHI, Masanori,**
**Tohoku University**
**Sendai-shi, Miyagi 980-8579 (JP)**
• **NITTA, Takahisa,**
**Ultraclean Tech. Res. Inst.Co.Ltd**
**Tokyo 113-0033 (JP)**

(74) Representative:
**VOSSIUS & PARTNER**
**Siebertstrasse 4**
**81675 München (DE)**

(54) **DATA COMPRESSING DEVICE AND METHOD, DATA EXPANDING DEVICE AND METHOD, DATA COMPRESSING/EXPANDING SYSTEM AND METHOD, CODE BOOK MAKING METHOD, AND VECTOR QUANTIZING DEVICE AND METHOD**

(57) A correlation ratio calculation section (36) quantizes the vectors of each frame of a moving picture by using a space direction code book. A space direction code book reconstruction calculating section (39) rearranges obtained code string to generate new vectors. The correlation ratio calculation section (36) quantizes the new vectors by using a time-axis code book. In such a way, not only vector quantization in the space direction is performed for each frame image, but also vector quantization in the time-axis direction is performed between frames along the time axis.

FIG. 9

## Description

Technical Field

The present invention relates to a data compressing device and method, a data expanding device and method, a data compressing/expanding system and method, a code book making method, and a vector quantizing device and method, and also a recording medium which stores a program for executing these processing operations.

Background Art

Various data compressing methods have been conventionally proposed. Of these methods, a method called "vector quantization" is well known as a data compression algorithm capable of very easily expanding compressed data. This algorithm is known in the field of signal processing for a long time and particularly applied to data compression of an image signal or a voice signal, or pattern recognition.

In this vector quantization, some pixel patterns (also called template vectors or code vectors) each having a certain size (e.g., a block of $4 \times 4$ pixels) are prepared and assigned unique numbers (this set is called a code book). For example, blocks having the same size (e.g., $4 \times 4$ pixels) are sequentially extracted from two-dimensional image data, and a pattern most similar to each block is extracted from the code book, and the pattern number is assigned to the block, thereby compressing the data. In vector quantization, a data string in one block corresponds to one vector.

On the receiving side or expanding side of such coded compressed data, the original image can be reconstructed only by extracting a pattern corresponding to a code number from the code book in units of blocks. Hence, when the expanding side has received or holds in advance the code book, the original image can be reconstructed by very simple hardware because no special calculation is necessary.

Subjects of the above-described vector quantization are, for example, in data compression of an image or voice signal, how to obtain a high-quality reconstructed image or reconstructed voice while holding a high compression ratio, and how to make a code book with high performance, which is always required for execution of vector quantization.

Conventionally, to realize a high compression ratio, examinations have been made, e.g., to increase the size of a block to be extracted from image data or decrease the number of blocks constructing a code book. In addition, to optimize the code book, some methods are used, represented by the Kohonen self-organizing map method.

However, for example, when a high compression ratio should be realized in compressing image data using vector quantization, the quality of reconstructed image inevitably degrades. Conversely, when the quality of reconstructed image should be increased, processing other than vector quantization is required, and consequently, the compression ratio does not increase.

The vector quantizing technique used for image data compression is designed to execute vector quantization for a still image. Compression of a moving picture is realized by executing vector quantization for each frame and additionally combining a techniques other than vector quantization. Hence, for a moving picture, the compression ratio is not high, and the image quality is not high, either.

The code book optimizing technique such as the Kohonen self-organizing map method optimizes a code book by performing appropriate equation processing using, e.g., a sample image. Hence, a resultant code book is useful for only data used for optimization.

More specifically, a code book optimized using image data of a person's face is the best code book for the image used for optimization. However, the code book is not always the best for other images. For example, when the code book is used for data compression of image data of another person's face, the quality of the image reconstructed from the compressed data is poor.

In addition, although a relatively high quality is obtained for a reconstructed image included in the same category "human face" as the image used for optimization, the image quality often degrades for an image in a different category such as "landscape" or "character". That is, since the pattern of the code book changes depending on the image, the code book is not so versatile.

In addition, the vector quantizing technique using a code book requires a large amount of calculation for processing of searching a code book for the code vector of a pattern most similar to an input vector or processing of extracting a code vector corresponding to a compression code from a code book and displaying the code vector, resulting in time-consuming processing.

The present invention has been made to solve the above problems, and aims to realize data compression at a high compression ratio in executing data compression of, e.g., an image or voice signal by vector quantization and also reconstruct high-quality data on the basis of the compressed data obtained by that data compression.

It is another object of the present invention to realize a versatile code book which has high performance and is compatible to various kinds of images.

It is still another object of the present invention to improve the processing speed of compression using vector quantization and that of image rearrangement by expansion.

As described above, in a vector quantizing device, search processing of finding data similar to the input vector data of an original image from the template vector group in a code book must be performed. As a means for determining whether two vector data are similar to each other, a means has been used in which two vector data are input to a predetermined function and calculated, the degree of similarity therebetween is expressed as a numerical value, and determination is done on the basis of the magnitude of this numerical value.

The numerical value representing the degree of similarity between two units of vector data is called "similarity". A representative example of the function for obtaining the similarity is a function for obtaining the Manhattan distance or Euclidean distance between two input vector data. An arbitrary function can be used in accordance with the purpose.

The Manhattan distance is obtained by calculating the absolute difference value between two units of input vector data for each element of vector data and adding all absolute difference values calculated for each element. The Euclidean distance is obtained by calculating the square-sum of such absolute difference values.

However, in the conventional vector quantizing device, in finding data similar to input vector data from the template vector data group, the similarity to input vector data must be calculated for all template vector data in order to find the most similar vector data. Hence, when the number of units of template vector data is enormous, the amount of calculation for determining whether each unit of data is similar to the input vector data is enormous accordingly.

The present invention has also been made to solve this problem, and aims to decrease the amount of calculation for expressing the degree of similarity between template vector data and input vector data in executing vector quantization so as to realize high-speed vector quantization processing with low power consumption.

Summary of the Invention

According to the first invention, there is provided a data compressing device which segments a data string including at least one unit of data into blocks forming vectors, searches a code book prepared in advance for a code vector similar to a vector extracted from a compression target, and outputs a code corresponding to the code vector, characterized in that the block forming the vector is a line block in which data positions are one-dimensionally arrayed.

According to the first invention, the block forming the vector used for vector quantization is a line block in which data positions are one-dimensionally arrayed. For this reason, when, e.g., image data is used as a compression target, the data construction in the line block can match the scanning direction of the reconstructing device, and the address conversion operation in expansion/rearrangement, which is necessary for a conventional macroblock, can be avoided. Hence, the time required to display the reconstructed image can be greatly shortened.

According to the second invention, there is provided a data compressing device which segments a data string including at least one unit of data into blocks forming vectors, searches a code book prepared in advance for a code vector similar to a vector extracted from a compression target, and outputs a code corresponding to the code vector, characterized by comprising block shift means for extracting the block forming the vector of the compression target from the compression target while shifting a spatial position in a horizontal direction at least between blocks close to each other in a vertical direction.

According to the third invention, there is provided a data expanding device which uses a data string including at least one unit of data as a vector, searches a code book having at least one code vector for a code vector corresponding to a compression code, and allocates the code vector to a corresponding block position to reconstruct original data, characterized by comprising block shift means for allocating the block constructing the code vector searched from the code book while shifting a spatial position in a horizontal direction at least between blocks close to each other in a vertical direction.

According to the second and third inventions, in compression, the block forming the vector used for vector quantization is extracted from the compression target while shifting its spatial direction in the horizontal direction at least between blocks close to each other in the vertical direction, or in expansion, the block constructing the code vector searched from the code book is allocated while shifting its spatial position in the horizontal direction at least between blocks close to each other in the vertical direction. For this reason, when, e.g., image data is used as a compression target, the continuity at the block boundaries on the reconstructed image can be broken to make the block boundaries (quantization errors) unnoticeable. Hence, a high-quality reconstructed image can be obtained while keeping the compression ratio.

According to the fourth invention, there is provided a data compressing device which segments a data string including at least one unit of data into blocks forming vectors, searches a code book prepared in advance for a code vector similar to a vector extracted from a compression target, and outputs a code corresponding to the code vector, characterized by comprising first vector quantizing means for, for data at each time in the compression target which changes along a time axis, extracting blocks from the data, searching a first code book for a code vector similar to the vector, and outputting a code string corresponding to the code vector at each time, and second vector quantizing means for rearranging code strings output by the first vector quantizing means at respective times to generate new vectors, and for each of the new vectors, searching a second code book for a code vector similar to the vector, and outputting a code string corresponding to the code vector.

According to the fifth invention, there is provided a data compressing device which segments a data string including at least one unit of data into blocks forming vectors, searches a code book prepared in advance for a code vector similar to a vector extracted from a compression target, and outputs a code corresponding to the code vector, characterized by comprising first vector quantizing means for, for data at each time in the compression target which changes along a time axis, extracting blocks from the data, searching a first code book for a code vector similar to the vector, and outputting a code string corresponding to the code vector at each time, and second vector quantizing means for defining, as a reference code string, a code string of data at a certain time in the code strings output from the first vector quantizing means at respective times, rearranging difference results each calculated for codes at a corresponding address between the reference code string and a code string of data at another time so as to generate new vectors, and for each of the new vectors, searching a second code book for a code vector similar to the vector, and outputting a code string corresponding to the code vector.

According to the sixth invention, there is provided a data compressing device which segments a data string including at least one unit of data into blocks forming vectors, searches a code book prepared in advance for a code vector similar to a vector extracted from a compression target, and outputs a code corresponding to the code vector, characterized by comprising first vector quantizing means for, for data at each time in the compression target which changes along a time axis, extracting blocks from the data, searching a first code book for a code vector similar to the vector, and outputting a code string corresponding to the code vector at each time, and second vector quantizing means for rearranging difference results each calculated for codes at a corresponding address in the code strings output from the first vector quantizing means at respective times between units of data adjacent in a time-axis direction so as to generate new vectors, and for each of the new vectors, searching a second code book for a code vector similar to the vector, and outputting a code string corresponding to the code vector.

According to the fourth to sixth inventions, in vector quantization of the compression target which changes along the time axis, not only space direction vector quantization for one data string in the same time but also time-axis direction vector quantization between data strings along the time axis is executed. For this reason, data compression can be done not only in each frame of a moving picture but also between the frames. Hence, a moving picture can be compressed at a high compression ratio while maintaining the high quality of the reconstructed image.

According to the seventh invention, the data compressing device is characterized by further comprising time-axis shift means for, in generating the new vectors, arranging elements in the new vector while shifting the elements in the time-axis direction at least between vectors close to each other.

In addition, the expanding side where processing opposite to that of the data compressing device of the fourth to sixth inventions is executed is characterized by comprising time-axis shift means for, in generating the new vectors, arranging at least elements close to each other in the new vector while shifting the elements in the time-axis direction.

According to the seventh invention, in generating the new vectors for vector quantization in the time-axis direction in compression, the elements in the new vector are arranged while shifting the elements in the time-axis direction at least between vectors close to each other, or in expansion, in generating the new vectors for processing opposite to that of compression, at least elements close to each other in the new vector are arranged while shifting the elements in the time-axis direction. For this reason, when, e.g., a moving picture is used as a compression target, the quantization errors which become perceivable as the image at each time is reconstructed in expansion can be made unnoticeable. Hence, a high-quality reconstructed image can be obtained while keeping the high compression ratio of the moving picture.

According to the eighth invention, there is provided a data compressing device which segments a data string including at least one unit of data into blocks forming vectors, searches a code book prepared in advance for a code vector similar to a vector extracted from a compression target, and outputs a code corresponding to the code vector, characterized by comprising separation means for extracting at least one feature amount from the compression target and separating feature amount data from basic pattern data obtained by excluding the feature amount from the compression target, wherein vector quantization is independently executed for each of the separated feature amount data and basic pattern data.

According to the eighth invention, at least one feature amount is extracted from the compression target, feature amount data is separated from the remaining basic pattern data, and vector quantization is independently executed for each of the separated feature amount data and basic pattern data. In this case, as compared to a code book for the compression target itself which includes various characteristic features, the code book used for vector quantization of each data can be simplified, and the number of necessary patterns can be reduced. This makes it possible to easily search patterns having large similarity by vector quantization and narrow down them to more appropriate patterns, and accurate vector quantization can be executed. Hence, when, e.g., image data is used as a compression target, a high-quality reconstructed image can be obtained while keeping a high compression ratio.

According to the ninth invention, there is provided a data compressing device which segments a data string including at least one unit of data into blocks forming vectors, searches a code book prepared in advance for a code vector similar to a vector extracted from a compression target, and outputs a code corresponding to the code vector, characterized by comprising vector quantizing means for, for data at each time in the compression target which changes along a time axis, extracting blocks from the data, searching the code book for a code vector similar to each of the vectors, and outputting a code string corresponding to the code vectors at each time, and output control means for, for the code string output from the vector quantizing means at each time, obtaining correlation between codes at a corresponding address between units of data adjacent in the time-axis direction and outputting the code only for an address where the correlation is smaller than a predetermined value.

According to another aspect of the ninth invention, the data compressing device is characterized by comprising output control means for, for feature amount of each code vector searched by the vector quantizing means at each time, obtaining correlation between feature amounts at a corresponding address between units of data adjacent in the time-axis direction and outputting the code only for an address where the correlation is smaller than a predetermined value.

According to the ninth invention, vector quantization is executed for data at each time of the compression target which changes along the time axis, and for a code string obtained at each time or the feature amount of a code vector corresponding to the code string, only the code of a portion having small correlation in the time-axis direction is output. When, e.g., a moving picture is used as a compression target, only data whose data value largely changes between frames can be transferred, and transfer of data having a small change can be inhibited. Hence, in addition to space direction vector quantization result in each frame, the data can also be compressed between the frames, so a moving picture can be compressed/transferred at a high compression ratio.

According to the 10th invention, there is provided a data compressing device which segments a data string including at least one unit of data into blocks forming vectors, searches a code book prepared in advance for a code vector similar to a vector extracted from a color image as a compression target, and outputs a code corresponding to the code vector, characterized by comprising a code book for luminance signals and a code book for chrominance signals, the code book for luminance signals being assigned a larger number of code vectors than the code book for chrominance signals.

According to the 10th invention, in vector quantization of a color image, the code book for luminance signals is assigned a larger number of code vectors than the code book for chrominance signals. For this reason, for a luminance signal which is more important for the image quality, a code vector having larger similarity can be obtained by vector quantization. Hence, when the total code length is kept unchanged, the quality of the reconstructed image can be improved while maintaining the compression ratio.

According to the 11th invention, there is provided a code book making method of making a code book which is formed from a set of vectors as data strings each including at least one unit of data and is to be used for vector quantization, in which vector quantization processing is repeatedly executed using certain sample data and an initial code book, and contents in a range designated on a virtual two-dimensional plane of the code book are updated in accordance with a predetermined update coefficient for every processing step so as to optimize the code book, characterized in that a code book of patterns each having a data value continuously changing from a minimum value to a maximum value of possible values is used as the initial code book,.

This method is also characterized in that the range to be updated by one processing step is one-dimensionally applied on the virtual two-dimensional plane and the range is reduced as the number of times of update increases.

This method is also characterized in that an initial value of the update coefficient to one value is set within a range of 0.3 to 1 and the value of the update coefficient is reduced as the number of times of update increases.

According to the 11th invention, in making a code book, a code book of patterns each having a data value continuously changing from a minimum value to a maximum value of possible values is used as the initial code book, the range to be updated by one processing is one-dimensionally applied on the virtual two-dimensional plane, the range is reduced as the number of times of update increases, the initial value of the update coefficient is set to one value within the range of 0.3 to 1, and the value of the update coefficient is decremented as the number of times of update increases. For this reason, the code book can be more efficiently optimized, and an accurate code book can be obtained. When the code book made in this way is used for, e.g., an image data compressing/expanding system, the quality of the reconstructed image can be improved.

According to the 12th invention, there is provided a code book making method of making a code book which is formed from a set of vectors as data strings each including at least one unit of data and is to be used for vector quantization, in which vector quantization processing is repeatedly executed using sample data and an initial code book, and contents in a range designated on a virtual two-dimensional plane of the code book are updated in accordance with a predetermined update coefficient for every processing step so as to optimize the code book, characterized in that the code book for units of sample data is independently optimized and code books obtained are synthesized to make a new code book.

According to the 12th invention, in making a code book, the code book is independently optimized for units of sample data, and code books obtained are synthesized to make a new code book. For this reason, a code book having versatility to various images can be made. Hence, a versatile code book can be obtained without increasing the size of the device for storing the code book.

The 13th invention is characterized by comprising feature amount storage means for storing a feature amount obtained in advance for each code vector in the code book, feature amount calculating means for obtaining a feature amount of the vector extracted from the compression target, and calculation omitting means for determining whether calculation for obtaining similarity between each of the code vectors and the compression target vector is to be omitted on the basis of the feature amount of each code vector, which is stored in the feature amount storage means, and the feature amount of the compression target vector.

According to the 13th invention, the feature amount of the vector extracted from the compression target and that of each code vector in the code book are compared, and it is determined on the basis of the comparison result whether calculation for obtaining similarity between each of the code vectors and the compression target vector is to be omitted. For this reason, by calculating the feature amount for which the calculation amount is smaller than that of similarity calculation, the similarity calculation can be appropriately omitted. In performing operation of searching a code vector similar to the compression target vector, the amount of calculation necessary for the search can be reduced, and vector quantization calculation can be executed at a high speed as a whole.

According to the 14th invention, there is provided a data compressing/expanding system comprising a code book server for holding at least one code book, a data compressing system, and a data expanding system, characterized in that the code book server supplies one of the held code books in accordance with a request from the data compressing system or the data expanding system.

According to the 14th invention, the code book which is always necessary in compression/expansion using vector quantization is prepared independently of the data compressing/expanding system. For this reason, the data compressing/expanding system need not hold the code book and need only transfer only actual data, so data can be transferred using a smaller-capacity medium. Hence, a very simple data transfer system can be implemented.

The 15th invention is characterized in that, in the ninth invention, the output control means outputs the code string output from the vector quantizing means for some or all addresses independently of whether the correlation is smaller than the predetermined value at a certain time.

According to the 15th invention, in association with the ninth invention, the code string output from the vector quantizing means for some or all addresses independently of whether the correlation is smaller than the predetermined value is output at a certain time. Hence, even when the correlation is smaller than the predetermined value, and the data in the previous frame is directly and continuously used, this state can be broken by transmission of updated data, and degradation in image quality along with the elapse of time can be suppressed.

A vector quantizing device of the present invention is a vector quantizing device which has search means for searching template vector data similar to input vector data from units of template vector data stored and outputting a code of the searched template vector data, characterized by comprising search target selection means for, in executing the search, comparing a feature amount of the input vector data with a feature amount of the template vector data and selecting template vector data as a search target on the basis of a comparison result.

In the present invention, a vector quantizing device means a device having search means for searching template vector data most similar to input vector data or similar to a degree that poses no practical problem from a stored template vector data group and outputting, as a code, the value or address of the searched template vector data, or an index number assigned to the template vector data.

In the present invention, vector data means a vector as a set of pieces of information represented by numerical values. Template vector data means individual vector data which form a set of vector data prepared in advance. Each template vector data may be assigned an index number or the like. This template vector data group may be generally called a code book. Input vector data means vector data input to the vector quantizing device.

In the present invention, a feature amount means a scalar amount directly representing the characteristic of vector data. Examples of feature amounts are the sum or average value of elements of vector data, or variance of elements of vector data. However, the present invention is not limited to these examples.

Another aspect of the present invention is characterized in that the search target selection means selects the template vector data as the search target using feature amounts of different types.

All elements of the vector data may be divided into parts, and the template vector data as the search target may be selected using a feature amount of each divided element.

Still another aspect of the present invention is characterized in that the search means comprises two or more similarity calculating means for parallelly reading units of template vector data selected by the search target selection means as the search targets and parallelly searching for template vector data similar to the input vector data, and

template specifying means for specifying template vector data most similar to the input vector data on the basis of calculation results from the two or more similarity calculating means and outputting a corresponding code.

According to the present invention, there is also provided a vector quantizing method in which template vector data similar to input vector data is searched from units of template vector data stored, and a code of the searched template vector data is output, characterized in that, in executing the search, a feature amount of the input vector data is compared with a feature amount of the template vector data and template vector data is selected as a search target on the basis of a comparison result.

A computer-readable recording medium of the present invention is characterized in that the recording medium records a program for causing a computer to function as the means of any one of claims 81 to 84.

The recording medium may record a program for causing a computer to realize the function of any one of claims 91 to 95.

The recording medium may record a program for causing a computer to execute a processing procedure of the vector quantizing method of any one of claims 98 to 102.

According to the present invention, since the feature amount of input vector data and that of template vector data are compared, and template vector data as a search target is selected on the basis of the comparison result, the range of search targets can be limited to a narrow range, and the amount of calculation for obtaining the similarity between the input vector data and template vector data can be reduced. Hence, vector quantization calculation can be executed at a high speed as a whole.

According to another characteristic feature of the present invention, since template vector data as a search target is selected using feature amounts of different types, the range of search targets can be limited to a narrower range, and vector quantization calculation can be executed at a higher speed.

According to still another characteristic feature of the present invention, since a mechanism for parallelly processing units of template vector data as search targets is employed, vector quantization calculation can be executed at a higher speed.

Brief Description of the Drawings

Fig. 1 is a block diagram showing the construction of a data compressing device according to the first embodiment;

Fig. 2 is a block diagram showing the construction of a data expanding device according to the first embodiment;

Fig. 3 is a flow chart showing the operation of the data compressing device according to the first embodiment;

Fig. 4 is a flow chart showing the operation of the data expanding device according to the first embodiment;

Fig. 5 shows illustrations for explaining a feature of the first embodiment using a line block as vector data, in which Fig. 5(a) is an illustration showing a conventional macroblock scheme, and Fig. 5(b) is an illustration showing a line block scheme of this embodiment;

Fig. 6 is an illustration for explaining the feature of the first embodiment in which the line block pasting position is shifted;

Fig. 7 is an illustration showing a time required for compression/expansion processing of one image having 640 × 480 pixels;

Fig. 8 is an illustration for explaining the flow of data in an entire vector quantizing system;

Fig. 9 is a block diagram showing the construction of a data compressing device according to the second to fourth embodiments;

Fig. 10 is a block diagram showing the construction of a data expanding device according to the second to fourth embodiments;

Fig. 11 is a data flow chart showing the flow of data in compression according to the second embodiment;

Fig. 12 is a data flow chart showing the flow of data in compression according to the third embodiment;

Fig. 13 is a data flow chart showing the flow of data in compression according to the fourth embodiment;

Fig. 14 is a block diagram for explaining the fifth embodiment;

Fig. 15 is a block diagram showing the construction of a data compressing device according to the seventh embodiment;

Fig. 16 is a data flow chart showing the flow of data in compression according to the seventh embodiment;

Fig. 17 is a block diagram showing the construction of a data compressing device according to the eighth embodiment;

Fig. 18 is a block diagram showing a construction which implements the data compressing device according to the eighth embodiment by software;

Fig. 19 is a flow chart showing the operation of the data compressing device according to the eighth embodiment;

Fig. 20 is a block diagram showing the construction of a data compressing device according to the ninth embodiment;

Fig. 21 is an illustration for explaining a code book making method according to the 10th embodiment;

Fig. 22 shows illustrations of the 10th embodiment so as to explain the difference in PSNR characteristic when an initial code book is given in various ways, in which Fig. 22(a) is an illustration showing a pattern which continuously changes the luminance value from the minimum value to the maximum value of possible values, Fig. 22(b) is an illustration showing a pattern which changes the luminance value at random, and Fig. 22(c) is an illustration showing a pattern having a predetermined luminance value of 128 (intermediate value);

Fig. 23 shows illustrations of the 10th embodiment so as to explain the difference in PSNR characteristic when a rewrite pattern is changed in various ways, in which Fig. 23(a) is an illustration showing a method of one-dimensionally applying the rewrite range in one learning cycle on a map and reducing the rewrite range as the number of times of update increases, and Fig. 23(b) is an illustration showing a method of two-dimensionally applying the rewrite range and reducing the rewrite range as the number of times of update increases;

Fig. 24 is a graph showing the 10th embodiment so as to explain the difference in PSNR characteristic when the manner the gain is given is changed in various ways;

Fig. 25 is a graph showing the 10th embodiment to explain the difference in PSNR characteristic when the initial value of gain is given in various ways;

Fig. 26 is an illustration for explaining the 11th embodiment, which shows a method of combining the characteristic features of three code books A, B, and C into one code book $A + B + C$ ;

Fig. 27 is a graph showing the PSNR characteristic so as to explain the 11th embodiment;

Fig. 28 is a block diagram showing the construction of a data compressing device according to the 12th embodiment;

Fig. 29 is a flow chart showing the operation of the data compressing device according to the 12th embodiment;

Fig. 30 is an illustration for explaining the 13th embodiment;

Fig. 31 is a graph for explaining the 13th embodiment;

Fig. 32 is an illustration for explaining the 14th embodiment;

Fig. 33 is an illustration for explaining the 14th embodiment;

Fig. 34 is an illustration for explaining the 14th embodiment;

Fig. 35 shows illustrations for explaining the 14th embodiment, in which (a) is an illustration showing an image block 131, and the size comparison pattern between pixels at the four corners of the image block;

Fig. 36 is an illustration for explaining the 14th embodiment;

Fig. 37 is a block diagram showing the construction of a data compressing device according to the 14th embodiment;

Fig. 38 is a block diagram showing the construction of a data compressing/expanding system according to the 15th embodiment;

Fig. 39 is a data flow chart for explaining a space direction code number reconstruction method according to the 16th embodiment;

Fig. 40 is a data flow chart showing the flow of data in compression when the space direction code number reconstruction manner according to the 16th embodiment is applied to the second embodiment;

Fig. 41 is a block diagram showing the construction of a data compressing device according to the 16th embodiment;

Fig. 42 is a block diagram showing the construction of a data expanding device according to the 16th embodiment;

Fig. 43 is a data flow chart showing the flow of data in compression when the space direction code number reconstruction manner according to the 16th embodiment is applied to the third embodiment;

Fig. 44 is a data flow chart showing the flow of data in compression when the space direction code number reconstruction manner according to the 16th embodiment is applied to the fourth embodiment;

Fig. 45 is a block diagram showing the construction of a data compressing device when the space direction code number reconstruction manner of the 16th embodiment is applied to the seventh embodiment;

Fig. 46 is a table showing the relationships between compression ratios and space direction code number reconstruction methods;

Fig. 47 is a block diagram showing the construction of a data compressing system according to the 17th embodiment;

Fig. 48 shows illustrations for explaining the second method of data update processing according to the 18th embodiment, in which Fig. 48(a) is an illustration showing a frame at a certain time t, Fig. 48(b) is an illustration showing the frame at time (t + 1), Fig. 48(c) is an illustration showing the frame at time (t + 2), and Fig. 48(d) is an illustration showing the frame at time (t + 4);

Fig. 49 shows illustrations for explaining the third method of data update processing according to the 18th embodiment, in which Fig. 49(a) is an illustration showing a frame at a certain time t, Fig. 49(b) is an illustration showing the frame at time (t + 1), Fig. 49(c) is an illustration showing the frame at time (t + 2), and Fig. 49(d) is an illustration showing the frame at time (t + 4);

Fig. 50 is a block diagram showing the construction of a vector quantizing device according to the 19th embodiment;

Fig. 51 is an illustration showing the construction of a vector quantizing device according to the 23rd embodiment;

Fig. 52 is an illustration showing the construction of a vector quantizing device according to the 24th embodiment;

Fig. 53 is an illustration showing the construction of a similarity calculating/storage unit shown in Fig. 52; and

Fig. 54 is a flow chart showing the operation of the vector quantizing device according to the 24th embodiment.

Detailed Description of the Preferred Embodiments

(First Embodiment)

In the first embodiment, in executing vector quantization for a still image, vector quantization is executed for a block formed from one line having, e.g., $16 \times 1$ pixels, unlike the conventional method in which vector quantization is executed for a square block having, e.g., $4 \times 4$ pixels. Additionally, in executing vector quantization or reconstructing an image compressed by vector quantization, blocks are shifted in the horizontal direction of the image in units of lines.

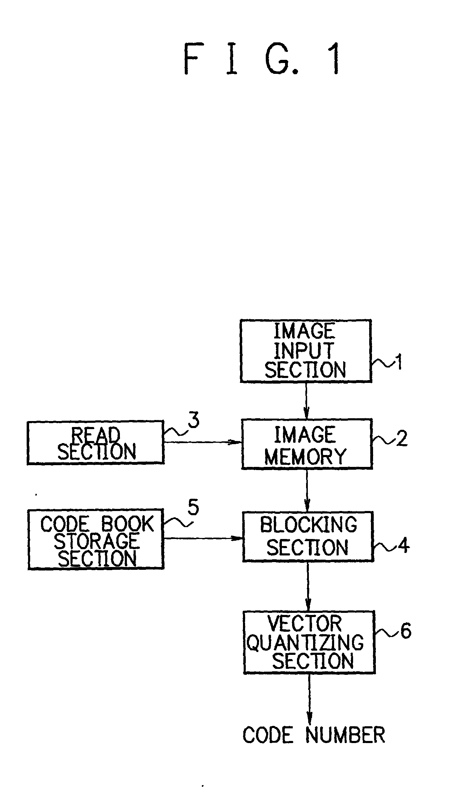

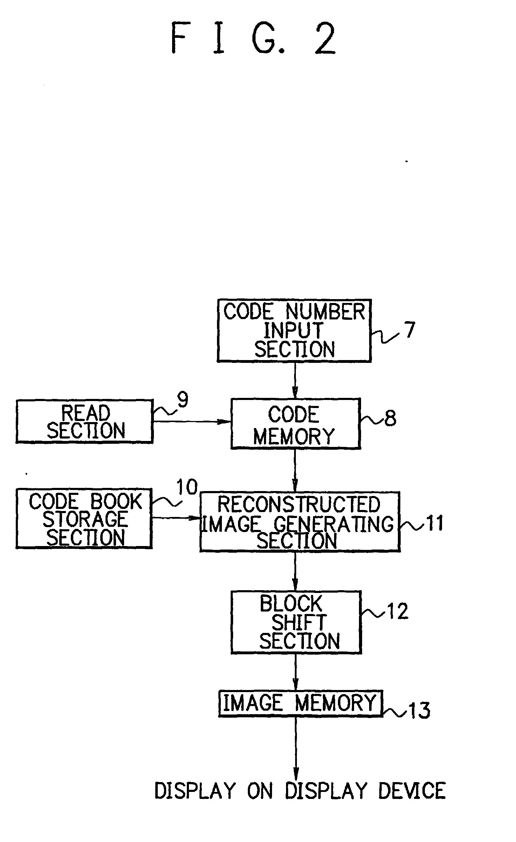

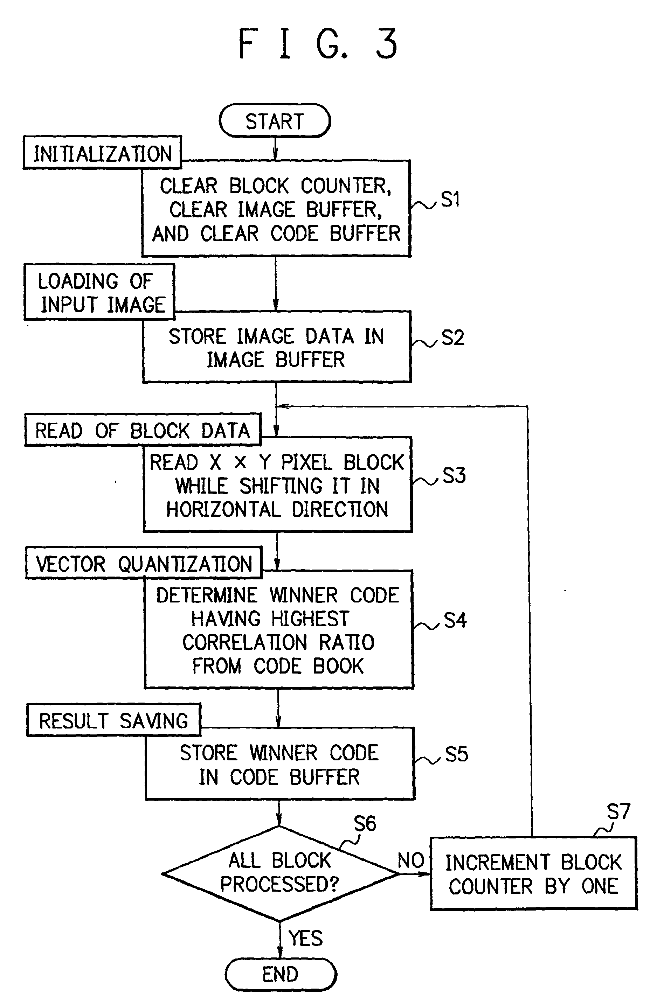

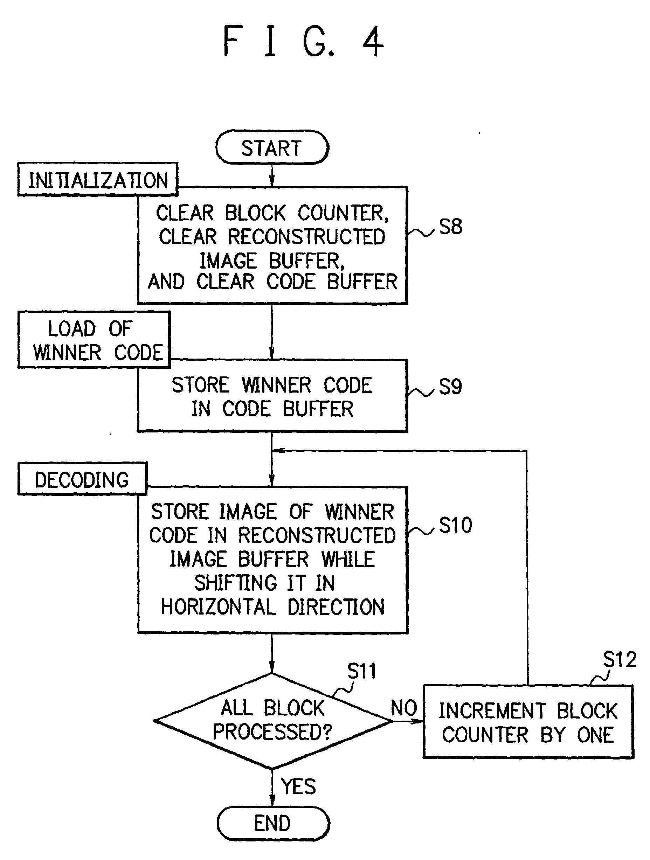

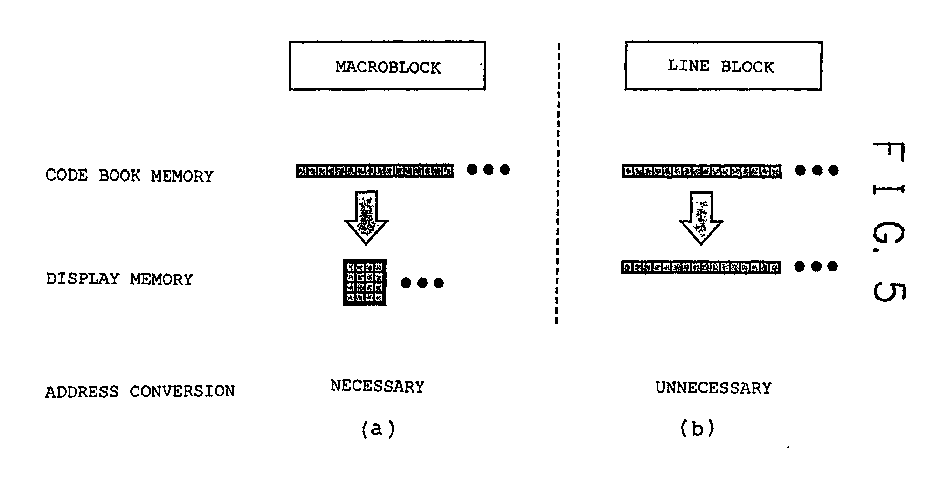

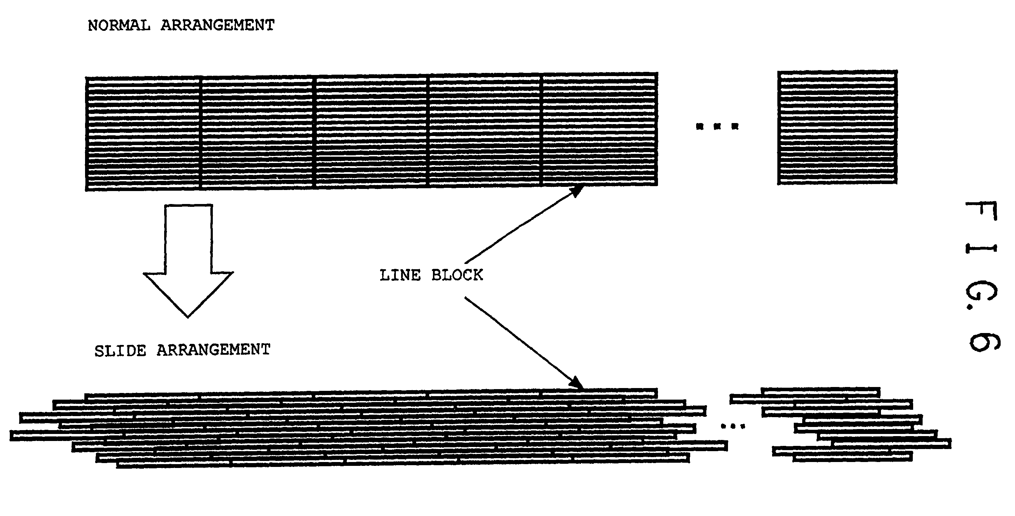

Figs. 1 and 2 are functional block diagrams showing the constructions of a data compressing device and data expanding device according to the first embodiment, respectively. Figs. 3 and 4 are flow charts showing the operations of the data compressing device and data expanding device shown in Figs. 1 and 2, respectively. Figs. 5 and 6 are explanatory illustrations for explaining the operation on the expanding side according to this embodiment.

Figs. 5 and 6 will be described first. Fig. 5 explains a case wherein a line block along a scanning line on an image as a vector is used as vector data (line block scheme of this embodiment) in comparison with a case wherein a conventional square block is used as vector data (macroblock scheme). Fig. 5(a) shows the conventional macroblock scheme, and Fig. 5(b) shows the line block scheme of this embodiment.

As shown in Fig. 5(a), a code book memory stores, in the order of addresses, a number of code vectors each having 16 data strings which form a macroblock of, e.g., $4 \times 4$ pixels. To generate a reconstructed image using the code vector and display the image on a display, the address must be converted on the display memory such that the 16 data strings are displayed at correct positions of the $4 \times 4$ pixels.

On the other hand, in the line block scheme of this embodiment, a block is extracted on one line having $16 \times 1$ pixels and subjected to vector quantization. Since the data construction in this line block matches the scanning direction of the display, the address conversion operation which is necessary for a square macroblock can be eliminated. A code book for this case can also be easily obtained using the Kohonen self-organizing map method.

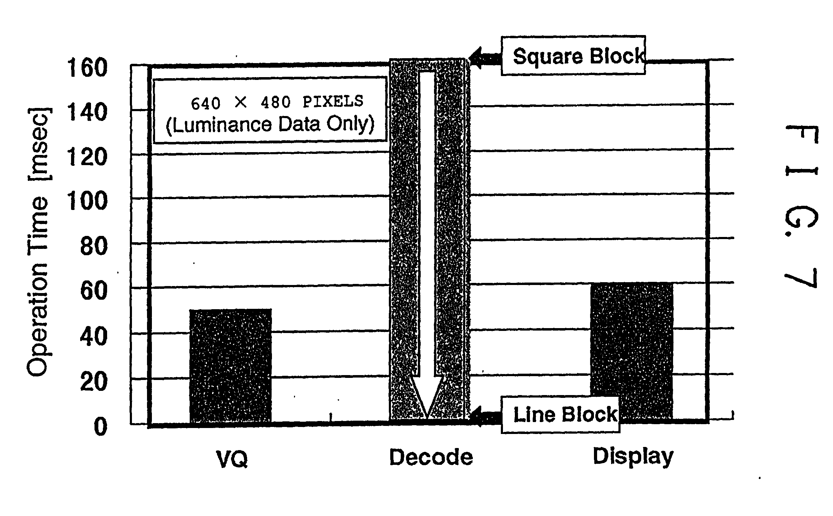

Fig. 7 is an illustration showing a result obtained by measuring a time required for each of compression, expansion, and display processing of one image formed from $640 \times 480$ pixels. Referring to Fig. 7, the conventional macroblock scheme requires about 50 msec for vector quantization (VQ), about 160 msec for decoding, and about 60 msec for display. Decoding requires such a long time because address conversion is necessary in extracting a code vector designated by a code number from the code book memory and converting it into a format displayable on the display.

In such a case, a chip dedicated to address conversion is generally prepared to increase the processing speed. However, this embodiment proposes a method using the line block scheme described above as a means for more easily realizing high-speed processing.

Fig. 7 also shows processing times in the line block scheme. Times required for vector quantization and display scanning are the same as in the macroblock scheme although the decoding time can be largely shortened from 160 msec, as is apparent.

In either of the macroblock scheme and line block scheme (especially in the line block scheme), when the pattern images of code vectors are sequentially pasted in order to display the reconstructed image, large discontinuous points between the two ends of patterns in each line of the reconstructed image inevitably become noticeable. To avoid this, in this embodiment, the positions where the patterns of code vectors are to be pasted are slightly shifted in units of lines, as shown in Fig. 6 (this will be referred to as a slide block scheme hereinafter).

When the blocks of code vectors are shifted in the horizontal direction of the image and pasted at least between lines close to each other, the continuity of block boundaries breaks to make the block boundaries (quantization errors) unnoticeable. This can produce an almost satisfactory image, though the reconstructed image has fuzzy portions at two ends. The disturbance at two end portions can be easily removed by masking the image in display.

In this embodiment, the processing of shifting blocks in the horizontal direction of the image between lines close to each other is performed not only in reconstructing the image after vector quantization, as described with reference to Fig. 6, but also in executing vector quantization. More specifically, instead of sequentially extracting blocks in order from the upper left corner of an image, blocks are extracted while shifting them in the horizontal direction of the image, and then vector quantization is executed.

The construction and operation of the above-described first embodiment will be described mainly on the basis of Figs. 1 to 4. Referring to Fig. 1, an image input section 1 inputs original image data as a compression target. The input image data is temporarily stored in an image memory 2 and the read out and output by address control or the like from a read section 3.

A blocking section 4 segments the image data read out from the image memory 2 into line blocks each formed from, e.g., $16 \times 1$ pixels. At this time, the blocks are extracted while shifting them in the horizontal direction of the image at least between lines close to each other. Note that the direction and amount of shift can be arbitrarily set as long as the block positions are shifted between horizontal lines close to each other. In this case, the blocking section 4 is provided, though it is not always necessary when the read section 3 reads out the image data while shifting the line blocks, as described above.

A code book storage section 5 stores, as code vectors, pixel patterns each having the same size (block of $16 \times 1$ pixels) as the line block extracted from the original image. A vector quantizing section 6 compares the data of a given line block extracted from the original image by the blocking section 4 with each unit of the code vector data stored in the code book storage section 5 to find a pattern most similar to the block data of the original image from the code book, and outputs the code number of the pattern. This operation is performed for all line blocks extracted from the original image.

Referring to Fig. 2, a code number input section 7 inputs a code number string corresponding to blocks specified on the compressing side. The input code number string is temporarily stored in a code memory 8 and read out and output by address control or the like from a read section 9. A code book storage section 10 stores, as code vectors, pixel patterns of blocks each having, e.g., $16 \times 1$ pixels in advance. As this code book, the code book on the compressing side can be transmitted and stored, or an identical code book can be stored in advance.

A reconstructed image generating section 11 performs processing of reading out, on the basis of the code number string read out from the code memory 8, the pattern images of code vectors corresponding to the code numbers from the code book storage section 10 and pasting the pattern images. A block shift section 12 performs processing of shifting the blocks of the reconstructed image output from the reconstructed image generating section 11 in the horizontal direction of the image. At this time, the direction and amount of shift can be arbitrarily set as long as the block positions are shifted at least between horizontal lines close to each other. The reconstructed image that has undergone such shift processing is temporarily stored in an image memory 13, and then sent to a display unit (not shown) and displayed.

Referring to Fig. 3 which shows the operation on the compressing side shown in Fig. 1, initialization processing is performed first in step S1. In this case, processing of clearing a block counter (not shown in Fig. 1) for counting processed blocks, an image buffer (image memory 2 in Fig. 1), and a code buffer (not shown in Fig. 1) for storing the code number determined by vector quantization is performed.

The original image is input and stored in the image buffer in step S2. In step S3, blocks each having a size of $x \times y$ pixels (x and y are arbitrary values: x = 16 and y = 1 in the above example) are read out from the original image stored in the image buffer. In this read, the block positions are adjusted such that they are shifted at least between horizontal lines close to each other.

In step S4, vector quantization processing is executed for the readout block data, a code vector having the highest correlation ratio to the readout block data is searched front the code book stored in the code book storage section 5, and a code number (Winner code) corresponding to the code vector is determined. In step S5, the obtained code number is stored in the code buffer. The code number stored is externally output later. Note that the code buffer is not always necessary.

The flow advances to step S6 to determine whether the above-described processing is ended for all blocks in the image. If NO in step S6, the value of the block counter is incremented by one in step S7, and the flow returns to step S3 to repeat the above processing. Thus, by determining and outputting code numbers for all blocks in the image, the original image is compressed.

Referring to Fig. 4 which shows the operation on the expanding side shown in Fig. 2, initialization processing is performed first in step S8. In this case, processing of clearing a block counter (not shown in Fig. 2) for counting processed blocks, a reconstructed image buffer (image memory 13 in Fig. 2), and a code buffer (code memory 8 in Fig. 2) for storing an input code number is performed.

In step S9, the code number string generated on the compressing side is input and stored in the code buffer. In step S10, decoding processing is performed on the basis of, of the stored code number string, one code number represented by the current block counter. More specifically, a code vector (pattern image) corresponding to the code number is extracted from the code book stored in the code book storage section 10, and stored in the reconstructed image buffer. At this time, the extracted blocks each having $x \times y$ pixels are stored such that the block positions are shifted at least between horizontal lines close to each other.

In this embodiment, the directions of block shift are opposite in step S3 on the compressing side and step S10 on the expanding side. More specifically, when a certain block line is shifted to the right by i pixels in step S3, the block line is shifted to the left by i pixels in step S10. This eliminates the shift of each block line in the reconstructed image. For this reason, quantization error can be made unnoticeable, and additionally, the quality of reconstructed image can be further improved.

Next, the flow advances to step S11 to determine whether the above-described processing is ended for all blocks in the image. If NO in step S11, the value of the block counter is incremented by one in step S12, and the flow returns to step S10 to repeat the above processing. Thus, by extracting a pattern image from the code book and storing the pattern image in the reconstructed image buffer for all blocks in the image, the reconstructed image stored in the reconstructed image buffer is supplied to the display and displayed.

In the above example, the blocks are shifted on both the compressing side and the expanding side. However, the blocks may be shifted only on the compressing side or only on the expanding side. In this case, although the reconstructed image includes the shift of each block line, the quantization errors themselves can be made unnoticeable, so the quality of reconstructed image can be improved as compared to the related art.

Data compression of a still image has been described. This can also be applied to data compression of a moving picture because vector quantization is executed for each frame of a moving picture.

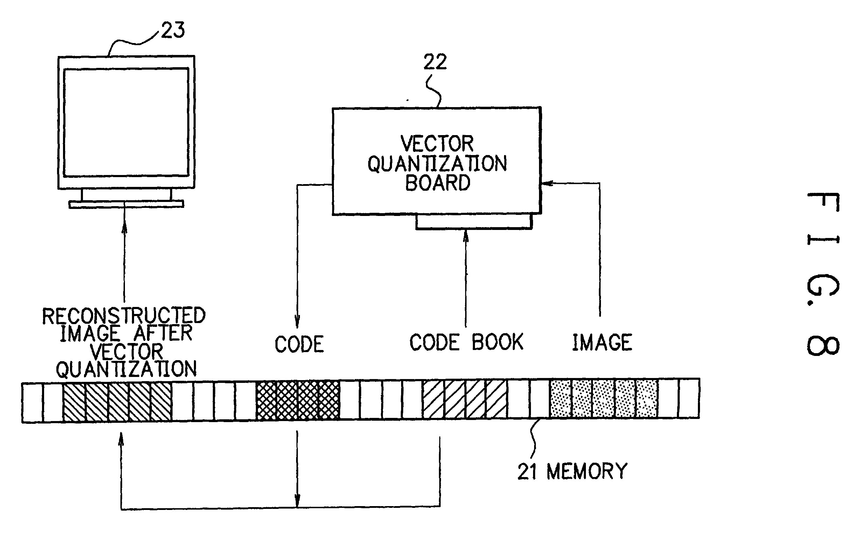

In this embodiment, a system for compressing a moving picture by vector quantization using a vector quantization PCI bus board 22 shown in Fig. 8 and reconstructing the moving picture from the compression result is implemented. This will be described below in detail.

The vector quantization board 22 shown in Fig. 8 has eight chips each capable of having, e.g., 256 8-bit 16-dimensional (4 × 4 pixels) code vectors, so vector quantization can be executed using a total of 2,048 code vectors. These chips are connected to a computer (not shown) through a PCI bus interface formed from, e.g., an FPGA (Field Programmable Gate Array).

In vector quantization, all code vectors of a code book that has been made in advance are transferred from a memory 21 to the chips of the vector quantization board 22. Next, moving picture data stored in the memory 21 in advance are sequentially sent to the vector quantization board 22, and vector quantization is executed. A code number obtained as a result of vector quantization is temporarily stored in the memory 21. On the basis of the code number, a code vector corresponding to the code number is read out from the memory 21, and decoding is executed. Decoded reconstructed image data is sent to a display 23 of the computer and displayed as an image.

In the above description, the number of code vectors of the code book is 2,048, and the number of data of a code vector is 16. These are merely examples and are not limited to the numerical values described above. The image size and the block size for vector quantization used in this system are also merely examples and are not limited to the numerical values described above.

As described above, in the first embodiment, a line block having, e.g., 16 × 1 pixels is used as a block as a processing unit of vector quantization. Since the line block matches the scanning direction of the display, address conversion processing in rearrangement becomes unnecessary, and the image rearrangement speed increases (a rearrangement speed becomes higher by about 3.5 times as compared to a case wherein vector quantization is executed using a macroblock having 4 × 4 pixels).

For example, when a moving picture whose frame has 640 × 480 pixels is compressed by the macroblock scheme, the frame rate is about 4 frames/sec. According to the line block scheme of this embodiment, vector quantization operation at a frame rate of about 14 frames/sec can be realized.

The processing time of the display section can be shortened by improving the display program. In the current system, about 60% the time required for vector quantization processing is a time for address conversion required to transfer an input vector to the vector quantization board and time for the transfer, while the vector quantizing chips operate only for a short time. Hence, when the transfer bus width is increased to improve the processing ability of the CPU, the processing speed can be further shortened. When these improvements are executed, vector quantization operation at a rate of 30 frames per sec can be realized.

In this embodiment, vector quantization is performed by extracting blocks while shifting them in the horizontal direction of an image, or an image is reconstructed while shifting blocks. For this reason, vertical lines (quantization errors) along the block boundaries, which are noticeable at two ends of the image when the blocks are directly sequentially applied, are dispersed and become unnoticeable, resulting in an improved image quality.

In the above embodiment, both the line block scheme and the slide block scheme are used. However, only one of them may be used. When only the line block is employed, at least the image rearrangement speed can be increased. When only the slide block scheme is employed, at least the quantization error can be made unnoticeable.

In the above embodiment, blocks are shifted in the space direction in one image. However, in data compression of a moving picture having frames, the elements in blocks may be shifted between frames in the time-axis direction. In this case as well, the quantization error in the reconstructed image can be made unnoticeable.

(Second Embodiment)

In compressing a moving picture, it is difficult to obtain a high compression ratio only by executing vector quantization for each frame (still image) of the moving picture. In the second embodiment, vector quantization in a frame is executed for each still image of frames, and additionally, data having the same address in the still images of frames are regarded as a vector, and data is compressed by applying vector quantization also between frames.

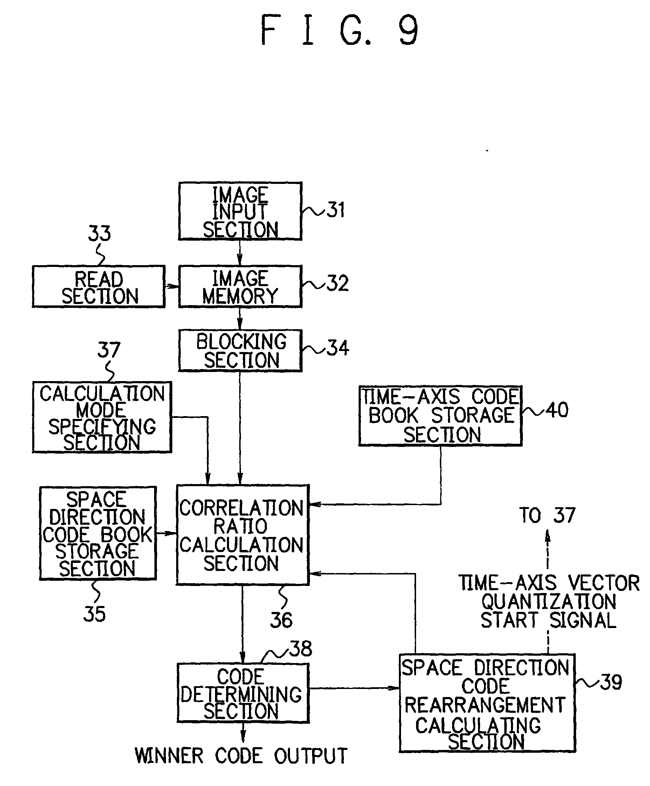

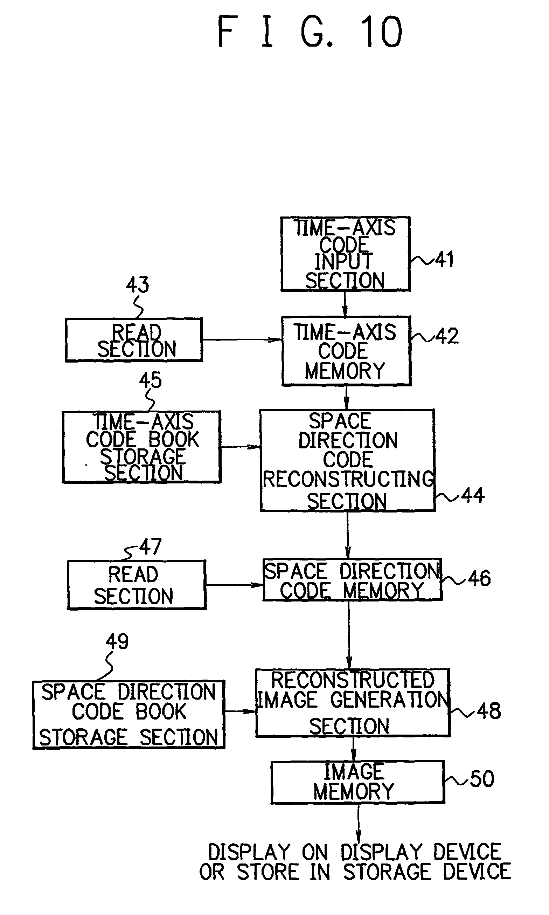

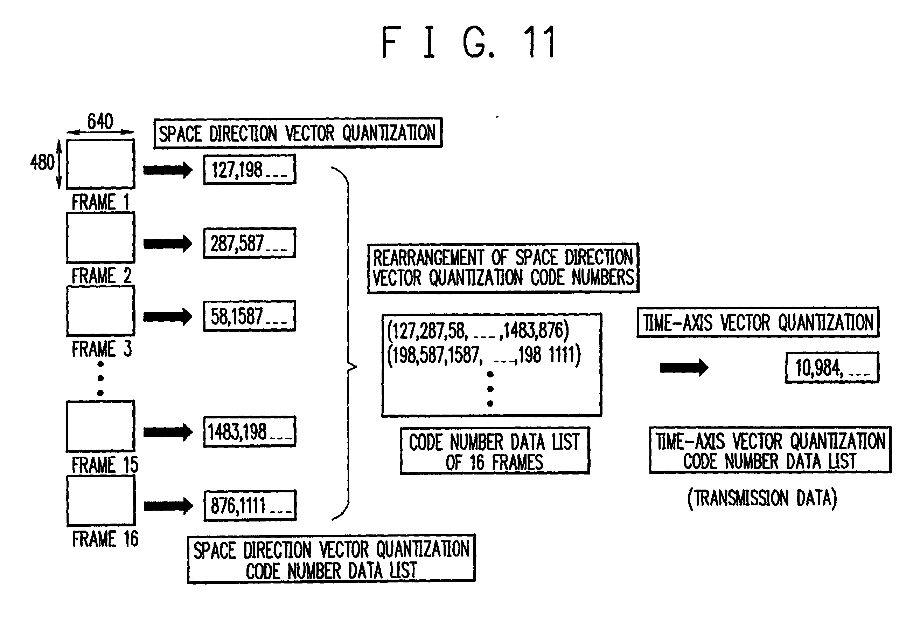

Figs. 9 and 10 are functional block diagrams showing the construction of a data compressing/expanding system according to the second embodiment. Fig. 11 is a data flow chart showing the flow of data in compression according to the second embodiment. Fig. 9 shows the construction on the compressing side, and Fig. 10 shows the construction on the expanding side. The flow of data in expansion is basically opposite to that in compression and can be anticipated from Fig. 11, so the data flow chart for expansion will be omitted.

A case wherein compression/expansion is performed for a moving picture in which one frame has $640 \times 480$ pixels, and the luminance value per pixel is expressed by 8-bit data, as shown in Fig. 11, will be described. For the descriptive convenience, assume that compression/expansion is executed for an image having 16 frames.

Referring to Fig. 9, an image input section 31 sequentially inputs original image data as a compression target, in this case, a moving picture in units of frames. The input image data is temporarily stored in an image memory 32 and the read out and output by address control or the like from a read section 33.

A blocking section 34 segments the image data read out from the image memory 32 into blocks each formed from, e.g., $4 \times 4$ pixels. In this case, the blocking section 34 is provided, though it is not always necessary when the read section 33 reads out the image data in units of blocks.

A space direction code book storage section 35 stores as a database in advance a code book (since this code book is used for vector quantization in one frame space, it will be referred to as a "space direction code book" hereinafter) used to execute, for one still image (frame), vector quantization in the frame.

In this space direction code book, a data string formed from 16 data is defined as one code vector, and code vectors are combined. In this case, the space direction code book is constructed by a combination of 2,048 vectors.

When a mode for space direction vector quantization is specified by a calculation mode specifying section 37, a correlation ratio calculation section 36 calculates the correlation ratio, i.e., the similarity between each of the code vectors in the code book and the input vector from the original image using the space direction code book stored in the space direction code book storage section 35 in units of sequentially input frames.

The similarity is a numerical value which is calculated by inputting two vector data to a certain function and represents the degree of similarity between the two vector data. A representative example of that function is a function for obtaining the Manhattan distance (absolute difference value) or Euclidean distance between the two vector data. For example, the Manhattan distance can be obtained by calculating the absolute difference value between the data of each element of an input vector and the data of each element of a code vector and adding the obtained absolute difference values.

To detect a code vector most similar to the input vector, for example, the above-described Manhattan distance is obtained in units of code vectors of the space direction code book, and a code vector with the minimum distance is detected.

The function for obtaining the similarity is not limited to the function above, and an arbitrary function can be used in accordance with the purpose. For example, a function having a coefficient (weight) for one or both vector data or a function for calculating feature amount data (e.g., the sum of elements of vector data) in a block may be used.

A code determining section 38 outputs a code number corresponding to a code vector having the maximum similarity as a compression code (Winner code) of the block on the basis of the similarity calculation result by the correlation ratio calculation section 36. The correlation ratio calculation section 36 and code determining section 38 construct a vector quantizing means. As the vector quantizing method, the conventional method or the method described in the first embodiment can be used.

The operation of this space direction vector quantization will be described below in detail with reference to Fig. 11. First, for the first frame image, vector quantization is executed using the space direction code book. In this case, a block region obtained by segmenting the first frame image in units of 4 pixels in the horizontal direction and 4 pixels in the vertical direction is defined as an input vector. The similarity between one input vector and each code vector of the space direction code book is obtained, and the code number of a code vector most similar to the input vector is specified.

This operation is performed for all input vectors in the frame whereby each block region obtained by segmenting the first frame image into $4 \times 4$ pixels is replaced with a code number corresponding to a code vector in the space direction code book. Numbers 127, 198,... in Fig. 11 indicate code numbers replacing the blocks which are sequentially extracted from the upper left corner to the lower right corner of the image.

Next, the same processing as that for the first frame image is performed for the second to 16th frame images or a total of 15 images whereby each block region obtained by segmenting each frame image into $4 \times 4$ pixels is

replaced with a code number corresponding to a code vector in the space direction code book.

Referring back to Fig. 9, for each frame image represented by code numbers in the space direction code book by the space direction vector quantizing means, a space direction code reconstruction calculating section 39 rearranges the code numbers of blocks represented by the same address in the order of frame images, thereby expressing the code numbers of blocks with the same address, which are dispersed in the time-axis direction, as one data string.

More specifically, when space direction vector quantization is executed for the 16 frame images, as shown in Fig. 11, the code number of the block at a designated address in the first frame image is placed at the 0th address position in the newly created data string, and the code number of the block in the second frame image, which has the same address as in the first frame image, is placed at the first address position in the newly created data string. In this way, the code numbers of the blocks at the same address in the 16 frames are rearranged. The code number of the block at the same address in the final, i.e., 16th frame image is placed at the 15th address position in the newly created data string.

The newly generated set including the 16 code numbers is defined as a new vector. This will be referred to as a "time-axis vector" hereinafter. In the example shown in Fig. 11, for example, a data string (127, 287, 58,..., 1483, 876) that rearranges the code numbers of blocks designated by the start addresses of the first to 16th frames corresponds to one time-axis vector.

As in this example, when one frame has $640 \times 480$ pixels, and one block region has $4 \times 4$ pixels, $160 \times 120$ = 19,200 blocks are generated from one frame image. Hence, when the above-described reconstruction processing is performed for all ranges of images that have undergone space direction vector quantization, 19,200 time-axis vectors are newly generated.

Referring back to Fig. 9, a time-axis code book storage section 40 stores as a database in advance a code book (since this code book is used for vector quantization for data which is given across frames along with the elapse of time, it will be referred to as a "time-axis code book" hereinafter) used to execute vector quantization for the time-axis vectors generated in the above manner. In this time-axis code book as well, a data string formed from 16 data is defined as one code vector, and 2,048 code vectors are combined.

When reconstruction is performed for all ranges of images by the space direction code reconstruction calculating section 39, a time-axis vector quantization start signal is output and supplied to the calculation mode specifying section 37. Accordingly, the calculation mode specifying section 37 switches the mode to a mode for time-axis vector quantization. When the mode for time-axis vector quantization is specified by the calculation mode specifying section 37, the correlation ratio calculation section 36 performs vector quantization for each time-axis vector generated by the space direction code reconstruction calculating section 39 using the time-axis code book stored in the time-axis code book storage section 40.

This time-axis vector quantization operation will be described below in detail with reference to Fig. 11. The similarity between one of the previously generated 19,200 time-axis vectors and each code vector of the time-axis code book is calculated, and the address (code number) of a code vector having the maximum similarity in the time-axis code book is specified. The similarity calculation is the same as described above.

This operation is performed for all time-axis vectors whereby the time-axis vectors each represented by the code numbers after space direction vector quantization is replaced with a code number corresponding to a code vector in the time-axis code book. In the example shown in Fig. 11, for example, the above-described time-axis vector (127, 287, 58,..., 1483, 876) is replaced with time-axis code number "10". At this stage, the 16 frame images each having $640 \times 480$ pixels are expressed by a data string (10, 984,...) formed from, e.g., 19,200 data expressed by 11 bits. This data is supplied to the expanding side.

Hence, to transfer a moving picture having 16 frames from the compressing side to the expanding side, the space direction code book and time-axis code book are sent to the expanding side in advance (or identical code books may be prepared on the expanding side in advance), and then, the list expressed by the code number string of the time-axis code book, which is obtained by the above series of processes, is sent. With this processing, 16 frame images having an information amount of 39,321,600 bits can be compressed to the code number string of the time-axis code book, which has an information amount of 422,400 bits or about 1/100 information amount while preserving the image quality.

On the expanding side shown in Fig. 10, the original image of 16 frames can be reconstructed on the basis of the data transferred from the compressing side in the above way. First, a time-axis code input section 41 inputs the code number string of the time-axis code book, which is transferred from the compressing side. The input time-axis code number string is temporarily stored in a time-axis code memory 42 and read out and output by address control or the like from a read section 43.

A space direction code reconstructing section 44 extracts a code vector corresponding to each time-axis code number from a time-axis code book which is, for example, transferred from the compressing side and stored in a time-axis code book storage section 45 in advance, using the time-axis code number string read out from the time-axis code memory 42. The extracted code vectors are sequentially arranged to reconstruct space direction code numbers.

The time-axis code number string read out from the time-axis code memory 42 includes 19,200 time-axis code numbers. One code number in the time-axis code book, which corresponds to each of these time-axis code numbers is formed from 16 data. For this reason, the data of code vectors arranged in order by processing of the space direction code reconstructing section 44 is formed from a total of 307,200 data (space direction code numbers).

The space direction code number string reconstructed in the above way is temporarily stored in a space direction code memory 46 and read out and output by address control or the like from a read section 47. A reconstructed image generating section 48 extracts every 16th data from the 307,200 data arranged and generates a data string from 19,200 data, which is then defined as a vector. This will be referred to as a "space direction vector" relative to the above time-axis vector hereinafter.

This operation is performed for all spaces of the 307,200 data whereby the space direction code number string read out from the space direction code memory 46 is segmented into 16 space direction vectors. The 16 space direction vectors are sets of space direction code numbers used to reconstruct the first to 16th frame images.

The reconstructed image generating section 48 also looks up the space direction code book which is, for example, transferred from the compressing side and stored in a space direction code book storage section 49 in advance to detect a code vector corresponding to each of the (19,200) space direction code numbers of each of the 16 space direction vectors. The data of corresponding code vectors (pattern images) are sequentially applied to the block positions, thereby reconstructing the original image.

When such processing is executed every time 16 space direction vectors are obtained, the original 16 frame images can be reconstructed. Note that when the operation of extracting every 16th data from the 307,200 space direction code numbers is performed by the read section 47, the reconstructed image generating section 48 can sequentially generate the reconstructed image of each frame every time 19,200 data are read out.

The reconstructed image is temporarily stored in an image memory 50 and then sent to and displayed on a display unit (not shown) or sent to and stored in a storage unit (not shown).

In this second embodiment, one vector is formed from 16 data, and each of the space direction code book and time-axis code book is formed front 2,048 code vectors. These are merely examples for the descriptive convenience of this embodiment and are not limited to the above numerical values.

In the above description, art image having 16 frames is compressed by vector quantization. However, the number of frames to be compressed is not limited to 16, and a necessary number of frames can be compressed by vector quantization. In this embodiment, a moving picture is used. However, this embodiment can be applied not only to an moving picture but also to a voice signal.

In the second embodiment, one correlation ratio calculation section 36 is commonly used for space direction vector quantization and time-axis vector quantization. However, two correlation ratio calculation sections may be prepared for vector quantization of these types, respectively.

(Third Embodiment)

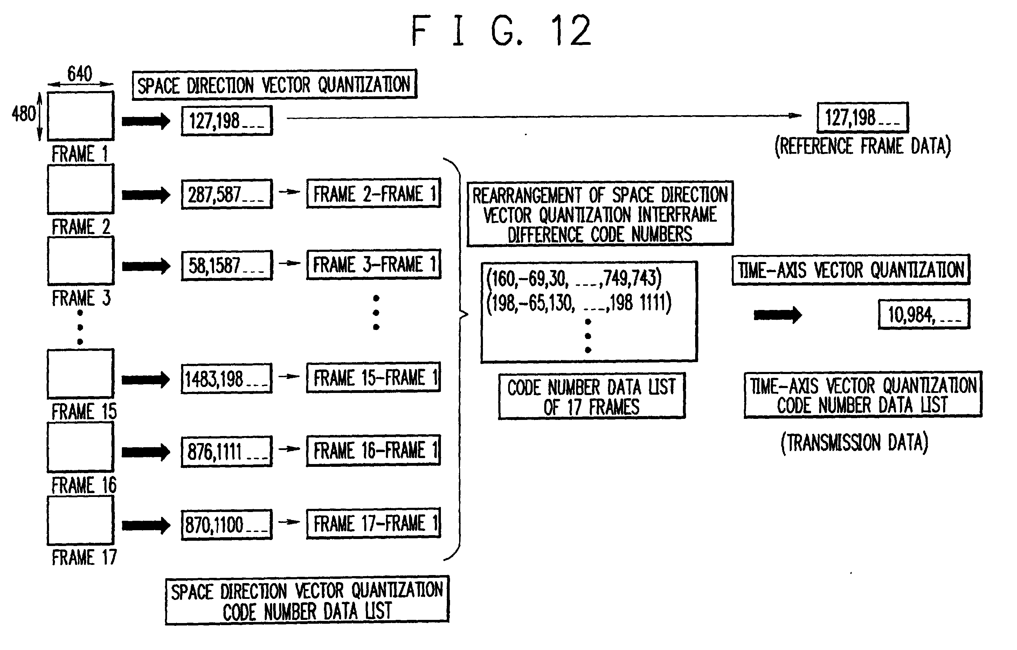

Fig. 12 is a data flow chart showing the flow of data in compression according to the third embodiment. The construction of a data compressing/expanding system of the third embodiment is almost the same as in the second embodiment, and an illustration thereof will be omitted. However, a space direction code reconstruction calculating section 39 and reconstructed image generating section 48 have slightly different processing contents in the third embodiment, and this will be described in detail.

In this embodiment, an image having 17 frames is compressed, as shown in Fig. 12. For this reason, when the mode for space direction vector quantization is specified by a calculation mode specifying section 37, a correlation ratio calculation section 36 executes space direction vector quantization processing for the first to 17th frame images or a total of 17 images whereby each block region obtained by segmenting each frame image into $4 \times 4$ pixels is replaced with a code number corresponding to a code vector in the space direction code book.

For the code numbers of blocks represented by the same address in the frame images, which are expressed by code numbers in the space direction code book by the correlation ratio calculation section 36, the space direction code reconstruction calculating section 39 calculates the difference between the code number in the first frame (used as a reference frame) and that in each of the remaining frames and rearranges the results in the order of frame images. The differences from the reference frame may be calculated in units of individual addresses after reconstruction.

More specifically, first, between the first frame and the second frame, the differences in code number with the same address are calculated first, and then, between the first frame and the third frame, the difference in code number with the same address are calculated as shown in Fig. 12. In a similar manner, between the first frame and each of the fourth to 17th frames, the differences in code number with the same address are calculated. The difference results for blocks represented by the same address are rearranged in the order of frame images, thereby expressing the difference code numbers of blocks with the same address, which are dispersed in the time-axis direction, as one data string.

More specifically, when space direction vector quantization is executed for the 17 frame images, as shown in Fig. 12, the difference between the code number in the first frame image and that in the second frame image is placed at the 0th address position in the newly created data string, and the difference between the code number in the first frame image and that in the third frame image is placed at the first address position in the newly created data string.

In this way, the differences between the code number in the first frame and code numbers in the 16 remaining frame images are rearranged. The final difference between the code number in the first frame image and that in the 17th frame image is placed at the 15th address position in the newly created data string. When the calculation mode specifying section 37 specifies time-axis vector quantization, the correlation ratio calculation section 36 performs time-axis vector quantization for the rearranged time-axis vectors and outputs a time-axis code number string of the time-axis code book.

At this stage, the 17 frame images each having $640 \times 480$ pixels are expressed by a data string formed from, e.g., 19,200 data expressed by 11 bits. Hence, to transfer a moving picture having 17 frames, the space direction code book and time-axis code book are sent to the expanding side in advance, and then, the list expressed by the code number string of the time-axis code book, which is obtained by the above series of processes, and a data string in which the first frame image is expressed by the code numbers of the space direction code book are sent.

With this processing, 17 frame images having an information amount of 41,779,200 bits can be compressed to the code number string of the time-axis code book, which has an information amount of 422,400 bits or about 1/100 information amount while preserving the image quality.

On the expanding side, the original image of 17 frames can be reconstructed on the basis of the data transferred from the compressing side in the above way. Processing until the reconstructed image generating section 48 segments the 307,200 data into 16 space direction vectors is the same as in the second embodiment. In this embodiment, the code numbers in the first frame after space direction vector quantization, which are sent from the compressing side, and the code number differences of each space direction vector reconstructed by the reconstructed image generating section 48 are added to reconstruct the data string of code numbers.

The reconstructed image generating section 48 searches the space direction code book stored in a space direction code book storage section 49 for a code vector corresponding to each code number of each of the 16 segmented and reconstructed space direction vectors and applies the code vectors, thereby reconstructing the original image. With this processing, the original 17 frame images can be reconstructed.

In this third embodiment, one vector is formed from 16 data, and each of the space direction code book and time-axis code book is formed from 2,048 vectors. These are merely examples for the descriptive convenience of this embodiment and are not limited to the above numerical values.

In the above description, an image having 17 frames is compressed by vector quantization. However, the number of frames to be compressed is not limited to 17, and a necessary number of frames can be compressed by vector quantization. In this embodiment, a moving picture is used. However, this embodiment can be applied not only to a moving picture but also to a voice signal.

(Fourth Embodiment)

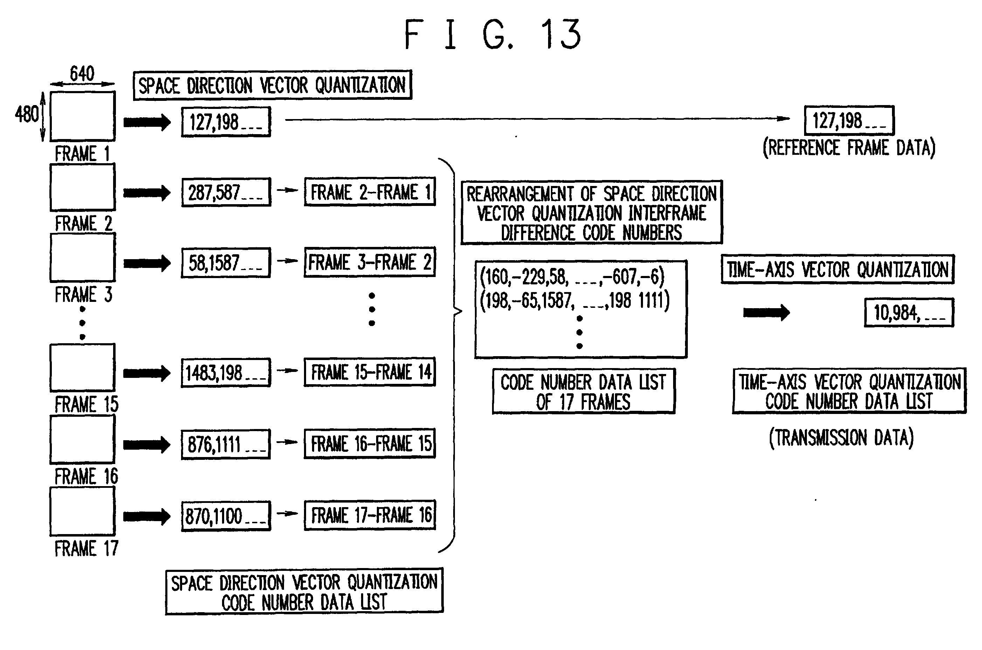

Fig. 13 is a data flow chart showing the flow of data in compression according to the fourth embodiment. The construction of a data compressing/expanding system of the fourth embodiment is also almost the same as in the second embodiment, and an illustration thereof will be omitted. However, a space direction code reconstruction calculating section 39 and reconstructed image generating section 48 have slightly different processing contents in the fourth embodiment, and this will be described in detail.

As shown in Fig. 13, in this embodiment as well, an image having 17 frames is compressed, as in the third embodiment. However, the contents of difference calculation executed by the space direction code reconstruction calculating section 39 are different from the above example. More specifically, in the third embodiment, the difference in code number between the first frame image and each frame is calculated. In the fourth embodiment, however, the difference in code number between frames adjacent to each other is calculated.

More specifically, as shown in Fig. 13, first, the difference in code number at the same address is calculated between the first frame and the second frame. Next, the difference in code number at the same address is calculated between the second frame and the third frame. The same processing is performed until the difference between the 16th frame and the 17th frame is calculated. The difference results for blocks represented by the same address are rearranged in the order of frame images, thereby expressing the difference code numbers of blocks with the same address, which are dispersed in the time-axis direction, as one data string.

The construction and operation on the expanding side according to the fourth embodiment are also almost the same as in the third embodiment except the contents of addition performed by the reconstructed image generating section 48. More specifically, in the fourth embodiment, code numbers in space direction vectors of frames adjacent to each other are added, and the data string of code numbers is reconstructed on the basis of the addition results.

More specifically, first, the code numbers in the first frame after space direction vector, which are sent from the compressing side, and the code number differences of the first space direction vector reconstructed by the reconstructed image generating section 48 are added to generate the space direction vector of the second frame image.

Next, the code numbers in the generated space direction vector of the second frame image and the code number differences of the second space direction vector generated by the reconstructed image generating section 48 are added to generate the space direction vector of the third frame image. The same operation as described above is sequentially performed for the remaining space direction vectors, thereby reconstructing the code number strings of space direction vectors of the 16 frame except the first frame.

In this fourth embodiment as well, one vector is formed from 16 data, and each of the space direction code book and time-axis code book is formed from 2,048 vectors. These are merely examples for the descriptive convenience of this embodiment and are not limited to the above numerical values.

In the above description, an image having 17 frames is compressed by vector quantization. However, the number of frames to be compressed is not limited to 17, and a necessary number of frames can be compressed by vector quantization. In this embodiment, a moving picture is used. However, this embodiment can be applied riot only to a moving picture but also to a voice signal.

In this case, to calculate the code number differences between frames, the code number differences between frames adjacent to each other are calculated. However, the code number differences between frames adjacent to each other need not always be calculated.

As described above, according to the second to fourth embodiments, by introducing not only space direction vector quantization but also time-axis vector quantization processing, not only data compression in each frame of a moving picture but also data compression across frames can be performed, and a higher compression ratio can be obtained.

More specifically, when only space direction vector quantization is performed for one frame image, the compression ratio is about 1/11.6. However, when time-axis vector quantization is introduced to compress the data of a moving picture having, e.g., 16 frames, the compression ratio increases to 16 times (a multiple of the number of frames to be compressed), i.e., 1/185.6.


(Fifth Embodiment)


In this embodiment, a detailed example of a method of obtaining a higher-quality reconstructed image in reconstructing a compressed image will be described. As a method of compressing image data in the time-axis direction, any one of the methods described in the second to fourth embodiments can be used. A case wherein the method of the second embodiment is used will be described.

In the above-described second embodiment, for the 16 space direction vectors generated by rearranging the 307,200 code numbers reconstructed by the space direction code reconstructing section 44, a code vector corresponding to each code number in the space direction vectors is obtained by looking up the space direction code book in the space direction code book storage section 49, and the data of corresponding pattern images are applied to the block positions, thereby reconstructing the original image.

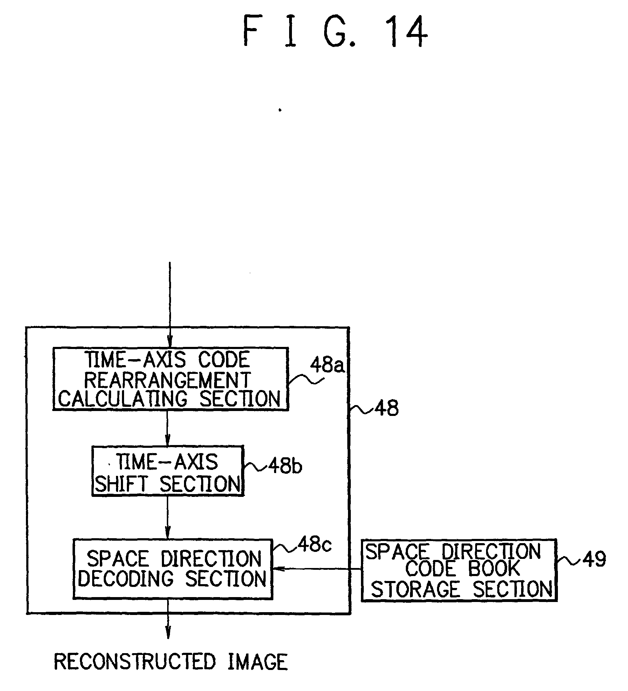

According to this method, however, although a high-quality reconstructed image can be obtained for the first frame, quantization errors by vector quantization in the time-axis direction become noticeable for the subsequent frames, resulting in degradation in image quality. In the fifth embodiment, to prevent such degradation in image quality and maintain a compression ratio of same level, a reconstructed image generating section 48 on the expanding side has an construction as shown in Fig. 14.

Referring to Fig. 14, a time-axis code reconstruction calculating section 48a rearranges 307,200 space direction code numbers reconstructed by a space direction code reconstructing section 44 so as to generate 16 space direction vectors each having 19,200 data. In this embodiment, a time-axis shift section 48b is arranged on the output side of the time-axis code reconstruction calculating section 48a.

When a space direction decoding section 48c searches for a code vector corresponding to each code number in the 16 space direction vectors by looking up the code book in a space direction code book storage section 49 and applies pattern images to the frame images, the time-axis shift section 48b performs shift processing of shifting the elements of each space direction vector in the time-axis direction for each address of blocks defined in vector quantization on the compressing side and applying the pattern images.

More specifically, the time-axis shift section 48b shifts elements close to each other in the time-axis direction in units of elements (addresses) in the space direction vectors. For example, for a designated address, 16 space direction code number strings are sequentially arranged from the first frame, and for each of the remaining addresses, 16 space direction code number strings are sequentially arranged from a frame other than the first frame.

This can disperse quantization errors generated by time-axis vector quantization in the time-axis direction. Hence, the quantization errors that become more noticeable for subsequent frames can be made unnoticeable, and the quality of the reconstructed image can be improved as a whole.

(Sixth Embodiment)

In the above-described fifth embodiment, pattern images are shifted in the time-axis direction and applied on the expanding side, thereby making the quantization errors unnoticeable. To the contrary, even when shift processing in the time-axis direction is done on the compressing side, the quantization errors can be made unnoticeable. In the sixth embodiment, such a method will be described.

In this embodiment as well, any one of the methods described in the second to fourth embodiments can be used as a method of compressing image data in the time-axis direction. A case wherein the method of the second embodiment is used will be described.

In this embodiment, a space direction code reconstruction calculating section 39 shown in Fig. 9 performs processing of shifting code number strings after space direction vector quantization in the time-axis direction.

More specifically, for space direction code numbers generated for each frame by space direction vector quantization by a correlation ratio calculation section 36, the space direction code reconstruction calculating section 39 rearranges the code numbers of blocks represented by the same address such that the elements of time-axis vectors are arranged with reference to different frames in units of addresses.

More specifically, in the second embodiment, in generating a time-axis vector by rearranging the code numbers of blocks represented by the same address in the code number strings after space direction vector quantization, the code numbers are arranged with reference to the first frame for all addresses. In the sixth embodiment, however, which frame is used as a reference for reconstruction is changed in units of addresses.

For example, for a certain time-axis vector, the code number of the first frame is placed at the 0th address position of the data string of the newly created time-axis vector. For each of the remaining time-axis vectors, the code number of a frame other than the first frame is placed at the 0th address position of the newly created data string.

This can disperse quantization errors generated by time-axis vector quantization in the time-axis direction, as in the fifth embodiment. Hence, the quantization errors that become more noticeable for subsequent frames in reconstructing the compressed image can be made unnoticeable, and the quality of the reconstructed image can be improved as a whole.

In the above embodiment, space direction vector quantization and time-axis vector quantization are combined. However, at least only time-axis vector quantization may be performed. In this case, when processing of shifting positions between frames (in the time-axis direction), as described above, in units of pixels or blocks in each frame image, the quantization errors generated by vector quantization in the time-axis direction can be made unnoticeable.

(Seventh Embodiment)

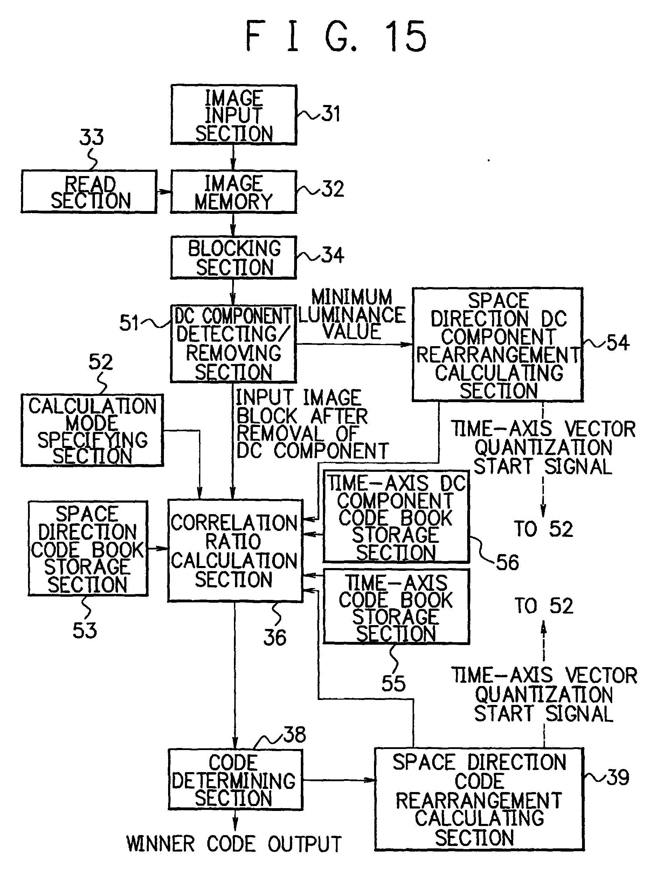

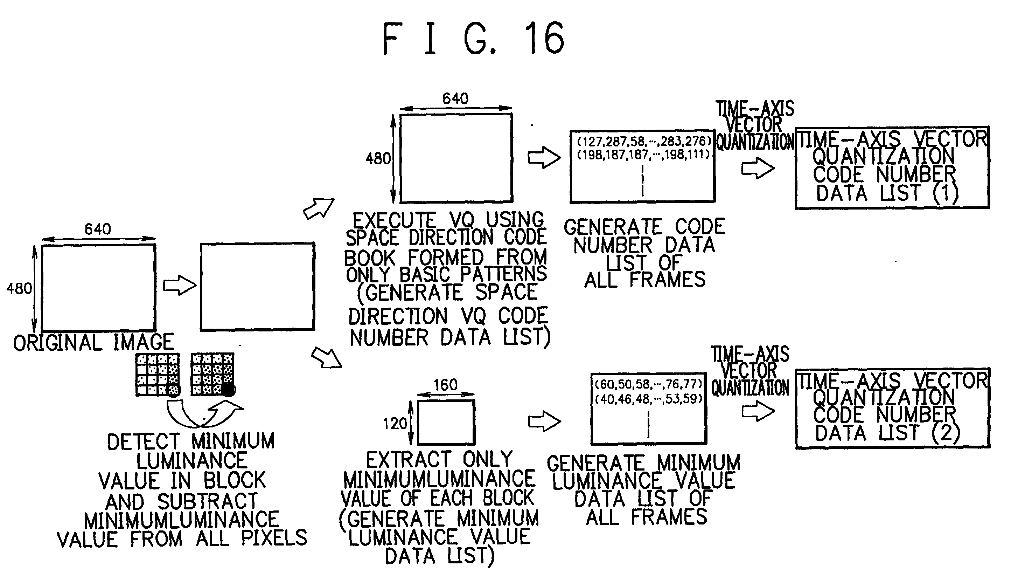

Fig. 15 is a functional block diagram showing the construction of a data compressing system according to the seventh embodiment. Fig. 16 is a data flow chart showing the flow of data in compression according to the seventh embodiment. The same reference numerals as in Fig. 9 denote parts having the same functions in Fig. 15, and a detailed description thereof will be omitted. Although Fig. 16 illustrates an original image of only one frame for the descriptive convenience, actually, frames are sequentially input from an image input section 31.

A DC component detecting/removing section 51 detects a DC component (minimum luminance value of pixels) from each block in executing vector quantization for the original image. In addition, the DC component detected from each block is subtracted from each of all pixel values in the block whereby an image which represents the pixel values of the input original image using only increment amounts from the minimum luminance value in units of blocks is generated.

When a mode for performing space direction vector quantization is specified by a calculation mode specifying section 52, a correlation ratio calculation section 36 executes space direction vector quantization processing for the input image blocks after DC component removal using a space direction code book formed from only basic patterns and stored in a space direction code book storage section 53 in advance. The basic patterns are patterns in which, e.g., the luminance value of each pixel monotonically changes in eight directions in the block of a code vector.

More specifically, the code book of basic patterns means a set of code vectors of patterns in which a luminance value gradually changes in the vertical or horizontal direction or in an oblique direction in the block, starting from one of the edge portions (the upper, lower, left, and right sides and four corners) of the block having, e.g., $4 \times 4$ pixels. When the luminance value of the start point of these code vectors is set to 0, the pattern matches the image block after DC component removal, which is generated by the DC component detecting/removing section 51. The space direction code book of basic patterns is constructed by giving variations to the increment amount of the luminance value from the start point to the end point, e.g., preparing code vectors of 321 patterns.

The DC component detecting/removing section 51 extracts the minimum luminance value detected from each block, thereby generating images having $160 \times 120$ pixels formed from only the minimum luminance values of the blocks, as shown in Fig. 16. Thus, minimum luminance value extraction processing by the DC component detecting/removing section 51 and space direction vector quantization processing by the correlation ratio calculation section 36 are performed to generate the data string of space direction code numbers and the data string of minimum luminance values of the blocks for each of the frame images input as an original image.

For each frame image expressed by the code number string of the space direction code book by the correlation ratio calculation section 36, a space direction code reconstruction calculating section 39 rearranges the code numbers of blocks represented by the same addresses in the order of frame images, thereby generating a time-axis vector which represents the code numbers of blocks at the same address, which are dispersed in the time-axis direction, as one data string. This processing can be done by any one of the methods described in the second to fourth embodiments.

For frame images expressed by only the minimum luminance values of the blocks by the DC component detecting/removing section 51, a space direction DC component reconstruction calculating section 54 rearranges the data values of blocks represented by the same address in the order of frame images, thereby generating a time-axis vector in which the minimum luminance values of blocks at the same address, which are dispersed in the time-axis direction, as one data string. This processing can also be done by any one of the methods described in the second to fourth embodiments.

In the example shown in Fig. 16, for a time-axis vector of basic pattern, for example, a data string (127, 287, 58,..., 283, 276) obtained by rearranging the code numbers of blocks designated by the start addresses in the first to 16th frames corresponds to one time-axis vector of basic pattern. For a time-axis vector of minimum luminance value, for example, a data string (60, 50, 58,..., 76, 77) obtained by rearranging the minimum luminance values of blocks designated by the start address in the first to 16th frames corresponds to one time-axis vector of minimum luminance value.

When reconstruction is done by the space direction code reconstruction calculating section 39 and space direction DC component reconstruction calculating section 54, a time-axis vector quantization start signal is output and supplied to the calculation mode specifying section 52. In accordance with the signal, the calculation mode specifying section 52 switches the mode to a mode for performing time-axis vector quantization for the basic patterns or minimum luminance values.

When time-axis vector quantization of basic patterns is specified by the calculation mode specifying section 52, the correlation ratio calculation section 36 executes vector quantization for each time-axis vector generated by the space direction code reconstruction calculating section 39 using the time-axis code book stored in a time-axis code book storage section 55. When time-axis vector quantization of minimum luminance values is specified by the calculation mode specifying section 52, the correlation ratio calculation section 36 executes vector quantization for each time-axis vector generated by the space direction DC component reconstruction calculating section 54 using the time-axis code book stored in a time-axis DC component code book storage section 56.

With the above processing, time-axis vectors related to the basic patterns and expressed by the code number strings after space direction vector quantization are replaced with code number strings corresponding to code vectors in the time-axis code book of basic patterns, and time-axis vectors related to the minimum luminance values and expressed by the data strings of minimum luminance values in each block are replaced with code number strings corresponding to code vectors in the time-axis code book of minimum luminance values. These data lists are transferred to the expanding side.

Although the construction and data flow on the expanding side are not illustrated in this embodiment, they are basically opposite in order to those on the compressing side, and for example, processing is performed in the following way. For the basic patterns and minimum luminance values, the same expansion processing as described in the second to fourth embodiments is performed. When expansion processing for each element is ended, the results are synthesized in units of blocks, thereby reconstructing the original image.

As described above in detail, according to the seventh embodiment, one feature amount data (minimum luminance value of each block in the above-described example) is extracted from the original image, and vector quantization of the extracted feature amount data and vector quantization of a basic pattern after removal of the feature amount data are separately executed. For this reason, the code book used for vector quantization of each image can be simplified as compared to the code book for the original image itself in which various features are combined, and the necessary number of patterns can also be reduced (although 2,048 patterns are used in the second to sixth embodiments, only 321 patterns suffice in the seventh embodiment)

In detecting a pattern having large similarity from a code book by vector quantization, since simple patterns are compared, an appropriate pattern can more easily be obtained, and accurate vector quantization can be performed. Hence, when data compressed in the above way is reconstructed, a reconstructed image with higher quality can be obtained.

In the seventh embodiment, the minimum luminance value has beep exemplified as a feature amount to be extracted. However, the present invention is not limited to this. For example, the maximum luminance value or average value of pixels in a block may be extracted.

In the seventh embodiment as well, one correlation ratio calculation section 36 is commonly used for space direction vector quantization and time-axis vector quantization. However, two correlation ratio calculation sections may be prepared for vector quantization of these types, respectively.

This embodiment can be applied to both a monochromatic image and color image. For example, in a color image formed from a Y signal (luminance signal) and U and V signals (chrominance signals), the minimum luminance value, maximum luminance value, or average value can be extracted for the Y signal as a feature amount, as described above. For not only the Y signal but also the chrominance signals, the minimum luminance value, maximum luminance value, or average value can be extracted as a feature amount, and vector quantization can be performed.

In the above example, only feature amounts of one type are extracted from the original image. However, feature amounts of different types (e.g., the minimum luminance value and the direction of change in luminance in a block) may be extracted for vector quantization. In this case, the compression ratio becomes low as the number of code number lists output increases, though the quality of the reconstructed image can be further improved. To give priority to the image quality, feature amounts of many types are extracted, and vector quantization is individually executed. In addition, image quality priority and compression ratio priority, or the degree of priority may be switched.

(Eighth Embodiment)

As described above, it is difficult to obtain a high compression ratio only by simply executing space direction vector quantization for each frame image (still image) of a moving picture in compressing the moving picture. In the second to seventh embodiments, the compression ratio is further increased by simultaneously executing time-axis vector quantization. In the eighth embodiment to be described below, a means for increasing the compression ratio using a method different from the above methods will be described.

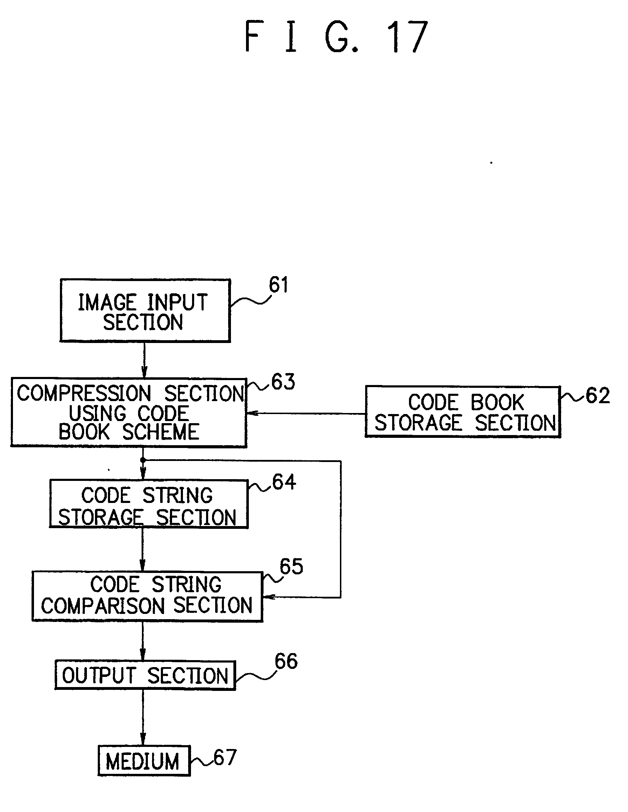

Fig. 17 is a block diagram showing the construction of a data compressing system according to this embodiment. Referring to Fig. 17, an image input section 61 is a device for continuously receiving images. For example, the image input section 61 receives 30 images per sec each of which is formed from $640 \times 440$ pixels each having 8-bit grayscale. This image input section 61 can be implemented by, e.g., not only an image receiving camera or video camera but also a semiconductor memory device or a storage medium such as a hard disk or floppy disk, which can store an image.

A number of pattern images (code vectors) each formed from a block of, e.g., $4 \times 4$ pixels are registered in a code book storage section 62. A unique code number is assigned to each block.

A compression section 63 using the code book scheme performs space direction vector quantization to be described next for each image obtained by the image input section 61. More specifically, $4 \times 4$ pixel blocks are sequentially extracted toward the right starting from the upper left corner of the original image. Reaching the right end, the extraction position is shifted to the lower side by one block, and blocks are extracted again from the left end. The blocks of the entire image are extracted by repeating this operation.

For each extracted block, the most similar pattern is selected from the number of code vectors registered in the code book storage section 62, and a corresponding code number is output. In processing an image having $640 \times 480$ pixels, since 19,200 blocks are extracted and processed, 19,200 code numbers are output.

A code string storage section 64 stores the code number string output by processing a frame image at time t by the compression section 63 using the code book scheme. A code string comparison section 65 compares the code number string of the image at time t, which is stored in the code string storage section 64 with the code number string of the next image at time (t + 1) and calculates the absolute difference value between the code numbers of blocks represented by the same address.

An output section 66 determines data to be output to a medium 67 (a communication channel such as a network or a recording medium) on the basis of the absolute difference value supplied from the code string comparison section 65. More specifically, when the absolute difference value for a given address is larger than a certain threshold value, the address and code number are output to the medium 67. On the other hand, when the absolute difference value for a given address is smaller than a certain threshold value, the address and code number are not output to the medium 67.

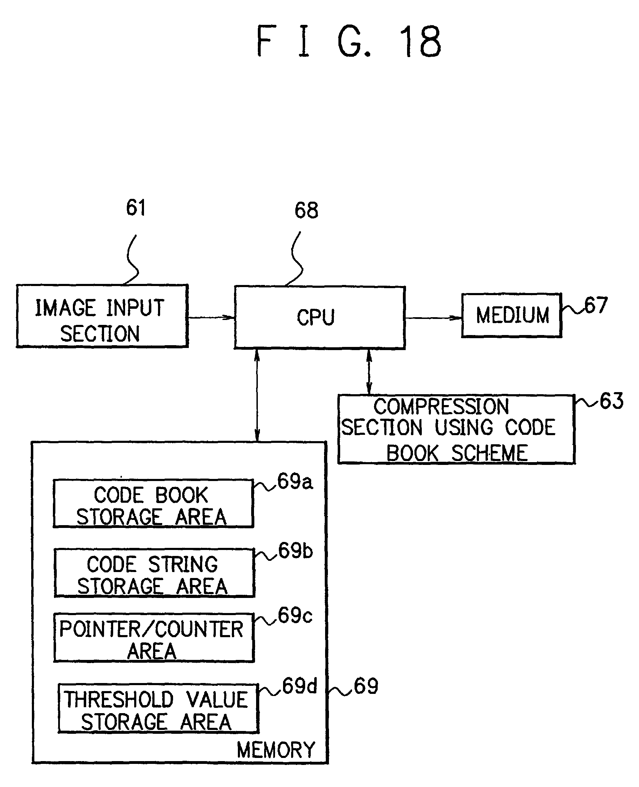

Fig. 18 is a block diagram showing a construction which implements the data compressing device shown in Fig. 17 by software. Fig. 18 shows the construction of a code book moving picture compressing processor including a CPU 68. Note that the image input section 61, the compression section 63 using the code book scheme, and the medium 67 shown in Fig. 18 are the same as in Fig. 17.

Referring to Fig. 18, a memory 69 added to the CPU 68 has a code book storage area 69a, code string storage area 69b, pointer/counter area 69c, and threshold value storage area 69d.

The code book storage area 69a stores the code book used by the compression section 63 using the code book scheme. The code string storage area 69b sequentially stores a code number string output for each frame from the compression section 63 using the code book scheme, and stores a code number string obtained by compressing the image at time t by the compression section 63 using the code book scheme.

The pointer/counter area 69c stores a pointer (address) which indicates a code number read/write position in the code string storage area 69b. The threshold value storage area 69d stores a threshold value used by the output section 66 as a criterion for determining data to be transferred to the medium 67.

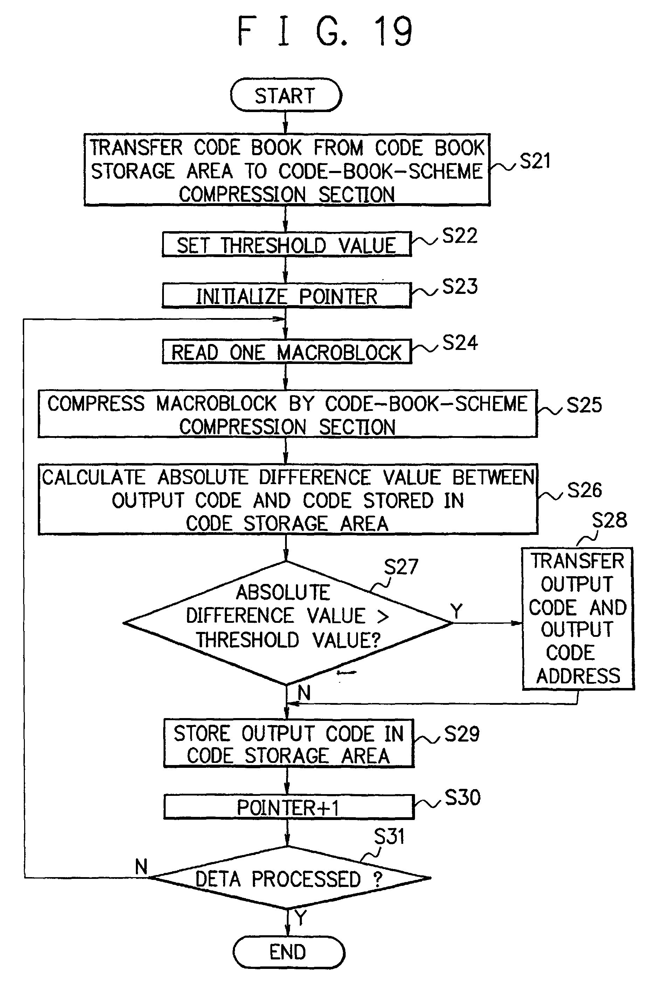

Fig. 19 is a flow chart showing the procedure of compression processing executed by the CPU 68 shown in Fig. 18. Referring to Fig. 19, first in step S21, code book data is transferred from the code book storage area 69a to the compression section 63 using the code book scheme. In step S22, a predetermined threshold value is set in the threshold value storage area 69d. In step S23, the pointer (address) of the pointer/counter area 69c is initialized to set the pointer value to, e.g., "0".

In step S24, a macroblock (e.g., a $4 \times 4$ pixel block) in the original image is received from the image input section 61. In step S25, the received macroblock is sent to the compression section 63 using the code book scheme, which is caused to execute space direction vector quantization processing. Thus, a space direction code number string is obtained as a compression code.

In step S26, the absolute difference value between the code number output from the compression section 63 using the code book scheme and the code number indicated by the current pointer value, which is obtained by previous processing and stored in the code string storage area 69b, is calculated. In step S27, it is determined whether the calculated absolute difference value is larger than the threshold value stored in the threshold value storage area 69d.

If YES in step S27, the code number output from the compression section 63 using the code book scheme and the pointer value at that time are output to the medium 67 in step S28, and the code number is stored in the code string storage area 69b in step S29.

On the other hand, if the calculated absolute difference value is smaller than the threshold value stored in the threshold value storage area 69d, the flow advances to step S29 without executing processing in step S28, and the code number output from the compression section 63 using the code book scheme is stored in the code string storage area 69b. In step S30, the pointer in the pointer/counter area 69c is incremented. In step S31, it is determined whether processing is ended for all macroblocks in one image.

If NO in step S31, the flow returns to step S24 to receive the next macroblock and execute the same processing as described above. The above-described processing is continued until all macroblocks in the image obtained from the image input section 61 are processed. When all macroblocks in the image are processed, compression processing for one frame of the moving picture is ended. By sequentially repeating the above processing for each frame, the moving picture is compressed.

On the expanding side, the basic processing of searching for a code vector corresponding to the received code number from the code book and applying the code vector to each block position is the same as in the above-described embodiments. In this embodiment, however, no code number is transferred for a block at a certain address. For such a block, an alternative code vector or pattern image must be prepared by some method.

To do this, for example, a reconstructed image storage section for storing a frame image reconstructed by decoding processing at time t is prepared as a component of the data expanding system. In generating a reconstructed image at time (t + 1) by decoding processing, if no code number is sent from the compressing side for a certain block, the previous frame image stored in the reconstructed image storage section is used as the image of that block. For discrimination between a block for which a code number is sent and a bock for which no code number is sent, the block address sent together with the code number is used.

As described above, in this embodiment, space direction vector quantization is performed for each of the frame images, and a space direction code number string is generated for each frame image. The change amount (absolute difference value) in code number at the same address is calculated between frames of frame images. Only when the change amount exceeds a predetermined threshold value, the data is transferred. When the change amount is smaller than the threshold value, the data is not transferred.

That is, of blocks of the frame images, only data whose values largely change between frames are transferred, and data with small changes are not transferred, and the data of the previous frame is used. Only data of portions having large motion are transferred. In addition to the space direction vector quantization result of each frame, the data can also be compressed along the frame direction (time-axis), so a high compression ratio can be obtained, unlike the case wherein only space direction vector quantization is executed.

(Ninth Embodiment)

Each of the above embodiments can be applied to a color image as well as a monochromatic image. In the ninth embodiment to be described below, especially in executing data compression using vector quantization for a color image, the image quality and compression ratio of the reconstructed image on the expanding side are further improved.

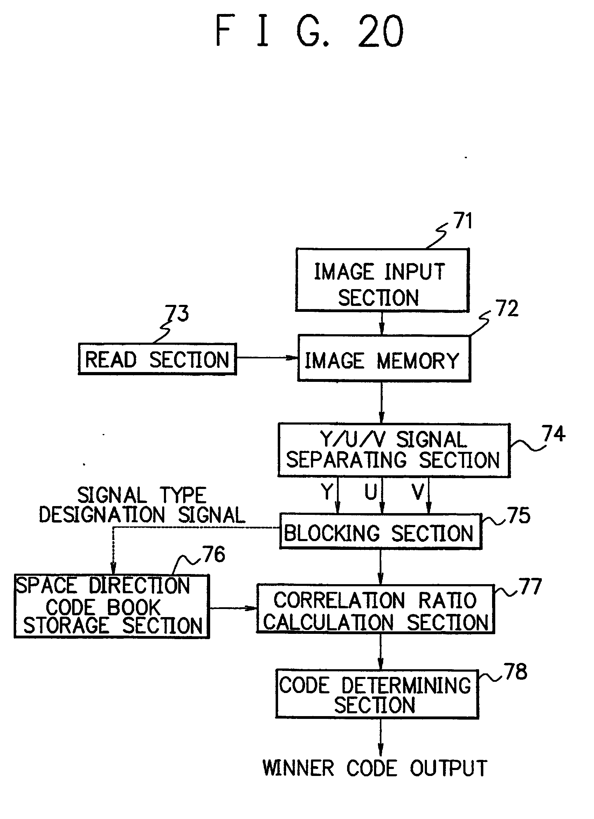

Fig. 20 is a block diagram showing the construction of a data compressing system according to this embodiment. Referring to Fig. 20, an original color image input from an image input section 71 is temporarily stored in an image memory 72 and read out and output by address control from a read section 73. The color image read out from the image memory 72 is supplied to a Y/U/V signal separating section 74.

The Y/U/V signal separating section 74 separates the Y signal (luminance signal), and U signal and V signal (chrominance signals) from the original image. A blocking section 75 segments each image data separated by the Y/U/V signal separating section 74 into blocks in units of, e.g., $4 \times 4$ pixels. At this time, the blocking section 75 sends to a space direction code book storage section 76 a signal type designation signal representing the blocking target, i.e., the Y, U, or V signal.

A correlation ratio calculation section 77 independently calculates the above-described similarity for each of the Y, U, and V signals separated and extracted in the above manner. On the basis of the similarity calculation result from the correlation ratio calculation section 77, a code determining section 78 outputs a code number corresponding to a code vector with the largest similarity as the compression code (Winner code) of that block.

In executing such space direction vector quantization, the correlation ratio calculation section 77 executes vector quantization using a code book stored in the space direction code book storage section 76 in advance. Which code book in the space direction code book storage section 76 is to be used is determined in accordance with the signal type designation signal. More specifically, the space direction code book storage section 76 stores in advance a number of code books, or a code book for the Y signal, a code book for the U signal, and a code book for the V signal. The code books for these signals are sequentially used in accordance with the signal type output from the blocking section 75 to the correlation ratio calculation section 77.

In this embodiment, a code book larger than those for the U and V signals is assigned to the Y signal. For example, the code book for the Y signal is formed from 8,192 code vectors (13 bits), and each of the code books for the U and V signals is formed from 128 code vectors (7 bits). However, the total size of code books for the Y, U and V signals is set to be equal to or smaller than the total size of uniquely assigned code books for these signals.

The most important signal to determine the image quality is generally the Y signal (luminance signal). For this reason, when the code book sizes (code length of code vectors) assigned to these signals are set such that the code book for the Y signal is larger than that for the U and V signals, the quality of the reconstructed image can be improved without changing the total code length.

More specifically, when compression is performing using a compression rate Y : U : V = 1 : 1 : 1, the entire code length does not change even when the number of code vectors assigned to the Y signal is larger than that for the U and V signals, and therefore, the compression ratio for one image does not change. In addition, since the number of code vectors for the Y signal is large, a code vector with larger similarity can be obtained by vector quantization in association with the Y signal which is more important for the image quality, and the quality of the reconstructed image improves.

The same effect as described above can be obtained not only when the compression rate is Y : U : V = 1 : 1 : 1 but also when it is 4 : 1 : 1 or 4 : 2 : 2. For example, when the compression rate is Y : U : V = 4 : 1 : 1, a 13-bit code is assigned to each block of Y signal, while a 7-bit code is assigned to four blocks of U and V signals. However, no problem is posed related to the color rearrangement since the human visual characteristic is relatively insensitive to chromatic error.

In addition, in the above embodiment, one correlation ratio calculation section 77 is commonly used as the space direction vector quantizing means for the Y, U, and V signals. However, two or more space direction vector quantization means may be prepared for the respective signals, and the signals may be parallelly processed.

Furthermore, in the above embodiment, the code books for the Y, U, and V signals are stored in one space direction code book storage section 76. However, the code books may be separately stored in different storage sections.

(10th Embodiment)

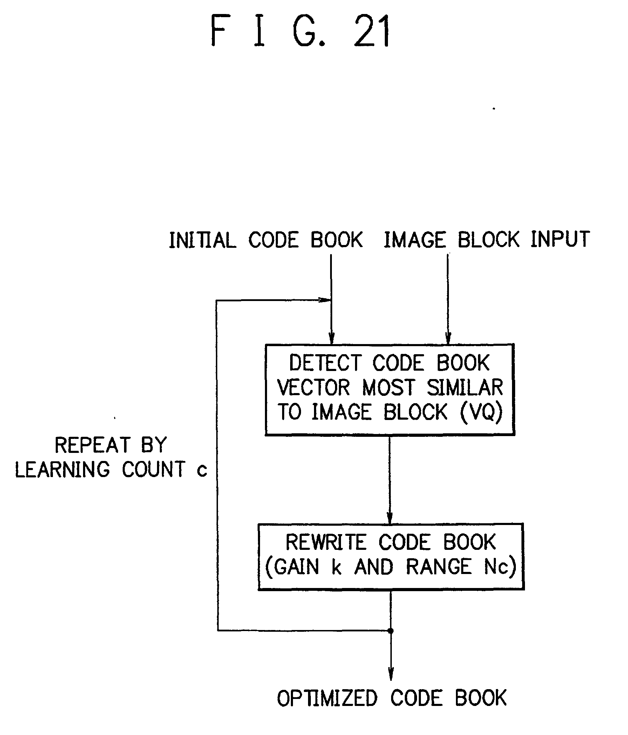

A method of making a space direction code book used to execute vector quantization for one image will be described next. In this embodiment, the Kohonen learning algorithm conventionally well known is used. Fig. 21 is an illustration showing the procedure of this Kohonen learning algorithm.

In this method, an initial code book to be given in learning is prepared, as shown in Fig. 21, and a sample image to be used for learning is prepared. In learning, image blocks each having, e.g., $4 \times 4$ pixels are sequentially input from the sample image and space direction vector quantization is performed using the code book, thereby detecting a code vector most similar to each input image block. On the basis of this result, the contents of the code book are rewritten.

A code book rewrite is done while setting a gain k in an equation representing the Kohonen learning algorithm and a rewrite range Nc to appropriate values. Such code vector detection and rewrite processing are repeated by a predetermined number of times of learning, thereby obtaining an optimized code book. In this embodiment, in executing this learning, various patterns are used as the initial code book.

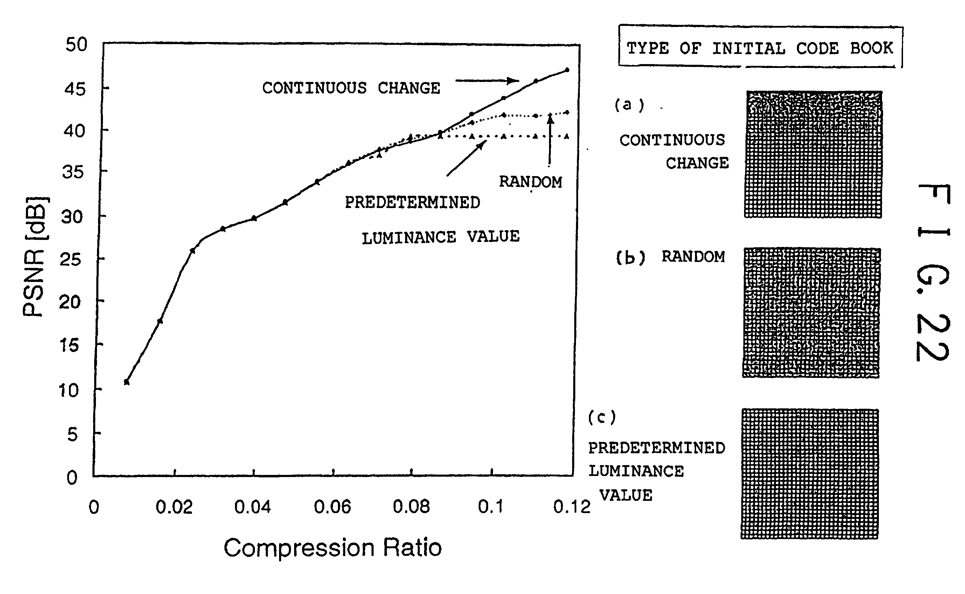

Referring to Fig. 22, a pattern (a) which continuously changes the luminance value from the minimum value to the maximum value of possible values of the initial code book, a pattern (b) which changes the luminance value at random, and a pattern (c) having a predetermined luminance value of 128 (intermediate value) are input, and the code book is optimized using these patterns. Fig. 22 shows an illustration showing the difference in PSNR (Peak Signal to Noise Ratio) characteristic when an image is compressed/expanded using the obtained code book. Each small square in (a) to (c) represents a code vector. As is apparent from Fig. 22, a more satisfactory result can be obtained when the pattern whose luminance value continuously changes is input as the initial code book.

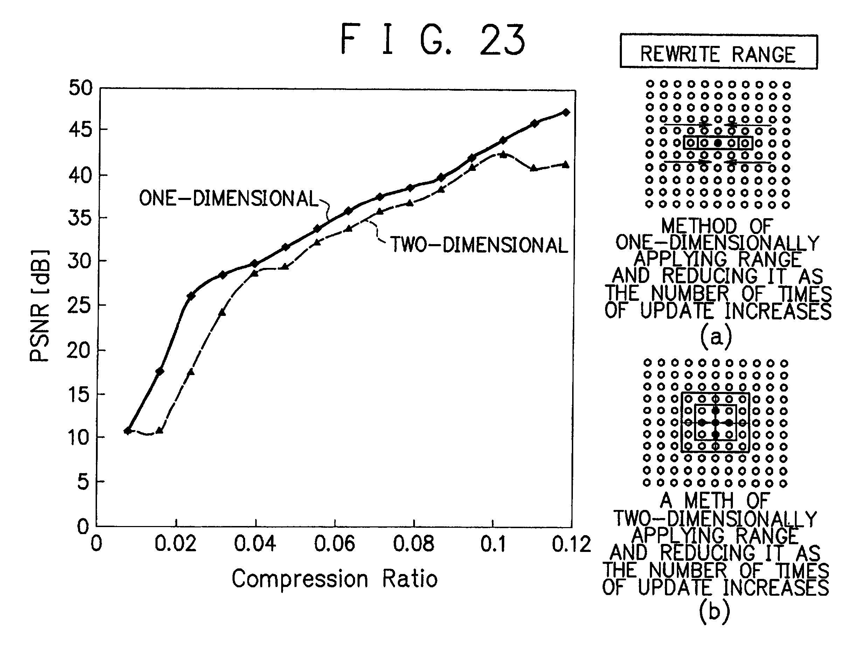

Fig. 23 shows illustrations of the difference in PSNR characteristic when code books are made by a method (a) of one-dimensionally applying the rewrite range in one learning cycle on a map (virtual two-dimensional plane) and reducing the rewrite range as the number of times of update increases, and a method (b) of two-dimensionally applying the rewrite range and reducing the rewrite range as the number of times of update increases, and an image is compressed/expanded.

Each of hollow and solid dots shown in Figs. 23(a) and 23(b) indicates a code vector block. A block indicated by a solid dot represents the current vector quantization target block. The rectangular range surrounding the hollow and solid dots represents the code book rewrite range. The arrows represent directions in which the rewrite range is reduced. As is apparent from Fig. 23, case (a) is more excellent than case (b).

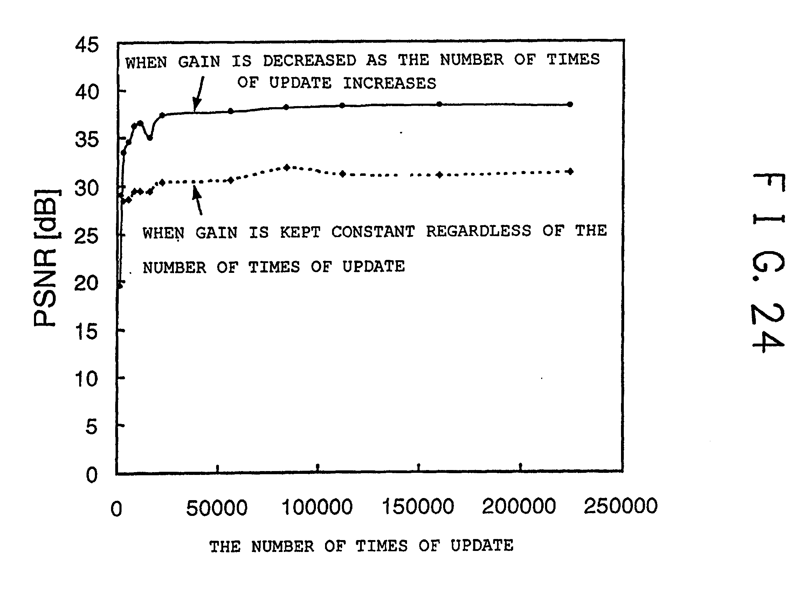

Fig. 24 is a graph showing the difference in PSNR characteristic between a case wherein the value of gain k in the Kohonen learning equation is not decreased from the initial value regardless of an increase in the number of times of update of the code book and a case wherein the gain is decreased from the initial value as the number of times of update increases. As is apparent from Fig. 24, the case wherein the value of the gain k is decreased from the initial value as the number of times of update of the code book increases is more excellent.

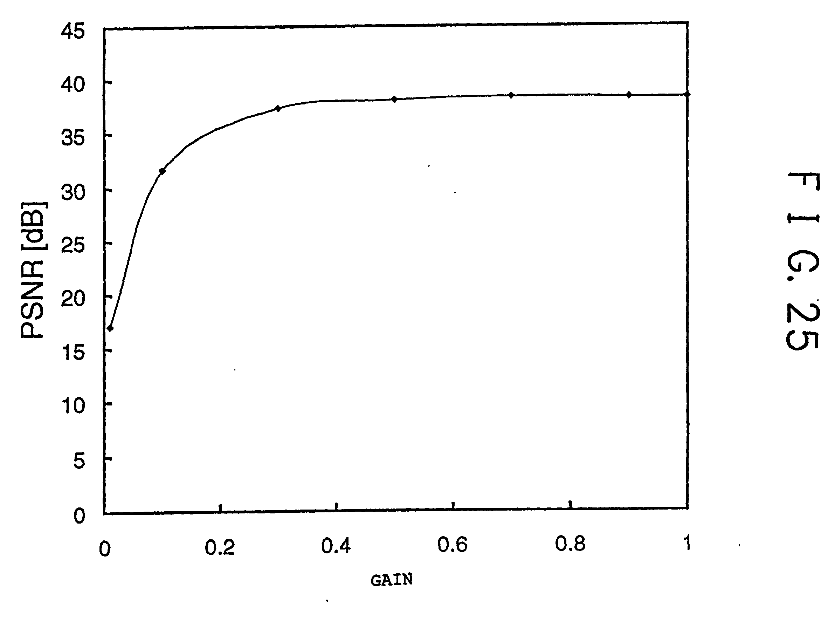

Fig. 25 is a graph showing the difference in PSNR characteristic when the code book is made by giving various values as the initial value of gain k and setting the number of times of update to, e.g., 160,000. As is apparent from Fig. 25, when the initial value of gain k is 0.3 to 1, an excellent result is obtained.

As is apparent from the results shown in Figs. 22 to 25, when learning is done by specifying the best parameter value for improving the image quality from various parameters, and a code book made in this way is used for the data compressing/expanding system, the quality of the reconstructed image can be improved. For example, a pattern which continuously changes the luminance value from the minimum value to the maximum value of possible values is used as the initial code book to be given for learning. In addition, the range for influence in one learning cycle is one-dimensionally applied and reduced as the number of times of update increases. Furthermore, the initial value of gain coefficient k to be given for learning is set to a value within the range of 0.3 to 1, and the coefficient value is decreased as the number of times of update increases. Thus, an accurate code book can be obtained, and the quality of a reconstructed image compressed/expanded using this code book can be improved.

(11th Embodiment)

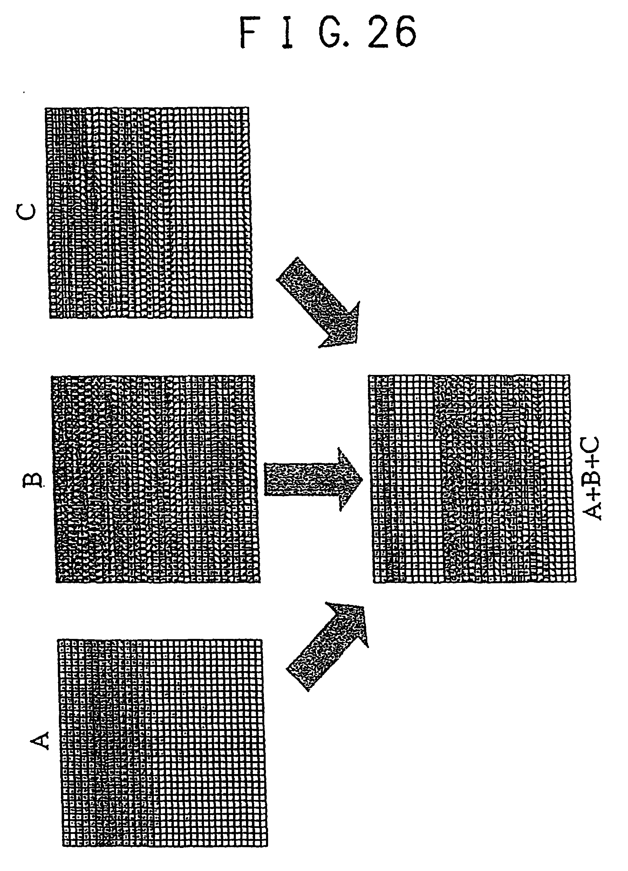

In this embodiment, code books are made by learning and synthesized to make a new code book, thereby obtaining an accurate code book. Fig. 26 is an illustration showing a method of combining the characteristic features of three code books A, B, and C obtained by optimization into one code book A + B + C .

Referring to Fig. 26, the size of the code book A + B + C (the number of code vectors) is, e.g., 1,024, like the single code book size of each of the code book A, B, and C. That is, patterns included in the combined code book A + B + C are obtained by appropriately thinning and synthesizing patterns included in the individual code books A, B, and C.

In this case, a code book obtained by the Kohonen self-organizing map has similar patterns existing close to each other on the map. For this reason, every second patterns are sequentially extracted from the upper left corner on the map of each of the code books A, B, and C and reconstructed into the new code book A + B + C . Thus, the new code book A + B + C is made while preserving the characteristic feature of each of the code books A, B, and C.

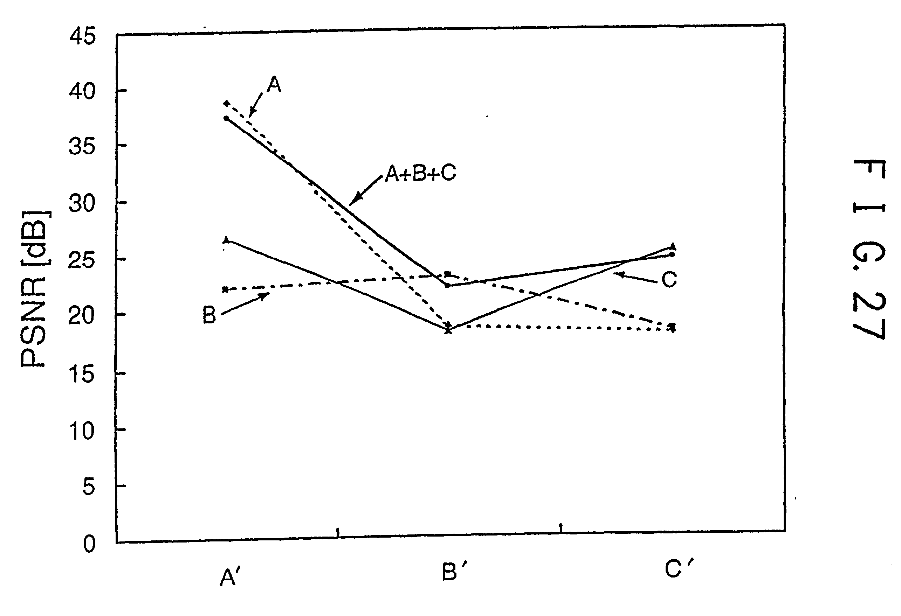

Fig. 27 is a graph showing the PSNR characteristic of an image obtained by executing vector quantization for images A', B', and C' using the code books A, B, C, and A + B + C shown in Fig. 26 and then reconstructing the images. The images A', B', and C' are sample images used to make the single code books A, B, and C.

As is apparent from Fig. 27, the single code books A, B, and C exhibit almost satisfactory results for the sample images A', B', and C' used to make the code books, though no satisfactory result is obtained for an image of another type. For example, when the code book A is used, a satisfactory result is obtained for the sample image A', though no satisfactory result is obtained for the remaining images B' and C'.

To the contrary, the PSNR characteristic when the synthesized code book A + B + C is used is equivalent to the characteristic obtained when the single code books A, B, and C are used and also includes all the characteristics. When a code book is made by combining some characteristic images, a code book having versatility to various images can be made. For example, code books are made using images of human faces, landscapes, and characters and synthesized, a versatile code book can be made without increasing the size of the code book memory.

In the above embodiment, three code books having the same size are combined into one code book. However, the number of code books is not limited to three, and two code books or three or more code books may be synthesized into one code book. Additionally, code books having different sizes may be synthesized into one code book.

(12th Embodiment)

To select the most similar code vector from a code book by vector quantization, calculation in an enormous amount is necessary. For this reason, in designing hardware dedicated to vector quantization, an enormous hardware area is normally required for high-speed calculation. In the embodiment to be described below, high-speed calculation is realized without increasing the hardware scale.

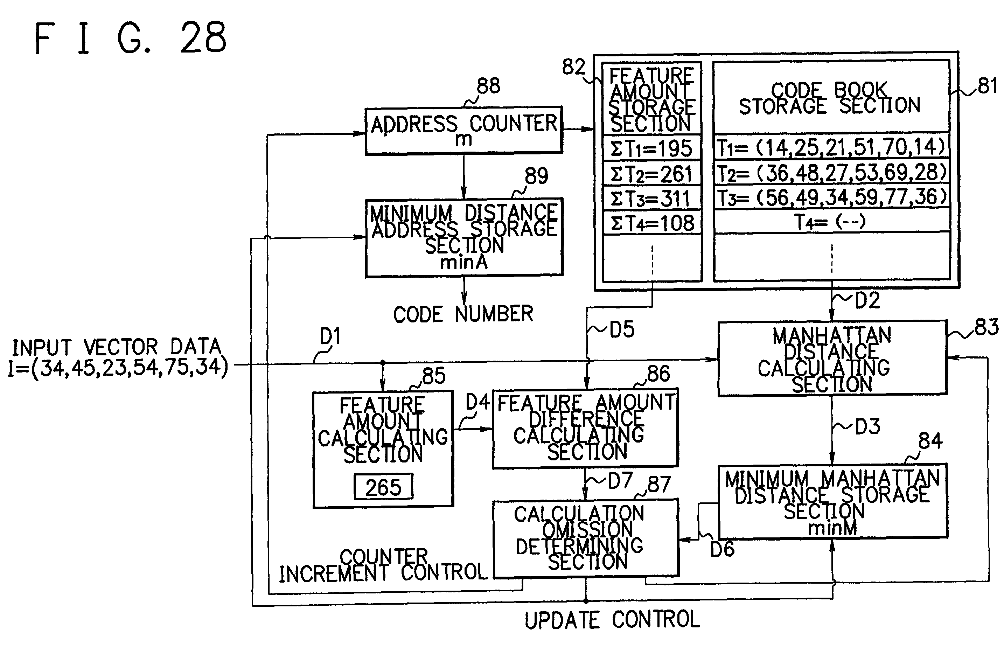

Fig. 28 is a block diagram for explaining the construction of a vector quantizing device which uses the Manhattan distance as a function for obtaining the similarity between two input vectors, which is expressed as a numerical value, and the sum of elements of vector data as the feature amount of an image, and the state wherein calculation is omitted. When the Manhattan distance is used as a similarity, the similarity increases as the distance decreases.

First, the principle of calculation omission will be described.

Let n be the number of dimensions (the number of elements) of vector data, and k be the total number of template vector (code vector) data in a code book storage section 81. At this time, when, for

$$\text{input vector data: } I = (I_1, I_2,..., I_n) \text{ and}$$

$$\text{template vector data: } T_m = (T_{m1}, T_{m2},.., T_{mn})$$

$$(m = 1, 2,..., k)$$

the similarity between the input vector data I and the template vector data $T_m$ is defined using a Manhattan distance $M_m$ represented by equation (1) below, operation of searching the template vector data $T_m$ most similar to the input vector data I corresponds to operation of searching the value m when the distance $M_m$ is minimized in all Manhattan distances $M_m$ (m = 1, 2.,..., k).

$$M_m = \Sigma|I_i - T_{mi}| \text{ (i = 1 to n)} \qquad \text{equation (1)}$$

Note that a relation $D_m \leqq M_m$ holds between the Manhattan distance $M_m$ given by equation (1) and an absolute value $D_m$ of the difference between the sum of elements of the input vector data I and the sum of elements of the template vector data $T_m$, which is given by equation (2) below. In this case, the following argument holds.

$$D_m = |\Sigma I_i - \Sigma T_{mi}| \text{ (i = 1 to n)} \qquad \text{equation (2)}$$

More specifically, assume that the Manhattan distance $M_m$ between the input vector data I and the template vector data $T_m$ in the code book storage section 81 is known. At this time, assume that when, for each of the input vector data I and template vector data $T_0$ in the code book storage section 81, which is different from the template vector data $T_m$, the sum of elements is calculated, and an absolute value $D_0$ of the difference between the sums is calculated, $D_0 > M_m$ holds.

In this case, $M_0 > M_m$ always holds because of the above-described relation $D_m \leqq M_m$. Hence, only calculation of the absolute difference value $D_0$ reveals that the template vector data $T_0$ is not similar to the input vector data I as compared to the template vector data $T_m$, without calculating the Manhattan distance $M_m$ between the template vector data $T_0$ and the input vector data I. That is, the template vector data $T_0$ can be excluded from the search targets.

Only the above fact apparently indicates that even when the Manhattan distance $M_0$ is not calculated for the template vector data $T_0$, processing related to search does not decrease as long as the absolute difference value $D_0$ need be calculated. However, in calculation of the absolute difference value $D_0$, the sum $\Sigma T_{mi}$ (the second term of the right-hand side of equation (2)) of elements as the feature amount of the template vector data $T_m$ can be calculated in advance and stored in a feature amount storage section 82.

Hence, the absolute difference value $D_0$ can be calculated only by calculating the feature amount of the input vector data I and calculating the difference between the calculated feature amount and the feature amount stored in the feature amount storage section 82. In addition, the feature amount of the input vector data I can be calculated by one calculation for one input vector data. For this reason, the absolute difference value $D_0$ can be calculated in a much smaller calculation amount than that for calculation of the Manhattan distance $M_0$.

Note that use of the sum of elements of vector data as a feature amount is equivalent to use of the average value of elements. This is because the average value of elements is a value obtained by dividing the sum of elements by the number of elements.

A detail description will be made below with reference to Fig. 28.

Referring to Fig. 28, the input vector data I and the template vector data $T_1$, $T_2$, $T_3$, $T_4$,... in the code book storage section 81 are, for example, six-dimensional vector data, though they can have an arbitrary number of dimensions. The feature amount storage section 82 stores the feature amounts (e.g., the sums of elements) $\Sigma T_1$, $\Sigma T_2$, $\Sigma T_3$, $\Sigma T_4$,... of the template vector data $T_1$, $T_2$, $T_3$, $T_4$,... stored in the code book storage section 81.

Referring to Fig. 28, the template vector data $T_1$, $T_2$, $T_3$, $T_4$,... in the code book storage section 81 and the feature amounts $\Sigma T_1$, $\Sigma T_2$, $\Sigma T_3$, $\Sigma T_4$,... in the feature amount storage section 82 located immediately on the left side correspond to each other. More specifically, the feature amount of the template vector data $T_1$ is $\Sigma T_1$, and the feature amount of the template vector data $T_2$ is $\Sigma T_2$,.... The data in the code book storage section 81 and feature amount storage section 82 are sequentially read out in accordance with an address from an address counter 88.

A Manhattan distance calculating section 83 obtains the Manhattan distance $M_m$ ( m = 1 to k ) between each template vector data $T_m$ represented by d2 transferred from the code book storage section 81 and the input vector data I represented by d1 and outputs Manhattan distance data represented by d3. A minimum Manhattan distance storage section 84 stores a minimum distance minM of the previously calculated Manhattan distances $M_m$ in accordance with update control by a calculation omission determining section 87.

When calculation for one input vector data I and all template vector data $T_m$ is ended, template vector data corresponding to the distance stored in the minimum Manhattan distance storage section 84 is data most similar to the input vector data I. An address minA of the most similar template vector data (with the shortest distance) is supplied from the address counter 88 to a minimum distance address storage section 89 and stored in accordance with update control by the calculation omission determining section 87.

Hence, when processing for one input vector data I is ended, the address stored in the minimum distance address storage section 89 corresponds to the code number of the block. This code number can be output every time processing for one input vector data I is ended. Alternatively, the code numbers may be output together when processing for the entire image is ended.

A feature amount calculating section 85 calculates the sum of elements of the input vector data I and outputs the result. While calculation for obtaining the similarity for at least the same input vector data I is being performed, the calculated feature amount is kept stored. A feature amount difference calculating section 86 calculates the difference between a feature amount d4 of the input vector data I, which is obtained by the feature amount calculating section 85, and a feature amount d5 of the template vector data $T_m$, which is read out from the feature amount storage section 82, and outputs the difference.

The calculation omission determining section 87 determines whether the Manhattan distance between the template vector data $T_m$ and the input vector data I need be calculated, using a minimum Manhattan distance d6 obtained so far, which is output from the minimum Manhattan distance storage section 84, and a feature amount difference d7 calculated by the feature amount difference calculating section 86.

The calculation omission determining section 87 sends the determination result to the Manhattan distance calculating section 83 to omit unnecessary calculation and also outputs a predetermined control signal to the minimum Manhattan distance storage section 84, address counter 88, and minimum distance address storage section 89 to control to update their contents.

The contents of the address counter 88 are updated every time one processing is ended. However, the contents of the minimum Manhattan distance storage section 84 and minimum distance address storage section 89 are updated only when predetermined conditions are satisfied. The control signal to a Manhattan distance calculating section 202 is not always necessary when the value of an address counter 208 is incremented before the read of the template vector data.

The procedure of vector quantization of the vector quantizing device having the above construction will be described next. Omission of calculation will be described simultaneously.

1) First, the feature amount of the input vector data I is calculated by the feature amount calculating section 85, and the result is stored. For one input vector data I, one calculation of the feature amount suffices.

2) Next, the Manhattan distance $M_1$ between the input vector data I and the first template vector data $T_1$ in the code book storage section 81 is calculated by the Manhattan distance calculating section 83. The calculation result is given by equation (3) below. At this stage, since only one Manhattan distance is calculated, the minimum Manhattan distance minM currently known is $M_1$. Hence, this Manhattan distance $M_1$ is stored in the minimum Manhattan distance storage section 84.

$$M_1 = \Sigma |I_i - T_{1i}| \ (i = 1 \text{ to } 6) = 70 \qquad \text{equation (3)}$$

3) An absolute value $D_2$ of the difference between the feature amount $\Sigma T_2$ of the second template vector data $T_2$ in the feature amount storage section 82 and the feature amount (265 in this example) of the input vector data I, which is stored in the feature amount calculating section 85, is obtained by the feature amount difference calculating section 86. The calculation result is given by

$$D_2 = |\Sigma I_i - \Sigma T_{2i}| \; (i = 1 \text{ to } 6) = 4 \qquad\qquad \text{equation (4)}$$

4) On the basis of the absolute value $D_2$ of the feature amount difference obtained by procedure 3) and the minimum Manhattan distance minM currently known, the calculation omission determining section 87 determines whether the Manhattan distance $M_2$ between the second template vector data $T_2$ and the input vector data I need be calculated. In this case, since $D_2 < \text{minM} (= M_1)$, calculation of the Manhattan distance $M_2$ between the second template vector data $T_2$ and the input vector data I cannot be omitted.

5) Since it is determined by procedure 4) that the Manhattan distance $M_2$ between the second template vector data $T_2$ and the input vector data I need be calculated, the Manhattan distance calculating section 83 executes this calculation. The calculation result is $M_2 = 22$. Since this is smaller than the Manhattan distance minM $(= M_1)$ currently known, the value minM is updated to $M_2$. Hence, $\text{minM} = M_2$. That is, the minimum Manhattan distance storage section 84 stores the Manhattan distance $M_2$ related to the second template vector data $T_2$.

6) An absolute value $D_3$ of the difference between the feature amount $\Sigma T_3$ of the third template vector data $T_3$ in the feature amount storage section 82 and the feature amount of the input vector data I, which is stored in the feature amount calculating section 85, is obtained by the feature amount difference calculating section 86. The calculation result is $D_3 = 46$.

7) On the basis of the absolute value $D_3$ of the feature amount difference obtained by procedure 6) and the minimum Manhattan distance minM currently known, the calculation omission determining section 87 determines whether the Manhattan distance $M_3$ between the third template vector data $T_3$ and the input vector data I need be calculated. In this case, since $D_3 > \text{minM} (= M_2)$, calculation of the Manhattan distance $M_3$ between the third template vector data $T_3$ and the input vector data I can be omitted.

8) Since it is determined by procedure 7) that calculation of the Manhattan distance $M_3$ between the third template vector data $T_3$ and the input vector data I can be omitted, this calculation is omitted. An absolute value $D_4$ of the difference between the feature amount $\Sigma T_4$ of the fourth template vector data $T_4$ and the feature amount of the input vector data I is calculated by the feature amount difference calculating section 86. The calculation result is $D_4 = 157$.

9) On the basis of the absolute value $D_4$ of the feature amount difference obtained by procedure 8) and the minimum Manhattan distance minM currently known, the calculation omission determining section 87 determines whether the Manhattan distance $M_4$ between the fourth template vector data $T_4$ and the input vector data I need be calculated. In this case, since $D_4 > \text{minM} (= M_2)$, calculation of the Manhattan distance $M_4$ between the fourth template vector data $T_4$ and the input vector data I can also be omitted.

10) The same processing as described above is repeated until $m = k$.

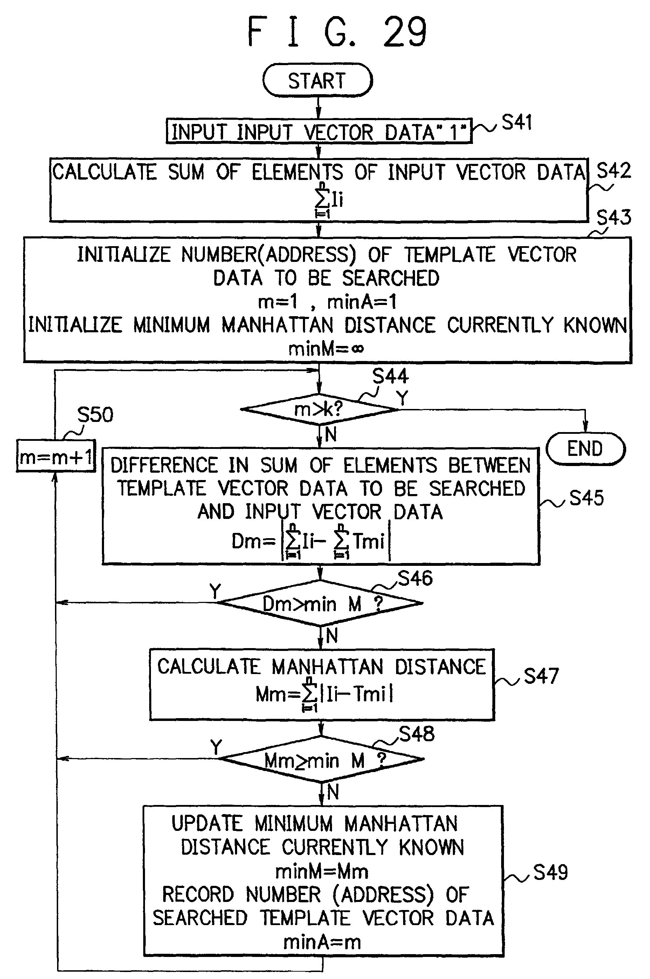

Fig. 29 is a flow chart showing the above-described procedure of vector quantization processing of this embodiment. This flow chart will be described below.

Referring to Fig. 29, first in step S41, the input vector data I is input. In step S42, the sum of elements (feature amount) of the input vector data I is calculated, and the result is stored.

In step S43, the numbers (addresses) of template vector data to be searched are initialized to m = 1 and minA = 1, and simultaneously, the value of the currently known minimum absolute difference value minM is initialized to ∞. In step S44, it is determined whether the value of the address counter m exceeds the number k of template vector data. If NO in step S44, the flow advances to step S45.

In step S45, the absolute value $D_m$ of the difference between the feature amount stored in advance for the template vector data $T_m$ to be searched and the feature amount of the input vector data I, which is stored as a result of calculation, is obtained. It is determined in step S46 whether the calculated absolute difference value $D_m$ is equal to or larger than the value of the minimum Manhattan distance minM currently known.

If YES in step S46, the value of the address counter m is incremented in step S50, and the flow returns to processing in step S44. If NO in step S46, the flow advances to step S47 to calculate the Manhattan distance $M_m$ between the input vector data I and the template vector data $T_m$ to be searched.

It is determined in step S48 whether the calculated Manhattan distance $M_m$ is equal to or larger than the current minimum Manhattan distance minM. If YES in step S48, the value of the address counter m is incremented in step S50, and the flow returns to processing in step S44. If NO in step S48, the flow advances to step S49.

In step S49, the value of the minimum Manhattan distance minM is updated to the calculated Manhattan distance $M_m$, and the number (address) of the searched template vector data is recorded in the minimum distance address storage section 89. After the value of the address counter m is incremented in step S50, the flow returns to processing in step S44.

As described in the above procedures, when the vector quantizing device having the construction shown in Fig. 28 is used, in searching the template vector data most similar to the input vector data I, the similarity calculation necessary for the search can be reduced, and high-speed calculation can be realized.

Referring to Fig. 28, the template vector data $T_1$, $T_2$, $T_3$, $T_4$,... in the code book storage section 81 are arranged in an arbitrary order. However, they may be arranged in descending order of feature amounts. When the template vector data are arranged in the order of feature amounts, template vector data can be easily searched from template vector data having a feature amount closest to that of the input vector data I. Since two vector data having feature amounts close to each other tend to have large similarity, similarity calculation can be further omitted by searching from template vector data closest to that of the input vector data.

In this embodiment, each vector data to be processed by the vector quantizing device is six-dimensional data. However, the number of dimensions of each vector data can be arbitrary.

The vector quantizing device shown in Fig. 28 can be implemented by dedicated hardware or software by a program on a computer. When it is implemented by hardware, the newly provided feature amount calculating section 85, feature amount difference calculating-section 86, and calculation omission determining section 87 do not require a large hardware area.

In the above embodiment, the feature amount of vector data is not limited to the sum of elements of the vector data. For example, to use the variance of vector data, the feature amount calculating section 85 and calculation omission determining section 87 are modified for variance calculation. When the function for obtaining similarity is to be changed to a function for obtaining a value other than the Manhattan distance, e.g., the Euclidean distance, the Manhattan distance calculating section 83, minimum Manhattan distance storage section 84, and calculation omission determining section 87 are modified.

(13th Embodiment)

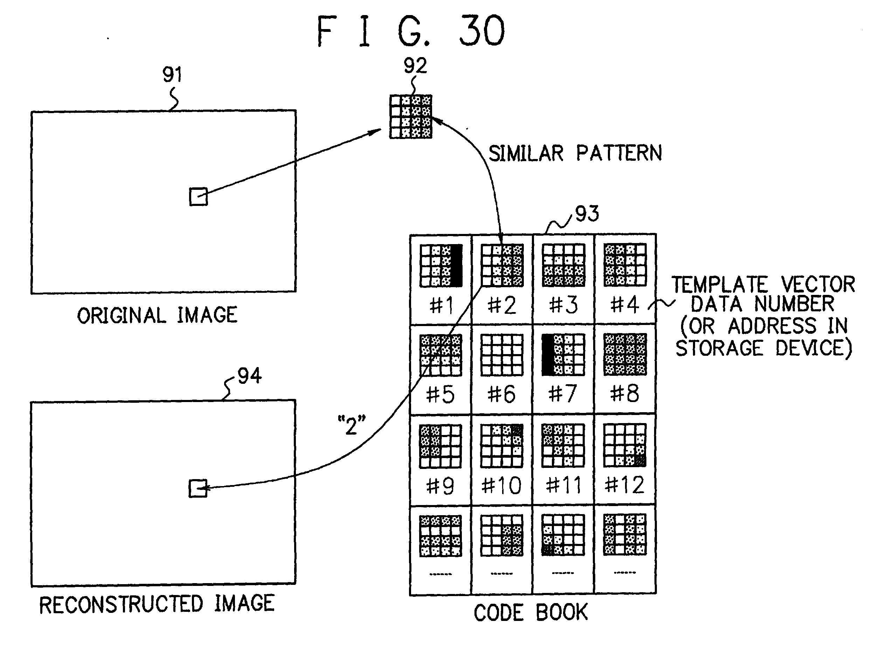

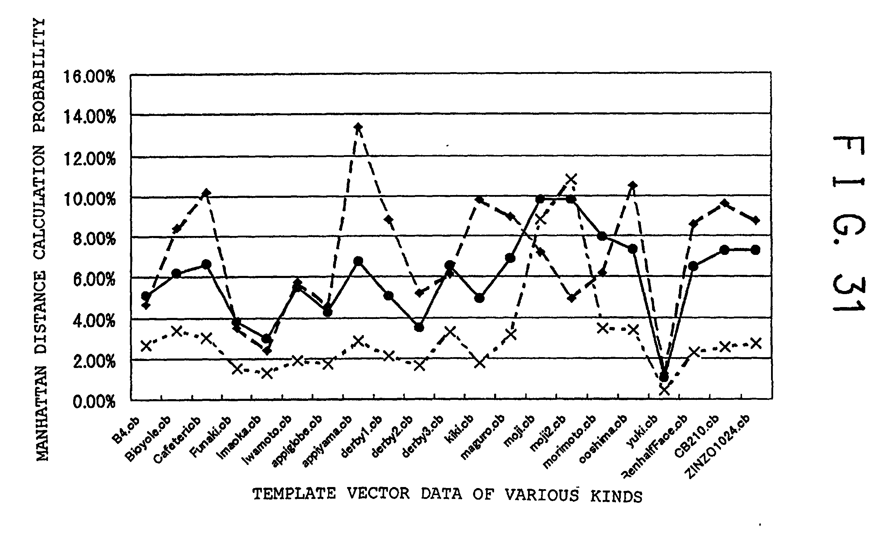

In the 13th embodiment, an example in which image data is used as the input to a vector quantizing device according to the 12th embodiment, and the vector quantizing device of the above embodiment is applied to an image compressing device will be described with reference to Figs. 30 and 31. A general example of image compression using the vector quantizing device will be described first with reference to Fig. 30.

Referring to Fig. 30, an original image 91 to be input is formed from a number of elements called pixels. Each pixel has information such as a luminance value or color difference signal. An input image block 92 is a block formed from pixels and extracted from the input image 91. In the example shown in Fig. 30, a $4 \times 4$ pixel size is selected as the size of the input image block 92, though an arbitrary size can be selected.

Since the input image block 92 has pixels, as described above, the luminance values of the pixels can be collected as vector data. This corresponds to input vector data I of the vector quantizing device described with reference to Fig. 28.

Some input image blocks in the input image 91 sometimes appear to be almost equal to each other due to the human visual characteristic. Such input image blocks that look equal can be represented by a smaller number of image blocks. An image block code book 93 has image blocks (template vector data) each representing a number of input image blocks on the input image 91. Template vector data has, as vector data, the luminance of the pixels in each image block in the image block code book 93.

The vector quantizing device segments the entire input image 91 into image blocks arid searches the code book 93 for template vector data similar to each input image block 92 as input vector data. The image can be compressed by transferring only the numbers of corresponding template vector data. To reconstruct the compressed image and obtain a reconstructed image 94, template vector data corresponding to the transferred numbers are read out from the code book 93 and applied to the image.

In this embodiment, after the input vector data represented by the image block 92 is extracted from the input image 91, when the Manhattan distance is used as a function for obtaining similarity, and the sum of elements of vector data is used as a feature amount, the procedure of vector quantization is the same as in the above-described 12th embodiment (a detailed description of the procedure will be omitted). Hence, in searching template vector data similar to the input vector data, calculation related to the search can be reduced, so high-speed image compression can be performed.

Fig. 31 is a graph showing how much the Manhattan distance calculation can be reduced by executing the vector quantization operation for image data by the above method. Fig. 31 shows the ratios of template vector data in various template vector data groups, for which the Manhattan distance must be calculated, when pictures of outdoor landscape, pictures of indoor landscape, and pictures of human figures are used as input images.

As is apparent from Fig. 31, the ratio of template vector data in the template vector data groups, for which the Manhattan distance from the input vector data must be calculated, is about 14% or less, indicating the usefulness of this embodiment.

In the above example, the luminance values of pixels are used as vector data. Not only the luminance values but also any other information of each pixel, which is represented as a numerical value, can be used as vector data. In addition, after the input image block 92 is extracted from the input image 91, the image data may be subjected to various conversion operations, represented by discrete cosine transform, and then, vector data may be prepared from the converted image and input to the vector quantizing device.

If the input vector data is image data, use of the sum of elements of vector data as a feature amount is equivalent to use of a DC component obtained by frequency-dividing the image data. This is because the DC component is obtained by multiplying the sum of elements of vector data by a certain coefficient.

(14th Embodiment)

When image data is used as the input to the vector quantizing device described in the 12th embodiment, a characteristic unique to the image can be used as a feature amount of vector data. In this embodiment, a feature amount unique to image data when the image data is used as the input to the vector quantizing device will be described, and the fact that the calculation amount of vector quantization processing can be reduced by combining some feature amounts will be described below.

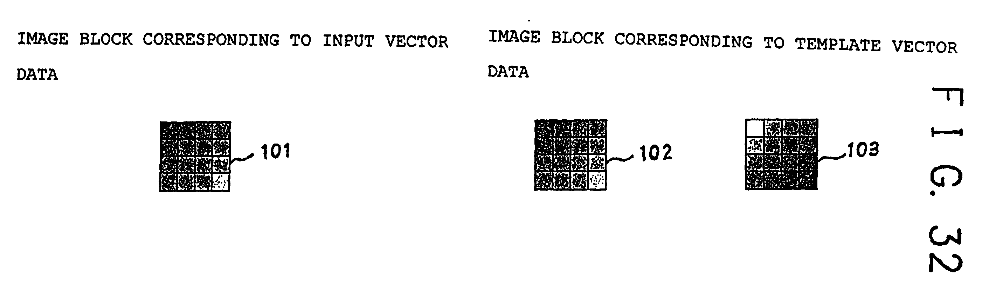

A problem which arises when a Manhattan distance is used as a function for calculating similarity of image data, and the sum of vector elements is used as a feature amount will be described first with reference to Fig. 32. Referring to Fig. 32, an image block 101 corresponding to input vector data is almost equal to an image block 102 corresponding to template vector data. On the other hand, an image block 103 corresponding to another template vector data is vertically and horizontally inverted from the image block 101 corresponding to the input vector data, so the two image blocks are apparently different at all.

Actually, when the luminance values of pixels of the input image block 101 and template image blocks 102 and 103 are extracted, and the Manhattan distances are calculated using the luminance values as vector data, the template image block 103 is less similar to the input image block 101 than another template image block 102.

However, the sums of elements of vector data as the feature amounts are the same for the two template image blocks 102 and 103. This means that when only the sum of elements of vector data is used as a feature amount, many wasteful similarity calculations remain.

To solve this problem, a means which uses the sum of elements after some of the elements of vector data are operated to invert the density pattern of the pixels is used as a feature amount is available.

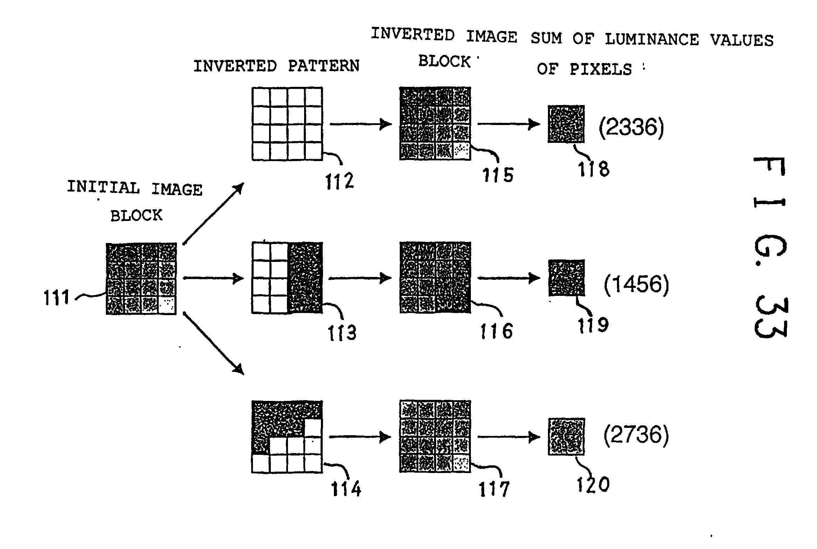

Fig. 33 shows a change in image block when the density pattern of some elements of vector data is inverted. An initial image block 111 is operated using three inverted patterns 112 to 114 such that the density pattern of pixels at the solid portions is inverted, thereby obtaining inverted image blocks 115 to 117. When the density pattern of one image is inverted using the different inverted patterns 112 to 114, sums 118 to 120 of the luminance values of the pixels of the inverted image blocks 115 to 117 are different although the initial image block is single.

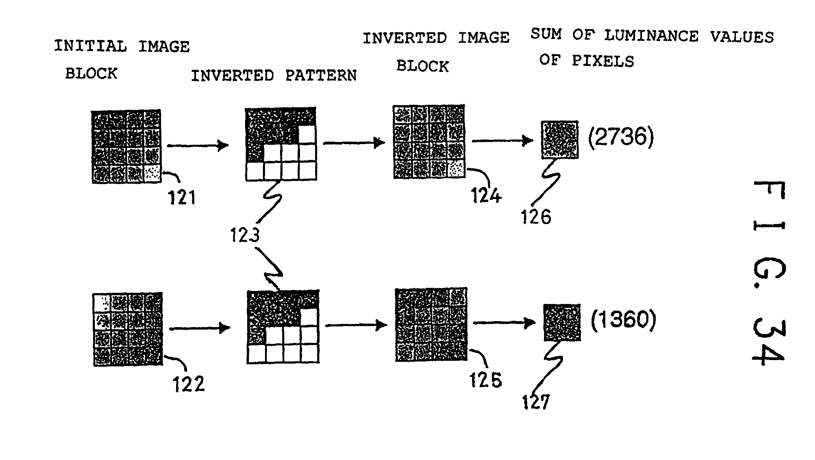

Fig. 34 is an illustration showing an example in which although the sums of elements of vector data are equal, when some of the elements of the data compressing device are operated such that the density pattern of the pixels is inverted, and then the sums of the elements of vector data are calculated as feature amounts, the feature amounts have a difference. Referring to Fig. 34, the sums of the luminance values of initial image blocks 121 and 122 are equal. Hence, when the sums of elements of vector data, i.e., the sums of luminance values of pixels in the blocks are used as feature amounts, the image blocks cannot be discriminated from each other.

For such two initial image blocks 121 and 122, when the density pattern of the solid portion of the same inverted pattern 123 is inverted, and sums 126 and 127 of luminance values of pixels in inverted image blocks 124 and 125 are calculated, the sums have different values.

This embodiment uses the above facts to further decrease wasteful Manhattan distance calculation. More specifically, as is apparent from the above examples, similarity calculation that cannot be omitted using a certain feature amount may be omitted using another feature amount. In this case, when two or more different feature amounts are used, the calculation amount can be further decreased.

More specifically, a method using feature amounts in two steps, in which the range for similarity calculation is narrowed down from template vector data using a certain feature amount, and then, the range is further narrowed down using another feature amount, or a method simultaneously using two feature amounts, in which a feature amount that exhibits a larger difference is used to determine calculation omission, can be used.

When an input image block is extracted from an image as an input to the vector quantizing device, some feature amounts unique to the image are available in addition to the above-described "sum of vector data after some elements of the vector data are operated such that the density pattern of pixels is inverted". A method using information of pixels at the four corners of an image block as feature amounts and a method using a change in pixel value on the image block as a feature amount will be described below.

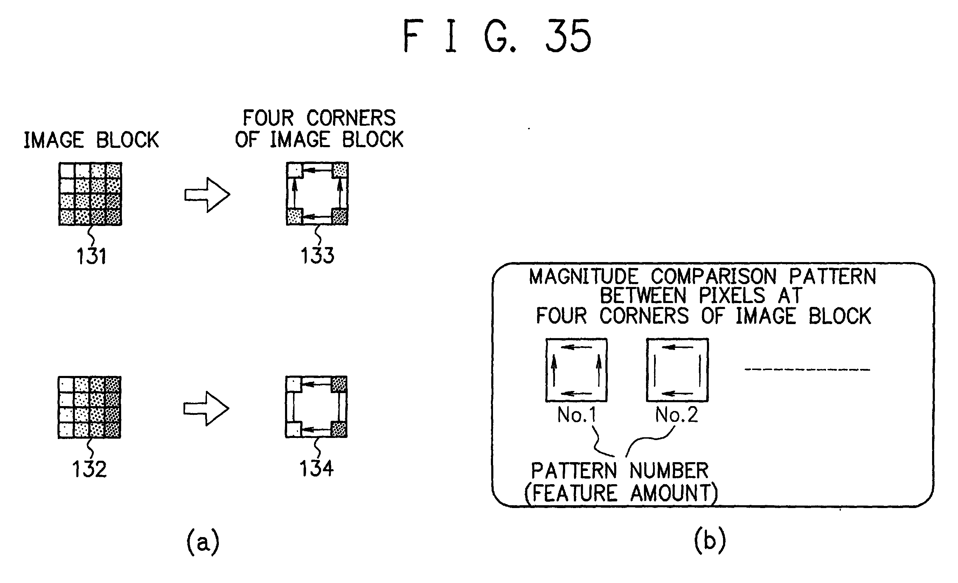

First, the method using information of pixels at the four corners of an image block as feature amounts will be described. When an image block is extracted from an input image whose pixel value smoothly changes in a predetermined direction in the block, feature amounts can be obtained from the four corners of the image block. Fig. 35 shows illustrations for explaining the method using the four corners of an image block as feature amounts.

Referring to Fig. 35(a), an image block 131 has luminance which changes to gradually become bright from the lower right corner to the upper left corner. When four corners 133 are extracted from this image block 131, and the luminance values of the four pixels of the four corners are compared, the direction in which the luminance of the image block 131 changes can be grasped.

An image block 132 and its four corners 134 have a pixel value change direction different from the above example. The luminance changes to gradually become bright from the right side to the left side of the image block. The arrows in the four corners 133 and 134 indicate the ascending direction of luminance values of pixels. A pixel near the arrow point has a large luminance value. When luminance values have no difference, their relationship is indicated by a line segment.

When the magnitudes of luminance values are compared between the pixels at the four corners of an image block and determined, the characteristic feature of the image block can be known. There are various luminance change patterns between the pixels at the four corners. These patterns are numbered and used as feature amounts. More specifically, as shown in Fig. 35(b), luminance change patterns between the pixels at the four corners can be numbered, and the numbers can be incorporated in the vector quantizing device of this embodiment as feature amounts.

Although the size of the image block shown in Fig. 35 is $4 \times 4$ pixels, the size can be arbitrary. In addition, although a luminance value is used as a pixel value, another pixel value (e.g., a chrominance signal value) may be used.

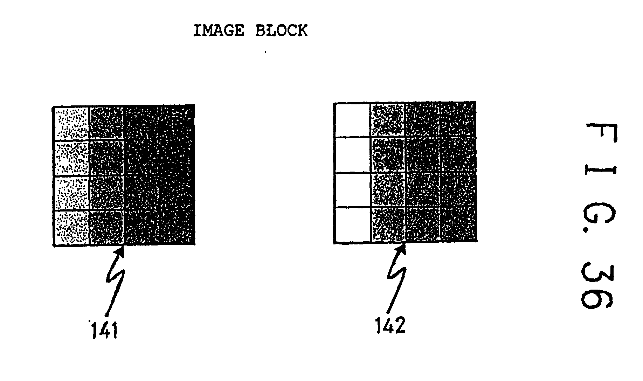

Next, the method using a change in pixel value on an image block as a feature amount will be described. When image blocks are extracted from an input image, some image blocks have similar changes in pixel value. Fig. 36 is an illustration showing two image blocks 141 and 142 in which the period and rate of a change in pixel value are the same. In these image blocks 141 and 142, the pixel value changes only in the horizontal direction.

The horizontal change in pixel value of the image block 141 equals to that obtained by multiplying the horizontal change in pixel value of the other image block 142 by a predetermined coefficient to suppress the amplitude of change. This is called a state wherein the pixel value change modes on the image blocks 141 and 142 are the same.

There are a number of pixel value change modes on an image block, and the change modes can be numbered and used as feature amounts. More specifically, each pixel value change mode can be numbered, and the number can be incorporated in the vector quantizing device of this embodiment as a feature amount.

Although the size of the image block shown in Fig. 36 is also $4 \times 4$ pixels, the size can be arbitrary.

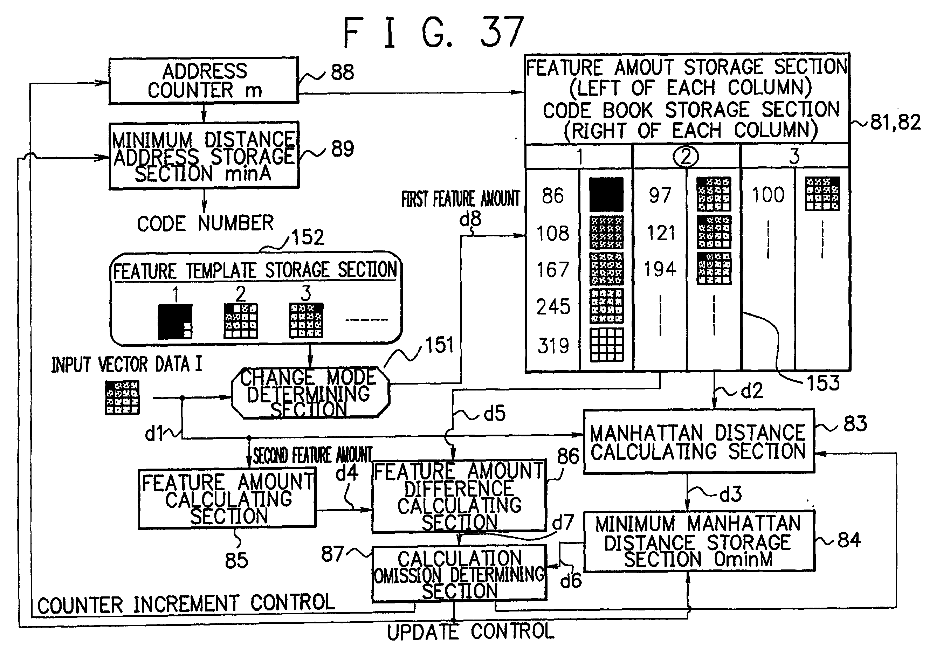

Finally, the construction of the vector quantizing device according to the 14th embodiment, which uses, as a first feature amount, a change in pixel value on the image block, i.e., a numbered change mode on an image block, and as a second feature amount, the sum of pixel values on the image block, i.e., the sum of elements of vector data will be described with reference to Fig. 37. The same reference numerals as in Fig. 28 denote the same blocks in Fig. 37. In this case, similarity is calculated on the basis of a Manhattan distance. Referring to Fig. 37, each vector data is visually expressed as a corresponding image block.

Input vector data I is classified in accordance with the first feature amount, i.e., the pixel value change mode on the image block. More specifically, a change mode determining section 151 outputs data d8 representing the template number corresponding to the pixel value change mode on the image block as the first feature amount of the input vector data I on the basis of vector data information stored in a feature template storage section 152 in which typical vector data of pixel value change modes are collected.

Each of a code book storage section 81 for storing template vector data and a feature amount storage section 82 for storing the sums of elements of vector data as the second feature amounts of the template vector data stores data arranged for each type of first feature amount. In the example shown in Fig. 37, since the first feature amount of the input vector data I is determined as "2", only a portion 153 corresponding to the first feature amount "2" is selected from the code book storage section 81 and feature amount storage section 82, and the remaining portions fall outside the search range.

For only the portion 153 corresponding to the first feature amount "2" in the code book storage section 81 and feature amount storage section 82, template vector data is searched for according to the same procedure as in the 12th embodiment. More specifically, the second feature amount of the input vector data I is calculated by a feature amount calculating section 85. Using a result d4 and a feature amount d5 in the feature amount storage section 82, a feature amount difference calculating section 86 and calculation omission determining section 87 determine particular template vector data corresponding to the first feature amount "2" in the code book storage section 81, for which Manhattan distance calculation is unnecessary.

As described above, according to the 14th embodiment, the calculation amount can be further omitted, as compared to the 12th embodiment in which a single feature amount is used. This is because template vector data as search targets are limited in advance using the first feature amount, and the search targets are further narrowed down using the second feature amount. This allows omission of more calculations, as compared to a case wherein only one feature amount is used, and calculation can be performed at a higher speed.

When the template vector data are two-dimensionally arrayed not only in accordance with the first feature amount but also in the descending order of magnitudes of the second feature amounts, search can be started from template vector data whose second feature amount is similar to that of the input vector data I. Hence, template vector data similar to the input vector data I can be more efficiently searched for.

In the example shown in Fig. 37, the image block size is $4 \times 4$ pixels, i.e., the image block is represented by 16-dimensional vector data. However, this size is arbitrary.

(15th Embodiment)

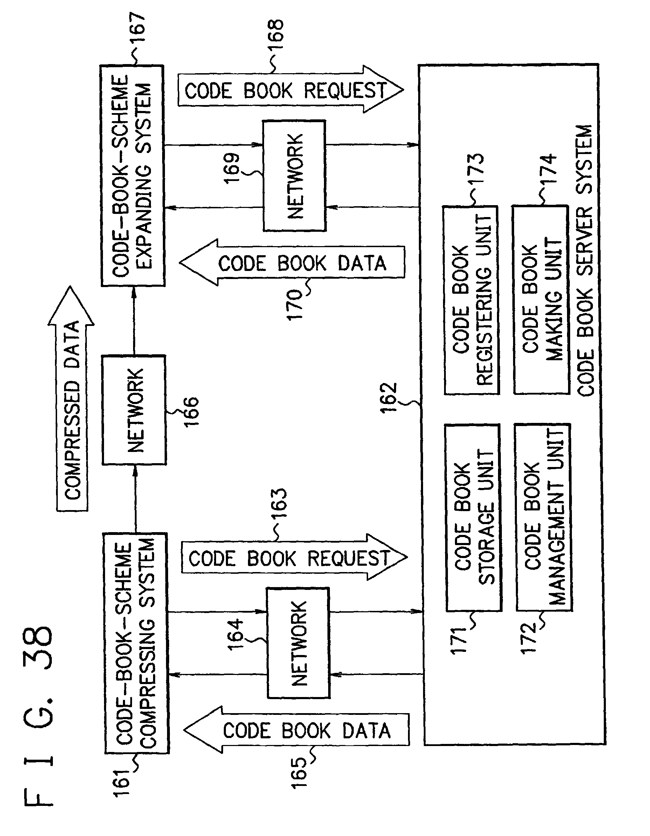

Fig. 38 is a block diagram showing the construction of a data compressing/expanding system according to the 15th embodiment. According to this embodiment, in a data compressing/expanding system using vector quantization, a system for holding a code book used for data compression/expansion is independently prepared.

Referring to Fig. 38, a code-book-scheme compressing system 161 is a device for comprising externally input or stored data using the code book scheme. A code book server system 162 comprises a code book storage unit 171, code book management unit 172, code book registering unit 173, and code book making unit 174 and has a function of transferring a code book in response to a request from the compressing/expanding system.

As a code book used in the data compression process in the code-book-scheme compressing system 161, a code book 165 transferred from the code book server 162 through a network 164 is used. For the type of necessary code book, a code book request 163 is transmitted to the code book server 162 through the network 164.

The code book server 162 executes the following operation as a response to the code book request 163. More specifically, the code book management unit 172 searches for the data of a code book matching the request from the code books stored in the code book storage unit 171 and transmits the data to the code-book-scheme compressing system 161 through the network 164. Note that in the code book storage unit 171, several code books are registered and stored in advance by the code book registering unit 173.

If the code book storage unit 171 has no code book matching the request, the code book making unit 174 makes a code book matching the request from the most similar code book. At this time, a code book can be made on the basis of a code book stored in the code book storage unit 171, or a new code book may be made.

Compressed data generated by the code-book-scheme compressing system 161 using the code book 165 transferred in the above way is transmitted to a code-book-scheme expanding system 167 through a network 166.

As a code book used in the data expansion process in the code-book-scheme expanding system 167, a code book 170 transferred from the code book server 162 is used. For the type of necessary code book, a code book request 168 is transmitted to the code book server 162 through a network 169.

For the contents requested by the code-book-scheme expanding system 167, the request contents generated by the code-book-scheme compressing system 161 can be received together with the compressed data and used. Alternatively, the request contents may be uniquely generated by the code-book-scheme expanding system 167. Different code books can be used on the compressing and expanding sides.

The code book server 162 executes the following operation as a response to the code book request 168. More specifically, the code book management unit 172 searches for the data of a code book matching the request from the code books stored in the code book storage unit 171 and transmits the data to the code-book-scheme expanding system 167 through the network 169.

If no code book matching the request is present, the code book making unit 174 makes a code book matching the request from the most similar code book. At this time, a code book can be made on the basis of a code book stored in the code book storage unit 171, or a new code book may be made.

As described above, in this embodiment, the code book server 162 for holding code books used for data compression/expansion by vector quantization is independently prepared. In addition, the code book server 162, data compressing system 161 (data transmitting side), and data expanding system 167 (data receiving side) are connected to each other through networks represented by analog telephone lines, digital lines, Internet dedicated lines, and communication lines.

When a code book dispersion request is supplied from each of the data compressing system 161 and data expanding system 167 to the code book server 162, the code book server 162 instantaneously transmits a code book through the network.

With this construction, each of the data compressing and expanding systems need not hold any code book, and when the code book is updated, data in the code book server 162 only need be updated, so a very simple data transfer system can be implemented. In addition, the latest code book can always be received from the code book server 162, and a high data quality can be maintained.

(16th embodiment)

In the 16th embodiment, an application example of the above-described embodiments in which after vector quantization in frame (space direction vector quantization) is executed in units of frames, the obtained code numbers are rearranged, and vector quantization between frames (time-axis vector quantization) is executed will be described below.

In the above-described second to seventh embodiments, code numbers after space direction vector quantization are extracted from each frame one by one and rearranged in the order of frame images, thereby generating a new vector (time-axis vector). To the contrary, in the 16th embodiment, the number of code numbers to be extracted from one frame is not one, and instead, code numbers are extracted from each frame to generate a new time-axis vector.

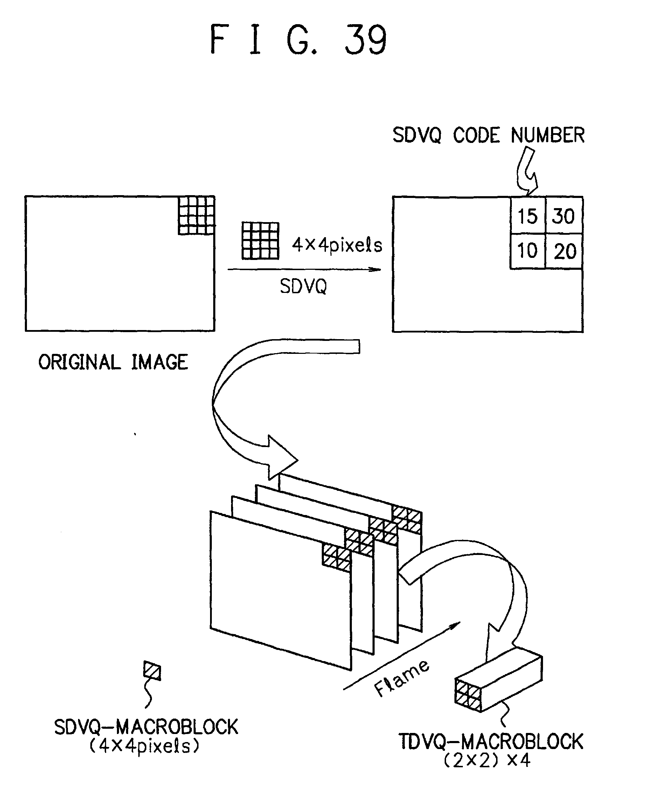

Fig. 39 is a data flow chart for explaining a space direction code number reconstruction method according to this embodiment. As shown in Fig. 39, each frame of an original image is subjected to space direction vector quantization (SDVQ) processing in units of macroblocks each having $4 \times 4$ pixels, and each macroblock is replaced with a code number corresponding to a space direction code vector. In the example shown in Fig. 39, the macroblock at the right corner of a certain frame is replaced with code number "30", and three macroblocks around the macroblock are replaced with code numbers "15", "10", and "20", respectively.

When such space direction vector quantization processing is performed for each frame (four frames in the example shown in Fig. 39), code numbers of blocks represented by the same address are extracted, from each frame image which is expressed by the code numbers in the space direction code book, in units of $2 \times 2$, e.g., four blocks and rearranged in the order of frame images. Thus, the code numbers of four blocks having the same address, which are dispersed in the time-axis direction, are expressed together as one time-axis vector data string, i.e., one macroblock for time-axis direction vector quantization (TDVQ).

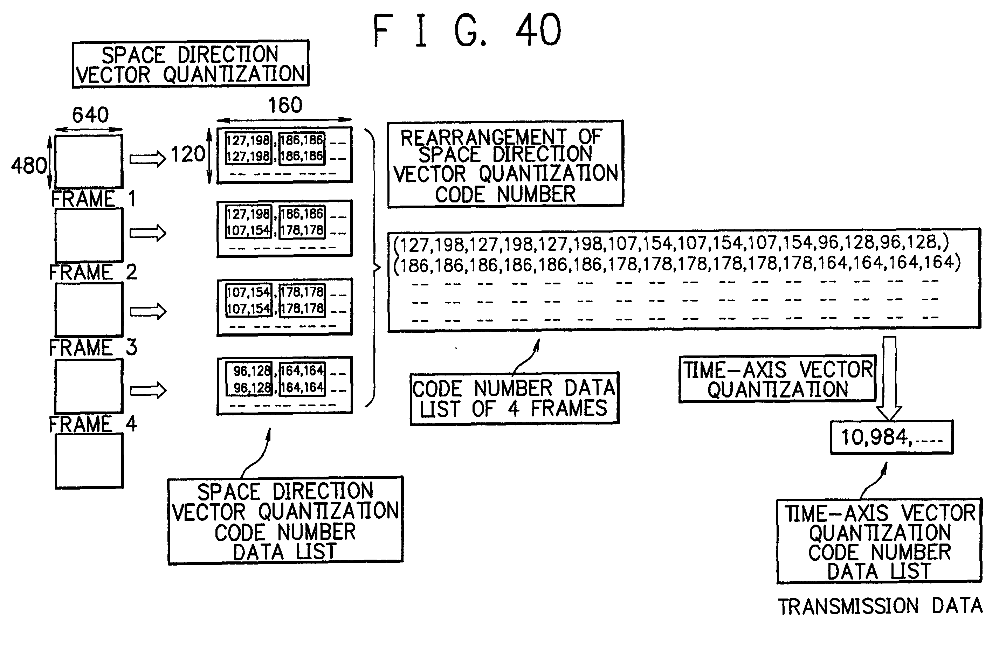

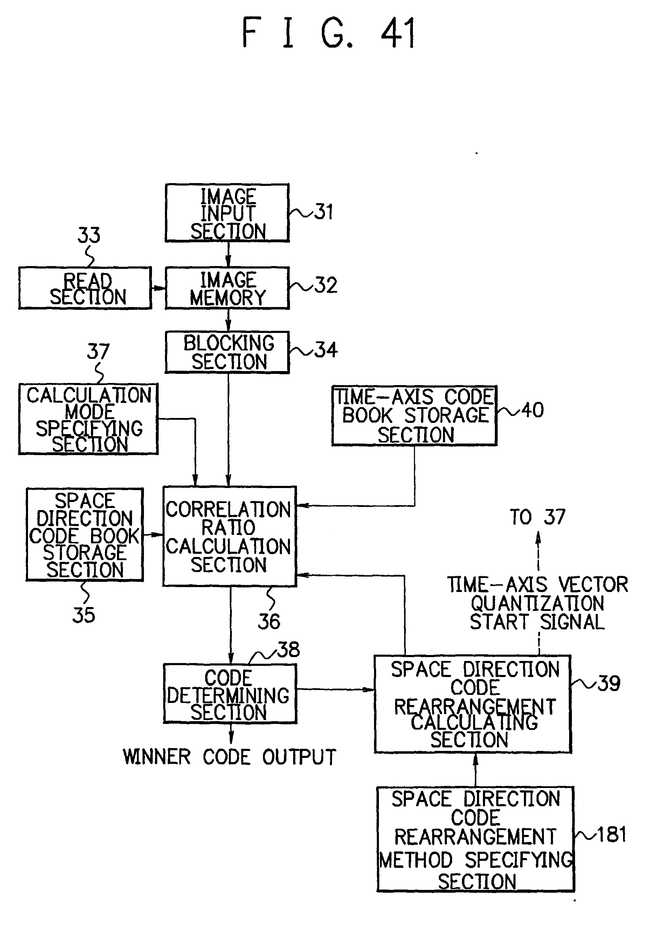

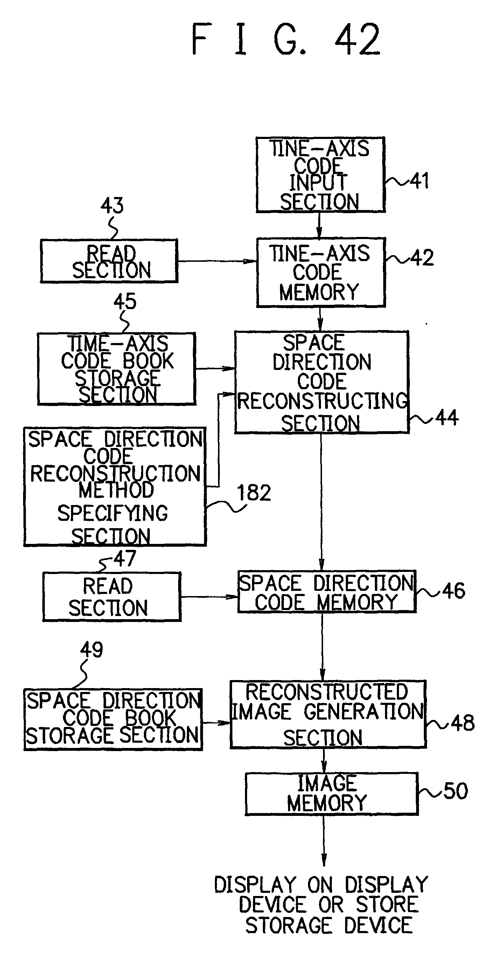

Fig. 40 is a data flow chart showing the flow of data in compression when the space direction code number reconstruction manner according to this embodiment is applied to the above-described second embodiment. Figs. 41 and 42 are block diagrams showing the constructions of data compressing and expanding system in that case. Fig. 40 is the same as in the second embodiment shown in Fig. 11 except the number of frames as compression targets is four, and the code number reconstruction manner is different, and a detailed description thereof will be omitted.

Referring to Fig. 41, in the data compressing system of this embodiment, a space direction code reconstruction method specifying section 181 is added to the data compressing system according to the second embodiment shown in Fig. 9. Referring to Fig. 42, in the data expanding system of this embodiment, a space direction code rearrangement method specifying section 182 is added to the data expanding system of the second embodiment shown in Fig. 10.

The space direction code reconstruction method specifying section 181 specifies whether one code number is to be extracted from one frame, or four code numbers are to be extracted from each frame in rearranging space direction code numbers to generate a new time-axis vector. In other words, the space direction code reconstruction method specifying section 181 specifies whether the series of processing operations of vector quantization are to be executed in accordance with the flow shown in Fig. 11 or the flow shown in Fig. 40.

Conversely, the space direction code rearrangement method specifying section 182 specifies whether one code number is to be extracted in according with one time-axis code number, or four code vectors are to be extracted in extracting a code vector corresponding to a time-axis code number from a time-axis code book. To specify this, a corresponding rearrangement method is specified in accordance with which reconstruction method is specified by the space direction code reconstruction method specifying section 181.

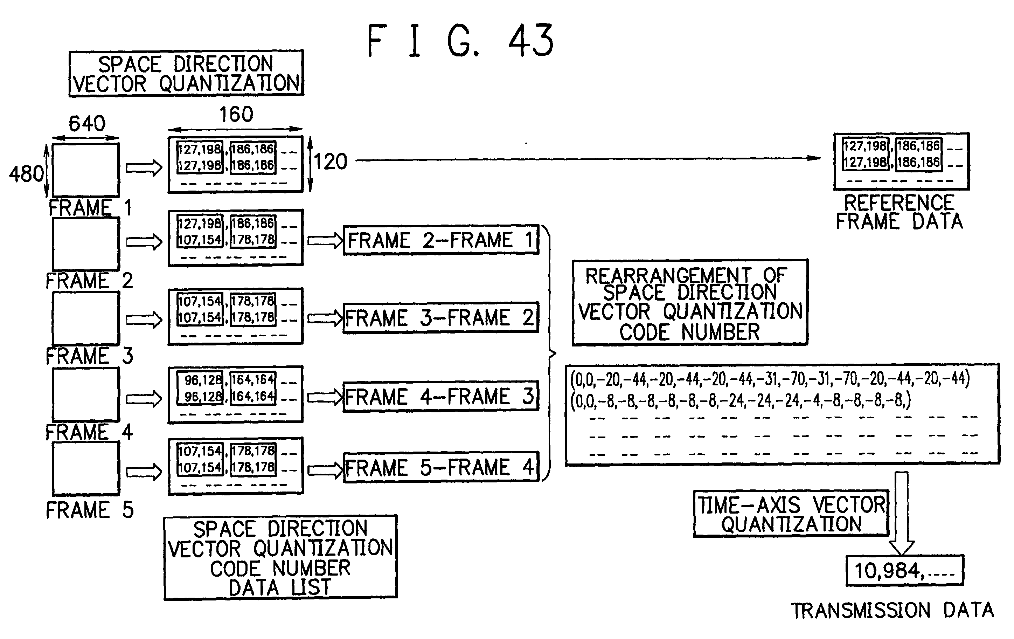

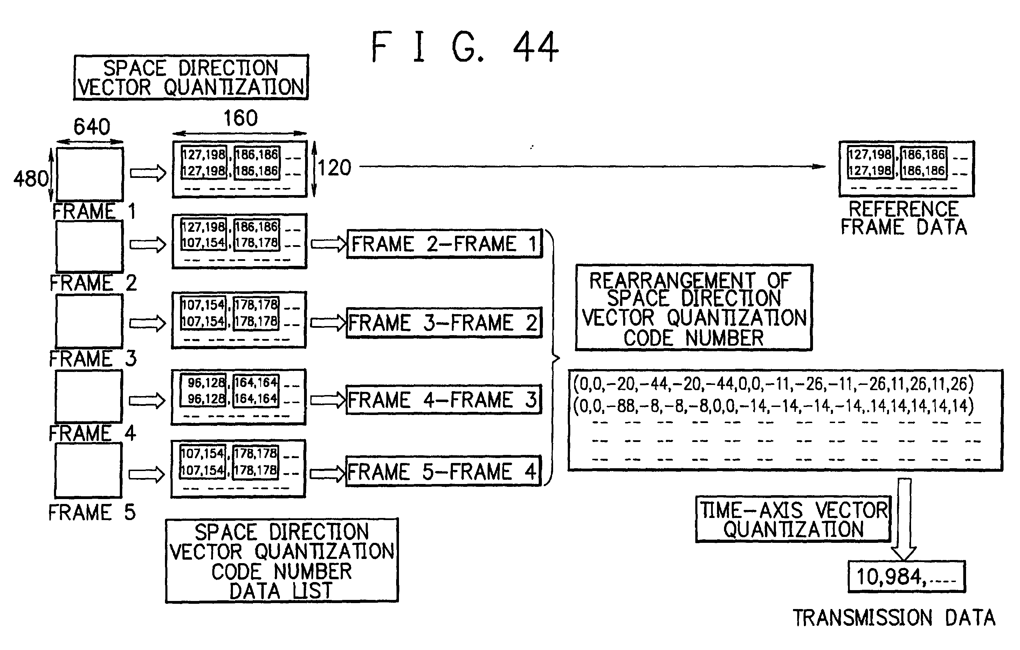

Figs. 43 and 44 are data flow charts showing the flow of data in compression when the space direction code number reconstruction manner according to this embodiment is applied to the third and fourth embodiments. Figs. 43 and 44 are the same as in the third and fourth embodiments shown in Figs. 12 and 13 except the number of frames as compression targets is five, and the code number reconstruction manner is different, and a detailed description thereof will be omitted.

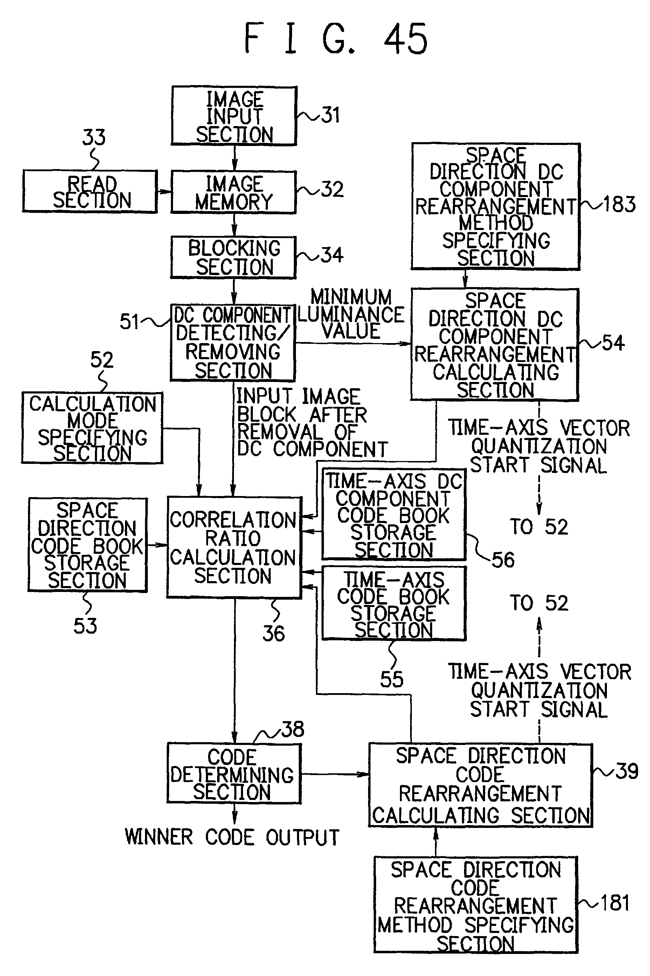

Fig. 45 is a block diagram showing the construction of a data compressing system when the space direction code number reconstruction manner of the 16th embodiment is applied to the above-described seventh embodiment. Referring to Fig. 45, in the data compressing system of this embodiment, the space direction code reconstruction method specifying section 181 and space direction DC component reconstruction method specifying section 183 are added to the data compressing system of the seventh embodiment shown in Fig. 15.

The space direction code reconstruction method specifying section 181 is the same as in Fig. 41. The space direction DC component reconstruction method specifying section 183 specifies, for each frame image expressed by only the minimum luminance value of each block, whether one DC component is to be extracted from one frame, or four DC components are to be extracted from each frame in rearranging the data values of blocks represented by the same address in the order of frame images to generate a new time-axis vector.

As described above, in the 16th embodiment, space direction code numbers or DC components are rearranged by a specified method, and a new time-axis vector can be generated by extracting code numbers or DC components from each frame. This allows time-axis vector quantization in units of blocks which are put together in the space direction to some extent. Hence, the quality of a reconstructed image can be further improved while maintaining a high compression ratio.

In the above example, four space direction code numbers are extracted from each of the four frames in units of $2 \times 2$ blocks to generate one macroblock of a time-axis vector. However, nine code numbers may be extracted from each of the four frames in units of $3 \times 3$ blocks. Additionally, the manner the space direction code number macroblocks are extracted or the number of frames as compression targets can be arbitrarily set.

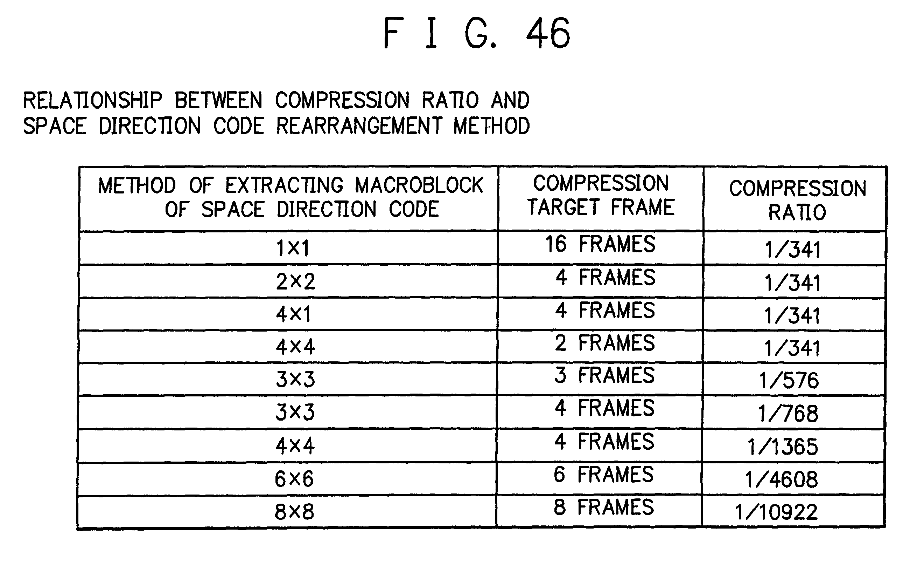

Fig. 46 is a table showing the relationships between compression ratios and space direction code number reconstruction methods set in various ways. As is apparent from Fig. 46, setting on the lower side of the table shown in Fig. 46 can achieve a higher compression ratio.

(17th Embodiment)

The 17th embodiment of the present invention will be described next. In the 17th embodiment, the above-described eighth embodiment is further improved.

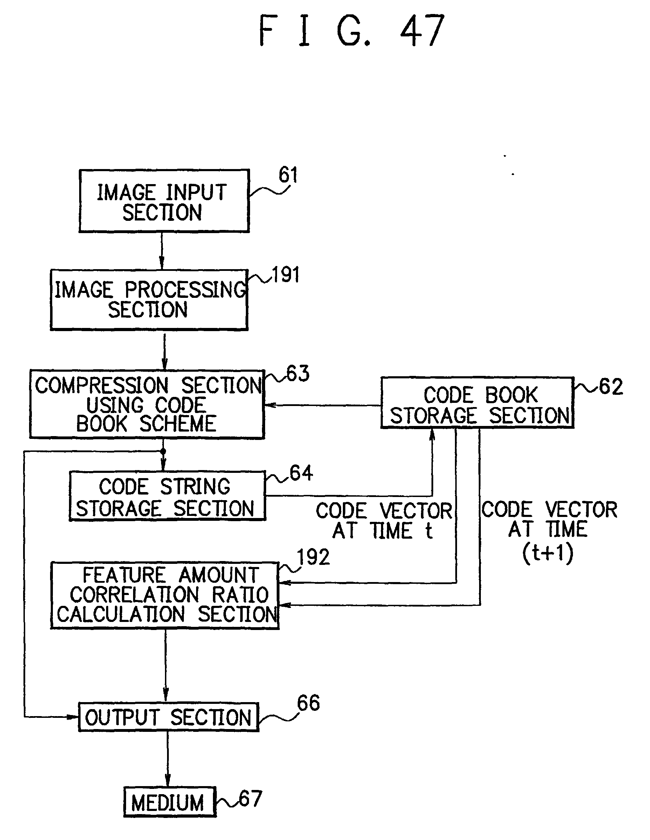

Fig. 47 is a block diagram showing the construction of a data compressing system according to this embodiment. The same reference numerals as in Fig. 17 as the eighth embodiment denote the same blocks in Fig. 47.

Referring to Fig. 47, an image input section 61 is a unit for continuously receiving images. In this case, for example, 30 images each having $640 \times 480$ pixels each having 8-bit RGB grayscale are received per sec. An image processing section 191 converts the RGB image signals received from the image input section 61 into image signals each formed from a luminance signal (Y signal) and chrominance signals (U and V signals). With this processing, the information amount can be more efficiently decreased by vector quantization later. Although the description of the eighth embodiment shown in Fig. 17 does not mention such processing, similar processing can be performed.

In a code book storage section 62, a number of pattern images (code vectors) each formed from, e.g., a $4 \times 4$ pixel block are registered. Each block is assigned a unique code number. These code vectors are arranged in the descending order of, e.g., the magnitudes of feature amounts to be described later (to be referred to as ascending order hereinafter, which starts from, e.g., address 0 representing a code vector having a minimum feature amount).

A compression section 63 using the code book scheme executes space direction vector quantization processing described in the eighth embodiment for each image obtained by the image processing section 191. More specifically, for each macroblock included in the original image, a code vector whose pattern is most similar to the macroblock is selected from a number of code vectors registered in the code book storage section 62, and a code number corresponding to the code vector is output. In processing an image having $640 \times 480$ pixels, 19,200 blocks are extracted and processed, and therefore, the number of code numbers output is also 19,200.

A code string storage section 64 stores a code number string output by processing a frame image at time t by the compression section 63 using the code book scheme. A feature amount correlation ratio calculation section 192 calculates the feature amounts (e.g., average values) of the code vector read out from the code book storage section 62 on the basis of the code number string of the image at the time t (previous frame), which is stored in the code string storage section 64, and the code vector selected as a code vector having the most similar as a result of space direction vector quantization for an image at the next time (t + 1) (current frame), and calculates the correlation ratio in feature amount of code vector between the macroblocks represented by the same address.

An output section 66 determines data to be output to a medium 67 (a communication channel such as a network or a recording medium) on the basis of the correlation value of the feature amount, which is supplied from the feature amount correlation ratio calculation section 192. More specifically, when the correlation value of the feature amount obtained for the address of a certain macroblock is smaller than a predetermined threshold value, the address and a corresponding code number in the current frame, which is supplied from the compression section 63 using the code book scheme, are output to the medium 67. On the other hand, when the correlation value obtained for the address of the given macroblock is larger than a predetermined threshold value, the address and a corresponding code number are not output to the medium 67 (nothing is output). In this case, the expanding side uses the image reconstructed in the previous frame for the macroblock, as described in the eighth embodiment.

In this case, of macroblocks between adjacent frames at the same position in the time-axis direction, for a macroblock having small correlation between the frames, the address and code number are defined as transmission data, and for a macroblock having large correlation, nothing is transmitted. However, the format of transmission data is not limited to this example.

For example, for a position where correlation is smaller relative to the previous frame, "1" is set at the start and transmitted, followed by a code number. On the other hand, for a position where correlation is large, only "0" can be set and transmitted. In this construction, the expanding side can identify a block for which a code number is sent and a block for which nothing is sent by checking whether the value at the start of transmission data sent for each macroblock is "1" or "0".

Alternatively, for a position where correlation is smaller relative to the previous frame, only the code number may be defined as transmission data. On the other hand, for a position where correlation is large, only "0" may be defined as transmission data. In this construction, the expanding side can identify a block for which a code number is sent and a block for which nothing is sent by checking whether the value at the start of transmission data sent for each macroblock is "0".

In all of the above-described three patterns of transmission data formats, Huffman coding or run-length coding can be executed for the transmission data generated in accordance with the correlation ratio. This further compresses the information amount.

As described above, in this embodiment, space direction vector quantization processing is performed for each of frame images. Between macroblocks in adjacent frames at the same position in the time-axis direction, the feature amounts of selected code numbers are compared. If the correlation is large, the code number sent for the previous frame is directly used in the current frame. Hence, in addition to the result of space direction vector quantization in each frame, the data can also be compressed in the frame direction (time-axis), so moving picture data can be compressed at a higher compression ratio than that for still image VQ compression.

In this embodiment, a feature amount correlation value is compared with a predetermined threshold value by the output section 66. However, the threshold value may be changed between frames on the basis of a certain function or the like. With this construction, for example, by changing the threshold value in accordance with large motion in a moving picture, the compression ratio can be dynamically changed in accordance with the motion in the image.

In the above embodiment, the code string of the previous frame is stored in the code string storage section 64. However, the code vector selected in the previous frame may be stored. In this case, the code vector in the previous frame before comparison with the code vector in the current frame by the feature amount correlation ratio calculation section 192 can be directly read out from the storage section.

In the above embodiment, the feature amount of a code vector to be compared is obtained by calculation in the compression operation. However, each code vector and a feature amount corresponding to the code vector may be stored in the code book storage section 62 in advance. In this case, feature amount calculation processing in the compression operation can be omitted, and the data compression processing speed can be increased.

(18th Embodiment)

The 18th embodiment of the present invention will be described next. In the 18th embodiment, the above-described 17th embodiment is further improved.

In the 17th embodiment, the quality of a reconstructed image may degrade as the time elapses because data in the previous frame is directly used when the correlation of the feature amount of a code vector is large. For example, for a certain macroblock, a state wherein the correlation value of the feature amount of the code vector slightly exceeds the threshold value continues across several frames, the image quality inevitably degrades. In addition, such situation can hardly be predicted.

In this embodiment, to make such degradation in image quality unnoticeable, an output section 66 in the data compressing system shown in Fig. 47 further has a "data updating" function of transmitting the data in the current frame independently of the correlation value of the feature amount. Whether the data is to be updated or which data portion in the frame is to be updated is determined by a feature amount correlation ratio calculation section 192. As the data updating method of this embodiment, the following three methods are available.

As the first method, the code strings of all macroblocks, which are obtained by a code-book-scheme compression section 63 for frames, are output to a medium 67 as updated data, e.g., once for several frames regardless of whether the feature amount correlation value of a corresponding code vector is larger than the threshold value. After updated data is output for a certain frame, space direction and time-axis direction compression are executed again using the updated data as a new key frame. With this processing, even when the data in the previous frame is directly and continuously used, this state can always be broken by transmission of updated data, and degradation in image quality along with the elapse of time can be suppressed.

In the first method, however, in a frame where the updated data is transmitted, only space direction vector quantization is executed by the code-book-scheme compression section 63, and time-axis direction compression is not executed on the basis of the magnitude of correlation value, so the transmission data amount is maximized (compression ratio of normal still image compression). To avoid this, in the second data updating method, instead of using all data in a frame as updated data, the data is updated in units of predetermined blocks.

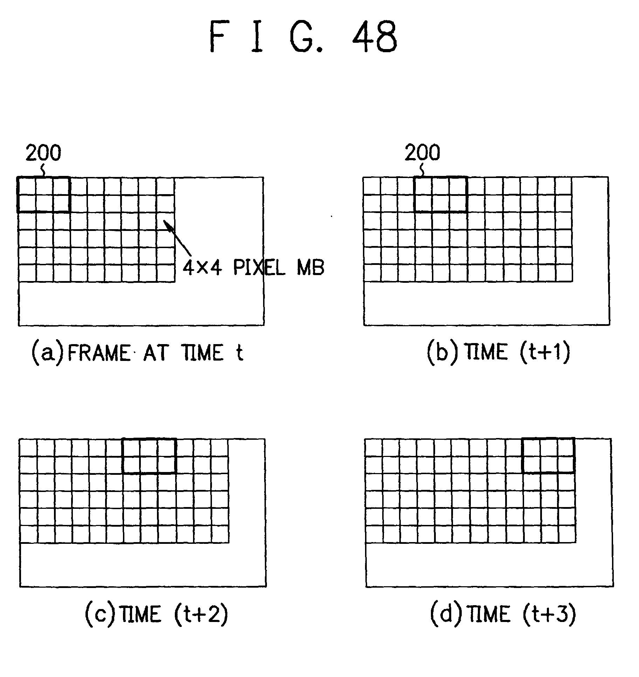

Fig. 48 shows illustrations for explaining the second data updating method. Figs. 48(a) to 48(d) show frames at times t to (t + 3). Small blocks in each frame are macroblocks each formed from $4 \times 4$ pixels. In this embodiment, the above-described data updating is performed using, as a unit, for example, a larger block 200 formed from macroblocks (two macroblocks in the vertical direction × three macroblocks in the horizontal direction in the example shown in Fig. 48), as indicated by the thick frame in Fig. 48.

More specifically, in the frame at time t shown in Fig. 48(a), in the block 200 at the upper left corner of the frame, the code string output from the code-book-scheme compression section 63 is output to the medium 67 without threshold value processing of the feature amount correlation value. On the other hand, in the region outside the block 200, threshold value processing of the feature amount correlation value is performed by the feature amount correlation ratio calculation section 192 and output section 66, and a code is output to the medium 67 for only a macroblock whose feature amount correlation value is smaller than the threshold value, as described in the 17th embodiment.

In the next frame at time (t + 1) shown in Fig. 48(b), the position of the block 200 for data updating is horizontally shifted by one block. In the shifted block 200, the code string output from the code-book-scheme compression section 63 is output to the medium 67 without threshold value processing of the feature amount correlation value. On the other hand, in the region outside the block 200, threshold value processing of the feature amount correlation value is performed, and a code is output to the medium 67 for only a macroblock whose feature amount correlation value is smaller than the threshold value.

In a similar manner, processing is executed while shifting the position of the block 200, as shown in Figs. 48(c) and 48(d). When the position of the block 200 reaches the lower right corner of the frame, processing is repeated after returning to the state shown in Fig. 48(a).

When data update processing is sequentially performed using the block 200 formed from macroblocks as a unit, the state wherein the data in the previous frame is continuously used can be broken by transmitting updated data using the block 200 as a unit. Hence, degradation in image quality along with the elapse of time can be suppressed. In addition, in the region outside the block 200, since not only the space direction vector quantization but also time-axis direction compression is performed, a high compression ratio can be ensured.

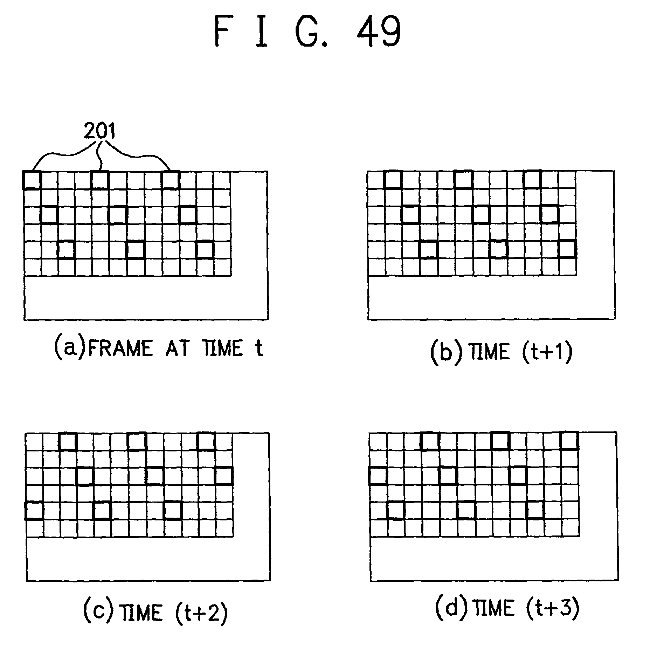

As the third method of data updating, the data is updated for macroblocks 201 discretely present in one frame, as indicated by the thick frame in Fig. 49, and the discrete positions of data updating are changed as the time elapses (every time processing shifts to the next frame) . In the above-described second method, the difference in image quality may be perceivable between the block 200 for data updating and the region outside the block 200. However, the third method has an advantage that such difference becomes unnoticeable.

In the second and third methods of this embodiment, the block 200 or 201 for data updating is prepared in units of frames. However, it may be prepared for each of several frames.

Additionally, this embodiment has been described as an improvement of the 17th embodiment. However, the above-described data update processing can also be applied to the eighth embodiment.

(19th Embodiment)

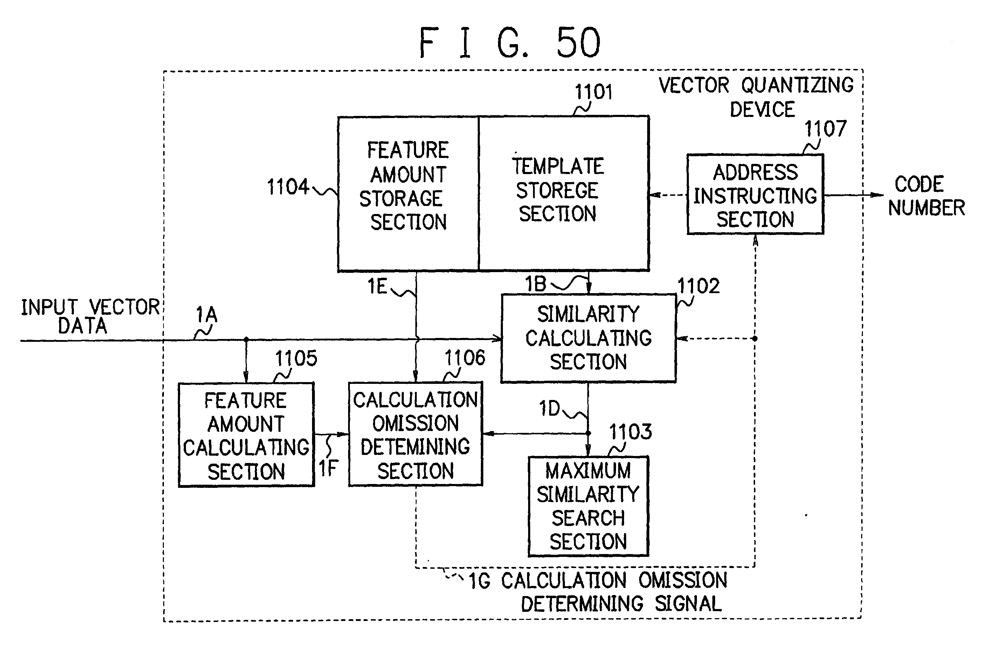

Fig. 50 is a block diagram showing the construction of a vector quantizing device according to an embodiment of the present invention. Referring to Fig. 50, reference numeral 1101 denotes a template storage section for storing units of template vector data; and 1102, a similarity calculating section for calculating and outputting similarity which expresses, as a numerical value, the degree of similarity between input vector data 1a and template vector data 1b in the template storage section 1101.

A maximum similarity search section 1103 determines template vector data having the largest similarity to the input vector data 1a on the basis of similarity 1d calculated by the similarity calculating section 1102 for the template vector data. An address instructing section 1107 instructs a read address of template vector data in the template storage section 1101. This address instructing section 1107 outputs an address corresponding to the template vector data having the maximum similarity as the code number for the input vector data 1a.

In this embodiment, the following functional blocks are newly added to the vector quantizing device having the above construction: a feature amount storage section 1104, feature amount calculating section 1105, and calculation omission determining section 1106.

The feature amount storage section 1104 stores the feature amount of each template vector data in the template storage section 1101. The feature amount calculating section 1105 calculates the feature amount of the input vector data 1a.

The calculation omission determining section 1106 determines whether given template vector data is a search target and in other words whether the similarity between the given template vector data and the input vector data need be calculated, using a feature amount 1e related to the template vector data read out from the feature amount storage section 1104, a feature amount 1f related to the input vector data, which is obtained by the feature amount calculating section 1105, and the similarity 1d obtained by the similarity calculating section 1102 as needed.

The calculation omission determining section 1106 outputs a calculation omission determining signal 1g to the similarity calculating section 1102 and address instructing section 1107, thereby controlling whether similarity calculation is to be executed in units of template vector data. For example, when it is determined that similarity calculation can be omitted for certain template vector data, the read of template vector data at that address is skipped, and similarity calculation is omitted.

In this embodiment, according to the above construction, for example, the feature amount of input vector data and that of template vector data are compared before calculation of the similarity of the template vector data, and it is determined on the basis of the comparison result whether similarity calculation is to be executed for the template vector data. Thus, the amount of similarity calculation executed by the vector quantizing device can be decreased, and the amount of calculation necessary for search can be decreased.

In the description of the above embodiment, operation of searching for template vector data having the maximum similarity, i.e., most similar to the input vector data is performed. For this purpose, the maximum similarity search section 1103 is provided. However, the present invention is not limited to searching template vector data having the maximum similarity and can also be applied to searching template vector data having similarity which becomes large to a degree that poses no practical problem. This can be easily implemented by modifying the operation of the maximum similarity search section 1103.

The feature amount related to template vector data, which is stored in the feature amount storage section 1104, may be obtained by calculation in advance before execution of search. Alternatively, when both calculation for determination by the calculation omission determining section 1106 and calculation of the feature amount of input vector data by the feature amount calculating section 1105 can be executed in a smaller calculation amount as compared to similarity calculation, the total calculation amount can be reduced even when the feature amount is calculated in searching.

Each portion of the vector quantizing device shown in Fig. 50 can be implemented by dedicated hardware or a computer which runs in accordance with a program for executing the above-described processing.

(20th Embodiment)

As the 20th embodiment, an construction in which the vector quantizing device shown in Fig. 50 is practiced in more detail may be employed, as in the above-described 12th embodiment (Figs. 28 and 29). More specifically, the vector quantizing device can have an construction which uses a Manhattan distance as a function for obtaining similarity that expresses as a numerical value whether two input vectors are similar, and the sum of elements of vector data as a feature amount. Its principle and procedures have already been described above in detail, and a detailed description thereof will be omitted here.

(21st Embodiment)

As the 21st embodiment, image data may be used as the input to the vector quantizing device of the 20th embodiment, and the vector quantizing device may be applied to an data compressing device, as in the above-described 13th embodiment (Figs. 30 and 31). This has already been described in detail, and a detailed description thereof will be omitted here.

(22nd Embodiment)

As the 22nd embodiment, when image data is used to the input to the vector quantizing device of the 20th embodiment, a characteristic unique to the image can be used as the feature amount of vector data, as in the above-described 14th embodiment (Figs. 32 to 37) . This has already been described in detail, and a detailed description thereof will be omitted here.

(23rd Embodiment)

The 23rd embodiment of the present invention will be described next. In the 23rd embodiment, a method of segmenting one vector data into several parts and decreasing the calculation amount related to search of template vector data using the feature amount of each segmented part will be described.

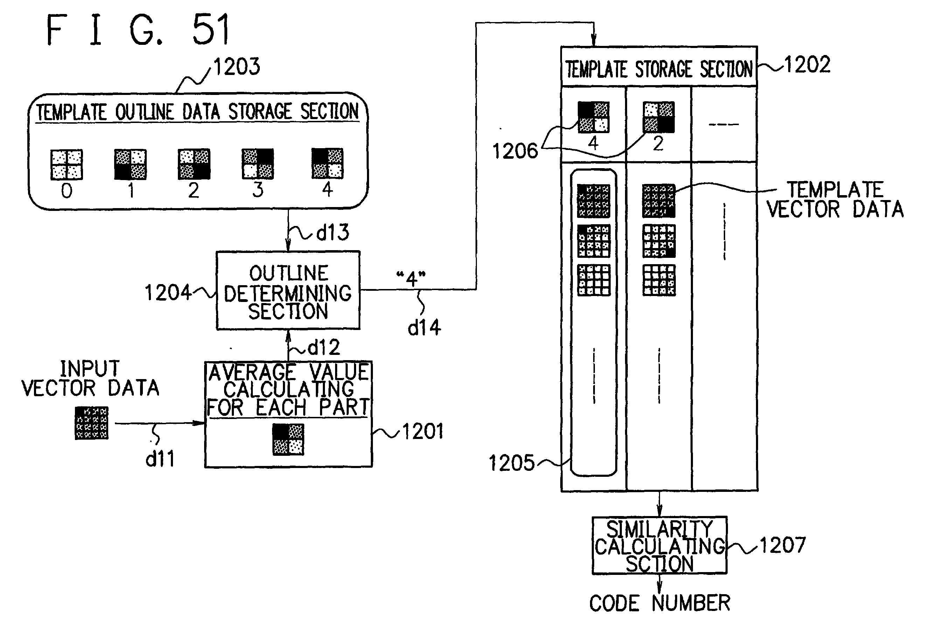

Fig. 51 is a block diagram showing the construction of a vector quantizing device according to the 23rd embodiment. Fig. 51 explains a method in which an image block formed from $4 \times 4$ pixels is used as 16-dimensional input vector data, this input vector data is segmented into four 4-dimensional vectors, the feature amount of each vector is calculated, and the similarity calculation amount is decreased using these feature amounts. Referring to Fig. 51, each vector data is visually expressed in the form of an image block. In the example shown in Fig. 51, the average value of elements of vector data is used as a feature amount.

Referring to Fig. 51, an average value calculating section 1201 for each part segments input vector data d11 into four parts (blocks each having $2 \times 2$ pixels) and calculates the average value as the feature amount of each part.

Four feature amounts are calculated from one input vector data d11 and output as one feature amount vector data d12. Each of the four blocks visually expressed in the average value calculating section 1201 represents the feature amount in each of the four segmented regions.

On the other hand, for template vector data stored in a template storage section 1202, a feature amount is obtained in units of four segmented regions according to the same procedure as that for the input vector data to generate one feature amount vector data in advance. Feature amount vector data similar to each other are put together into a set, and template vector data are stored for each set. Additionally, each set is assigned a unique number. For example, a vertical column indicated by a frame 1205 corresponds to one set.

Furthermore, feature amount vector data 1206 that represents each set of template vector data is generated in units of sets and stored in the template storage section 1202. The feature amount vector data 1206 representing each set will be referred to as "template outline data" hereinafter. The template outline data 1206 is assigned the same number as that of the set. The template outline data 1206 and number are also stored in a template outline data storage section 1203.

The feature amount vector data d12 extracted from the input vector data d11 is input to an outline determining section 1204 together with each template outline data d13 from the template outline data storage section 1203. The outline determining section 1204 determines template outline data most similar to the feature amount vector data d12 of the input vector data d11 and outputs its number d14. Thus, only template vector data of a set corresponding to the output number d14 is read out from the template storage section 1202.

A similarity calculating section 1207 executes similarity calculation while defining only the set of template vector data corresponding to the number d14 output from the outline determining section 1204 as search targets. In the example shown in Fig. 51, number "4" is output from the outline determining section 1204, the similarity calculating section 1207 executes similarity calculation for only template vector data of the set 1205 corresponding to that number. This decreases the calculation amount related to search of template vector data.

In the above embodiment, the template outline data 1206 is stored in the template storage section 1202 together. However, when the set of template vector data corresponding to the input number d14 can be identified, the template outline data 1206 need not always be stored.

In the above embodiment, the input vector data has a size of $4 \times 4$ pixels, and each segmented block has a size of $2 \times 2$ pixels. However, these are merely examples and are not limited.

(24th Embodiment)

The 24th embodiment of the present invention will be described next. In the above embodiments, although the number of template vector data as search targets can be reduced, all of them must be sequentially searched. To the contrary, in this embodiment, when a vector quantizing device is constructed by hardware, a mechanism for parallelly executing similarity calculation is used, thereby further increasing the calculation speed.

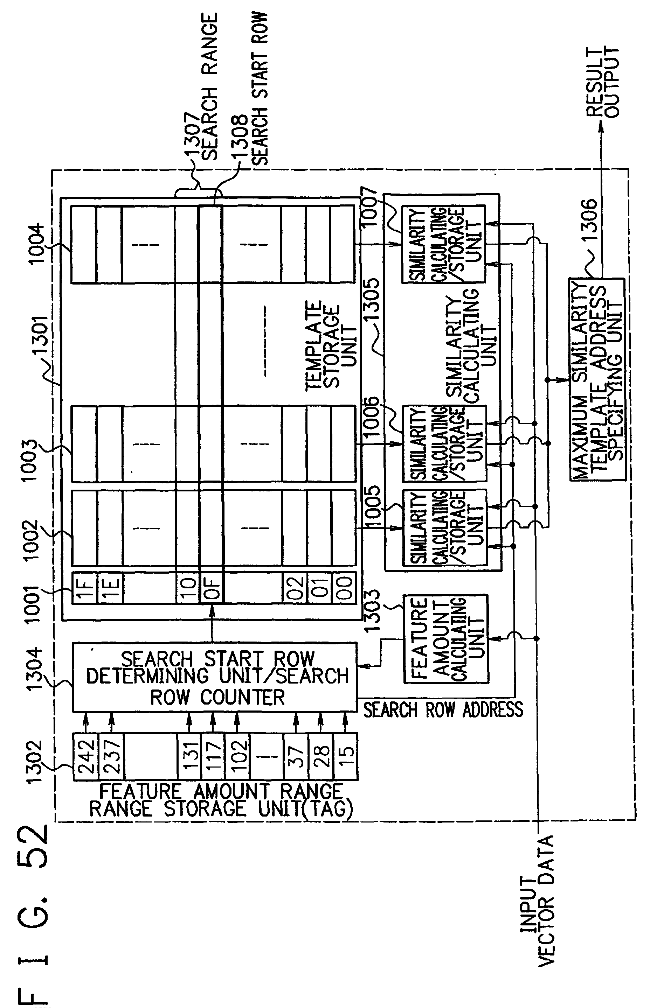

Fig. 52 is an illustration showing the hardware construction of a vector quantizing device according to this embodiment. Referring to Fig. 52, a template storage unit 1301 comprises memory sections 1002, 1003,..., 1004 and therefore has two-dimensional storage areas in each of which units of template vector data are stored. When a portion of an address section 1001 is designated, units of template vector data stored in the row (horizontal line) represented by the address are parallelly read out from the memory sections 1002, 1003,..., 1004.

In the template storage unit 1301, the units of template vector data are stored in ascending order of feature amounts (e.g., the average values of elements of vector data) from the lower left corner to the upper right corner of the drawing. For example, the feature amount of template vector data stored in the second row (address 01) is larger than that of template vector data stored in the first row (address 00).

Hence, units of template vector data having feature amounts relatively similar to each other are stored at the same row address. Template vector data having the same feature amount may be present across rows. A feature amount range storage unit 1302 stores the range of feature amounts of template vector data stored in a single row.

A feature amount calculating unit 1303 obtains the feature amount (average value of elements of vector data) of input vector data. A search start row determining unit/search row counter 1304 determines the search range of template vector data for which similarity calculation should be done, on the basis of the feature amount of input vector data, which is calculated by the feature amount calculating unit 1303, and the feature amount range stored in the feature amount range storage unit 1302.

More specifically, two vectors having approximate feature amounts tend to have large similarity (in other words, two vectors having dissimilar feature amounts tend to have small similarity). For this reason, when the range in the feature amount range storage unit 1302 to which the feature amount of the input vector data belongs is checked, which row in the template storage unit 1301 has template vector data having large similarity to the input vector data can be determined. Similarity calculation suffices for only that row.

The search start row determining unit/search row counter 1304 determines, as a search range 1307, one or rows in which template vector data having a feature amount relatively similar to the feature amount of the input vector data is stored, on the basis of calculated feature amount of the input vector data and the feature amount range in the feature amount range storage unit 1302, and sequentially increments the value of the search row counter from a search start row 1308.

With this processing, template vector data in the row designated by the search row address are parallelly read out from the memory sections 1002, 1003,..., 1004 and supplied to a similarity calculating unit 1305. The similarity calculating unit 1305 comprising similarity calculating/storage units 1005, 1006,..., 1007 in units of columns parallelly processes the units of template vector data read out from the memory sections 1002, 1003,..., 1004 and specifies the maximum similarity in each column and the row address that gives it.

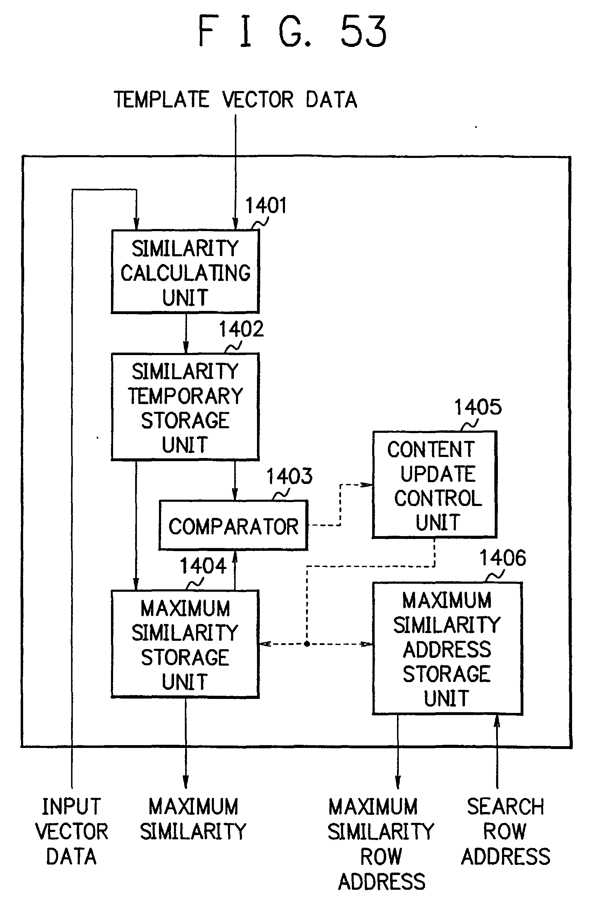

Each of the similarity calculating/storage units 1005, 1006,..., 1007 has, e.g., a construction shown in Fig. 53. Referring to Fig. 53, a similarity calculating unit 1401 sequentially calculates the similarity between the input vector data and each template vector data and stores the calculation results in a similarity temporary storage unit 1402 (the similarity temporary storage unit 1402 need not always be provided). A comparator 1403 compares similarity from the similarity temporary storage unit 1402 with the maximum similarity currently known, which is stored in a maximum similarity storage unit 1404, and determines which is larger.

If the similarity currently calculated and supplied from the similarity temporary storage unit 1402 is larger, a content update control unit 1405 is notified of it, and under its control, the contents of the maximum similarity storage unit 1404 are rewritten to the value of similarity currently calculated. Simultaneously, the content update control unit 1405 stores the search row address input from the search start row determining unit/search row counter 1304 at that time in a maximum similarity address storage unit 1406.

Values stored in the maximum similarity storage unit 1404 and maximum similarity address storage unit 1406 when similarity calculation between one input vector data I and all template vector data in the search range 1307 is ended are the similarity of template vector data most similar to the input vector data in each column of the search range 1307, and the row address that gives the similarity. These data are output to a maximum similarity template address specifying unit 1306 shown in Fig. 52.

On the basis of the maximum similarity in each column, which is output from each of the similarity calculating/storage units 1005, 1006,..., 1007 for columns, and the row address that gives the similarity, the maximum similarity template address specifying unit 1306 specifies the address of template vector data having the maximum similarity in the entire template storage unit 1301 and outputs it as a code number.

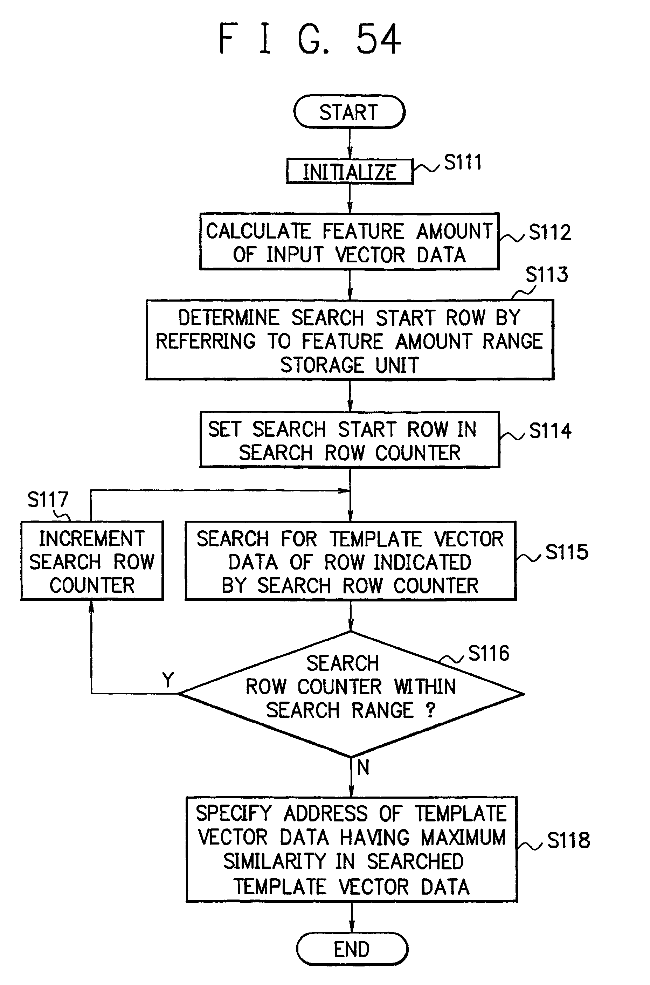

Fig. 54 is a flow chart showing the operation of the vector quantizing device having the constructions shown in Figs. 52 and 53. Referring to Fig. 54, first, in step S111, initialization processing is performed. In this case, contents stored in the similarity calculating unit 1401 and maximum similarity address storage unit 1406 provided in each of the similarity calculating/storage units 1005, 1006,..., 1007 are cleared.

In step S112, the feature amount of input vector data is calculated by the feature amount calculating unit 1303. In step S113, information in the feature amount range storage unit 1302 is referred to on the basis of the calculated feature amount of input vector data to specify a row in which template vector data having a feature amount most similar to the input vector data is stored. A predetermined offset is subtracted from the specified row, thereby determining the search start row 1308.

In step S114, the determined search start row 1308 is set in the search start row determining unit/search row counter 1304. The search row counter indicates the current search row (address). In step S115, for units of template vector data stored in the row indicated by the search row counter, the similarity calculating/storage units 1005, 1006,..., 1007 for columns parallelly calculate similarities, and update processing for the maximum similarity storage unit 1404 and maximum similarity address storage unit 1406 is appropriately executed in each column in accordance with the calculation result.

In step S116, it is determined whether the value of the search row counter still falls within the search range 1307. If YES in step S116, the flow advances to step S117 to increment the search row counter by one and then returns to step S115. On the other hand, when the search row counter reaches a predetermined value and falls outside the search range 1307, search processing is ended. At this stage, the maximum similarity storage unit 1404 of each column stores the maximum similarity value in that column, and the maximum similarity address storage unit 1406 of each column stores the row address at which template vector data that gives the maximum similarity in that column.

Finally, in step S118, the maximum similarity template address specifying unit 1306 determines on the basis of the similarity stored in the maximum similarity storage unit 1404 of each column which column has template vector data having the largest similarity to the input vector data, and specifies the column address. The maximum similarity template address specifying unit 1306 also generates the ultimate address in combining the row address stored in the maximum similarity address storage unit 1406 of the specified column.

As described above, according to this embodiment, since the range of search targets is narrowed down on the basis of the feature amounts extracted from vector data, the number of template vector data for which similarity calculation is to be done can be decreased, and the calculation time can be shortened. Also, in this embodiment, in constructing the vector quantizing device by hardware, a mechanism for parallelly processing similarity calculation is employed. Hence, the calculation time can be further shortened.

When the search range is limited to some rows in the template storage unit 1301, as described above, template vector data having the maximum similarity to the input vector data cannot always be selected. However, since search is executed in the range with similar feature amounts, template vector data which is apparently similar without any problem is selected, and application without any practical problem is possible.

(Other Embodiments)

Each of the functional blocks and processing procedures described in the above embodiments can be constructed by hardware or by a microcomputer system formed from a CPU or MPU, and ROM and RAM, and its operation can be implemented in accordance with an operation program stored in the ROM or RAM. The present invention also incorporates a case wherein, to realize the function of each of the above functional blocks, a software program for realizing the function is supplied to the RAM, and the functional block is made to operate in accordance with the program.

In this case, the software program itself realizes the functions of the above-described embodiments, and the program itself and a means for supplying the program to the computer, and for example, a recording medium that stores the program constitute the present invention. As a recording medium which stores the program, not only the ROM or RAM but also, e.g., a floppy disk, a hard disk, an optical disk, an optical magnetic disk, a CD-ROM, a CD-I, a CD-R, a CD-RW, a DVD, a zip, a magnetic tape, or a nonvolatile memory card can be used.

The functions of the above-described embodiments are realized not only when the computer executes the supplied program. Even when the functions of the above-described embodiments are realized by the program cooperating with the OS (Operating System) or another application software running on the computer, the program is incorporated in the embodiments of the present invention.

The present invention also incorporates a case wherein the supplied program is stored in the memory of the function expansion board of the computer or the function expansion unit connected to the computer, and then the CPU of the function expansion board or function expansion unit executes part or all of actual processing on the basis of instructions of the program to realize the functions of the above-described embodiments.

Industrial Applicability

The present invention is useful in realizing data compression at a high compression ratio in compressing image or voice data by vector quantization, and reconstructing high-quality data on the basis of the compressed data.

The present invention is also useful in realizing a high-performance, versatile code book compatible to various images.

The present invention is also useful in improving the processing speed in compression by vector quantization and image rearrangement by expansion.

The present invention is also useful in decreasing the amount of calculation for expressing the similarity between template vector data and input vector data as a numerical value in executing vector quantization, and realizing high-speed vector quantization processing at low power consumption.

**Claims**

1. A data compressing device which segments a data string including at least one unit of data into blocks forming vectors, searches a code book prepared in advance for a code vector similar to a vector extracted from a compression target, and outputs a code corresponding to the code vector, characterized in that

   the block forming the vector is a line block in which data positions are one-dimensionally arrayed.

2. A data compressing device which segments a data string including at least one unit of data into blocks forming vectors, searches a code book prepared in advance for a code vector similar to a vector extracted from a compression target, and outputs a code corresponding to the code vector, characterized by comprising:

   block shift means for extracting the block forming the vector of the compression target from the compression target while shifting a spatial position in a horizontal direction at least between blocks close to each other in a vertical direction.

3. A data compressing device according to claim 2, characterized in that the block forming the vector is a line block in which data positions are one-dimensionally arrayed.

4. A data expanding device which uses a data string including at least one unit of data as a vector, searches a code book having at least one code vector for a code vector corresponding to a compression code, and allocates the code vector to a corresponding block position to reconstruct original data, characterized by comprising:

block shift means for allocating the block constructing the code vector searched from the code book while shifting a spatial position in a horizontal direction at least between blocks close to each other in a vertical direction.

5. A data expanding device according to claim 4, characterized in that the block forming the vector is a line block in which data positions are one-dimensionally arrayed.

6. A data compressing/expanding system which segments a data string including at least one unit of data into blocks forming vectors, in data compression, searches a code book prepared in advance for a code vector similar to a vector extracted from a compression target and outputs a code corresponding to the code vector, and in data expansion, searches the code book for a code vector corresponding to the code and allocates the code vector to a corresponding block position to reconstruct original data, characterized by comprising at least one of:

first block shift means for, in the data compression, extracting the block forming the vector of the compression target from the compression target while shifting a spatial position in a horizontal direction at least between blocks close to each other in a vertical direction; and
second block shift means for, in the data expansion, allocating the block of the code vector searched from the code book while shifting the spatial position in the horizontal direction at least between the blocks close to each other in the vertical direction.

7. A data compressing/expanding system according to claim 6, characterized in that the block forming the vector is a line block in which data positions are one-dimensionally arrayed.

8. A data compressing/expanding system according to claim 66 or 7, characterized in that block shift by said first block shift means and block shift by said second block shift means have the same shift amount in opposite directions.

9. A data compressing device which segments a data string including at least one unit of data into blocks forming vectors, searches a code book prepared in advance for a code vector similar to a vector extracted from a compression target, and outputs a code corresponding to the code vector, characterized by comprising:

first vector quantizing means for, for data at each time in the compression target which changes along a time axis, extracting blocks from the data, searching a first code book for a code vector similar to the vector, and outputting a code string corresponding to the code vector at each time; and
second vector quantizing means for rearranging code strings output by said first vector quantizing means at respective times to generate new vectors, and for each of the new vectors, searching a second code book for a code vector similar to the vector, and outputting a code string corresponding to the code vector.

10. A data compressing device according to claim 9, characterized by further comprising code string rearrangement means for, of the code strings output from said first vector quantizing means at each time, combining codes at a corresponding address between units of data at each time to generate new vectors.

11. A data compressing device which segments a data string including at least one unit of data into blocks forming vectors, searches a code book prepared in advance for a code vector similar to a vector extracted from a compression target, and outputs a code corresponding to the code vector, characterized by comprising:

first vector quantizing means for, for data at each time in the compression target which changes along a time axis, extracting blocks from the data, searching a first code book for a code vector similar to the vector, and outputting a code string corresponding to the code vector at each time; and
second vector quantizing means for defining, as a reference code string, a code string of data at a certain time in the code strings output from said first vector quantizing means at respective times, rearranging difference results each calculated for codes at a corresponding address between the reference code string and a code string of data at another time so as to generate new vectors, and for each of the new vectors, searching a second code book for a code vector similar to the vector, and outputting a code string corresponding to the code vector.

**12.** A data compressing device according to claim 11, characterized by further comprising code string rearrangement means for, of the code strings output from said first vector quantizing means at each time, defining the code string of the data at the certain time as the reference code string, calculating a difference for the codes at the corresponding address between the reference code string and the code string of the data at another time, and combining the differences at the corresponding address to generate new vectors.

**13.** A data compressing device which segments a data string including at least one unit of data into blocks forming vectors, searches a code book prepared in advance for a code vector similar to a vector extracted from a compression target, and outputs a code corresponding to the code vector, characterized by comprising:

first vector quantizing means for, for data at each time in the compression target which changes along a time axis, extracting blocks from the data, searching a first code book for a code vector similar to the vector, and outputting a code string corresponding to the code vector at each time; and
second vector quantizing means for rearranging difference results each calculated for codes at a corresponding address in the code strings output from said first vector quantizing means at respective times between units of data adjacent in a time-axis direction so as to generate new vectors, and for each of the new vectors, searching a second code book for a code vector similar to the vector, and outputting a code string corresponding to the code vector.

**14.** A data compressing device according to claim 13, characterized by further comprising code string rearrangement means for, of the code strings output from said first vector quantizing means at each time, calculating a difference for the codes at the corresponding address between the units of data adjacent in the time-axis direction, and combining the differences at the corresponding address to generate new vectors.

**15.** A data expanding device which uses a data string including at least one unit of data as a vector, searches a code book having at least one code vector for a code vector corresponding to a compression code, and allocates the code vector to a corresponding block position to reconstruct original data, characterized by comprising:

second decoding means for searching the second code book for a code vector corresponding to a code string generated by said data compressing device of claim 9 or 10 and outputting the code vector; and
first decoding means for rearranging code strings each of which forms code vectors output from said second decoding means to generate new vectors, and for each of the new vectors, searching the first code book for a code vector corresponding to a code string which forms the new vector, and outputting the code vector.

**16.** A data expanding device which uses a data string including at least one unit of data as a vector, searches a code book having at least one code vector for a code vector corresponding to a compression code, and allocates the code vector to a corresponding block position to reconstruct original data, characterized by comprising:

second decoding means for searching the second code book for a code vector corresponding to a code string generated by said data compressing device of claim 11 or 12 and outputting the code vector; and
first decoding means for rearranging results of addition for codes at the corresponding address between a code string which forms code vectors output from said second decoding means and the reference code string to generate new vectors, and for each of the new vectors, searching the first code book for a code vector corresponding to a code string which forms the new vector, and outputting the code vector.

**17.** A data expanding device which uses a data string including at least one unit of data as a vector, searches a code book having at least one code vector for a code vector corresponding to a compression code, and allocates the code vector to a corresponding block position to reconstruct original data, characterized by comprising:

second decoding means for searching the second code book for a code vector corresponding to a code string generated by said data compressing device of claim 13 or 14 and outputting the code vector; and
first decoding means for, for the code string which forms code vectors output from said second decoding means, rearranging results of addition of codes in the order of addresses to generate new vectors, and for each of the new vectors, searching the first code book for a code vector corresponding to a code string which forms the new vector, and outputting the code vector.

**18.** A data compressing device according to any one of claims 9 to 14, characterized by further comprising time-axis shift means for, in generating the new vectors, arranging elements in the new vector while shifting the elements in the time-axis direction at least between vectors close to each other.

**19.** A data expanding device according to any one of claims 15 to 17, characterized by further comprising time-axis shift means for, in generating the new vectors, arranging at least elements close to each other in the new vector while shifting the elements in the time-axis direction.

**20.** A data compressing device which segments a data string including at least one unit of data into blocks forming vectors, searches a code book prepared in advance for a code vector similar to a vector extracted from a compression target, and outputs a code corresponding to the code vector, characterized by comprising:

vector quantizing means for, of data strings at times in the compression target which changes along a time axis, combining data at a corresponding address between units of data at the times to generate vectors, searching the code book for a code vector similar to each of the vectors, and outputting a code string corresponding to the code vectors.

**21.** A data compressing device according to claim 20, characterized by further comprising time-axis shift means for, in extracting the vectors, arranging elements in the vector while shifting the elements in the time-axis direction at least between vectors close to each other.

**22.** A data compressing device which segments a data string including at least one unit of data into blocks forming vectors, searches a code book prepared in advance for a code vector similar to a vector extracted from a compression target, and outputs a code corresponding to the code vector, characterized by comprising:

separation means for extracting at least one feature amount from the compression target and separating feature amount data from basic pattern data obtained by excluding the feature amount from the compression target,
wherein vector quantization is independently executed for each of the separated feature amount data and basic pattern data.

**23.** A data compressing device according to claim 22, characterized by further comprising

first vector quantizing means for, for each basic pattern data separated at each time by said separation means from the compression target which changes along a time axis, extracting blocks from the data, searching a first code book of basic patterns for a code vector similar to the vector, and outputting a code string corresponding to the vectors;
second vector quantizing means for rearranging the code strings output from said first vector quantizing means at respective times to generate new vectors, and for each of the new vectors, searching a second code book of basic patterns for a code vector similar to each of the vectors, and outputting a code string corresponding to the code vectors; and
third vector quantizing means for rearranging data strings each constructing a feature amount and separated by said separation means at each time from the compression target which changes along the time axis to generate new vectors, and for each of the new vectors, searching a third code book of feature amounts for a code vector similar to each of the vectors, and outputting a code string corresponding to the code vectors.

**24.** A data expanding device which uses a data string including at least one unit of data as a vector, searches a code book having at least one code vector for a code vector corresponding to a compression code, and allocates the code vector to a corresponding block position to reconstruct original data, characterized by comprising:

first decoding means for basic patterns, which reconstructs original basic pattern data on the basis of a code string related to a basic pattern output from said data compressing device of claim 22 or 23;
second decoding means for feature amounts, which reconstructs original feature amount data on the basis of a code string related to a feature amount output from said data compressing device of claim 22 or 23; and
synthesis means for synthesizing output results from said first and second decoding means to reconstruct the original data.

**25.** A data compressing device which segments a data string including at least one unit of data into blocks forming vectors, searches a code book prepared in advance for a code vector similar to a vector extracted from a compression target, and outputs a code corresponding to the code vector, characterized by comprising:

vector quantizing means for, for data at each time in the compression target which changes along a time axis, extracting blocks from the data, searching the code book for a code vector similar to each of the vectors, and outputting a code string corresponding to the code vectors at each time; and

output control means for, for the code string output from said vector quantizing means at each time, obtaining correlation between codes at a corresponding address between units of data adjacent in the time-axis direction and outputting the code only for an address where the correlation is smaller than a predetermined value.

26. A data compressing device which segments a data string including at least one unit of data into blocks forming vectors, searches a code book prepared in advance for a code vector similar to a vector extracted from a color image as a compression target, and outputs a code corresponding to the code vector, characterized by comprising:

a code book for luminance signals and a code book for chrominance signals, said code book for luminance signals being assigned a larger number of code vectors than said code book for chrominance signals.

27. A data compressing device according to claim 26, characterized in that a compression rate of a Y signal as the luminance signal and U and V signals as the chrominance signals is 4 : 1 : 1 or 4 : 2 : 2.

28. A code book making method of making a code book which is formed from a set of vectors as data strings each including at least one unit of data and is to be used for vector quantization, in which vector quantization processing is repeatedly executed using certain sample data and an initial code book, and contents in a range designated on a virtual two-dimensional plane of the code book are updated in accordance with a predetermined update coefficient for every processing step so as to optimize the code book, characterized in that:

a code book of patterns each having a data value continuously changing from a minimum value to a maximum value of possible values is used as the initial code book.

29. A code book making method of making a code book which is formed from a set of vectors as data strings each including at least one unit of data and is to be used for vector quantization, in which vector quantization processing is repeatedly executed using sample data and an initial code book, and contents in a range designated on a virtual two-dimensional plane of the code book are updated in accordance with a predetermined update coefficient for every processing step so as to optimize the code book, characterized in that:

the range to be updated by one processing step is one-dimensionally applied on the virtual two-dimensional plane and the range is reduced as the number of times of update increases.

30. A code book making method of making a code book which is formed from a set of vectors as data strings each including at least one unit of data and is to be used for vector quantization, in which vector quantization processing is repeatedly executed using sample data and an initial code book, and contents in a range designated on a virtual two-dimensional plane of the code book are updated in accordance with a predetermined update coefficient for every processing step so as to optimize the code book, characterized in that:

an initial value of the update coefficient to one value is set within a range of 0.3 to 1 and the value of the update coefficient is reduced as the number of times of update increases.

31. A code book making method of making a code book which is formed from a set of vectors as data strings each including at least one unit of data and is to be used for vector quantization, in which vector quantization processing is repeatedly executed using sample data and an initial code book, and contents in a range designated on a virtual two-dimensional plane of the code book are updated in accordance with a predetermined update coefficient for every processing step so as to optimize the code book, characterized in that:

a code book of patterns each having a data value continuously changing from a minimum value to a maximum value of possible values is used as the initial code book;
the range to be updated by one processing step is one-dimensionally applied on the virtual two-dimensional plane and the range is reduced as the number of times of update increases; and
an initial value of the update coefficient to one value is set within a range of 0.3 to 1 and the value of the update coefficient is reduced as the number of times of update increases.

32. A code book making method of making a code book which is formed from a set of vectors as data strings each including at least one unit of data and is to be used for vector quantization, in which vector quantization processing is repeatedly executed using sample data and an initial code book, and contents in a range designated on a virtual two-dimensional plane of the code book are updated in accordance with a predetermined update coefficient for every processing step so as to optimize the code book, characterized in that:

the code book for units of sample data is independently optimized and code books obtained are synthesized to make a new code book.

33. A code book making method according to claim 32, characterized in that, in independently optimizing the code book for the units of sample data, the code book is made according to said method of any one of claims 28 to 31.

34. A data compressing device according to any one of claims 1 to 3, 9 to 14, 18, 20 and 21, and 25 to 27, characterized by further comprising:

feature amount storage means for storing a feature amount obtained in advance for each code vector in the code book;
feature amount calculating means for obtaining a feature amount of the vector extracted from the compression target; and
calculation omitting means for determining whether calculation for obtaining similarity between each of the code vectors and the compression target vector is to be omitted on the basis of the feature amount of each code vector, which is stored in said feature amount storage means, and the feature amount of the compression target vector.

35. A data compressing device according to claim 34, characterized in that the feature amount is a sum, an average value, or DC components of values of the data string constructing the vectors.

36. A data compressing device according to claim 34, characterized in that the feature amount is a sum, an average value, or DC components of values of some elements of the data string constructing the vectors after the values are operated and inverted with reference to an intermediate value of possible values.

37. A data compressing device according to claim 34, characterized in that the feature amount is a direction of change in a block of values of the data string constructing the vectors.

38. A data compressing device according to claim 34, characterized in that the feature amount is a form of change in a block of values of the data string constructing the vectors.

39. A data compressing device according to any one of claims 34 to 38, characterized in that said calculation omitting means comprises

absolute difference value calculating means for obtaining an absolute difference value between a feature amount of a certain code vector and the feature amount of the compression target vector, and
omission determining means for, when the absolute difference value obtained by said absolute difference value calculating means is larger than a minimum value of a value representing similarity, which is already obtained for another code vector, omitting similarity calculation for the certain code vector.

40. A data compressing device according to any one of claims 1 to 3, 9 to 14, 18, 20 and 21, and 25 to 27, characterized by further comprising:

feature amount storage means for storing feature amounts of different types, which are obtained in advance for each of the code vectors in the code book;
feature amount calculating means for obtaining the feature amounts of different types for each vector extracted from the compression target; and
calculation omission means for determining for each of the code vectors whether calculation for obtaining similarity to the compression target vector is to be omitted, on the basis of the feature amounts of different types for each code vector, which are stored in said feature amount storage means and the feature amounts of different types for the compression target vector, which are obtained by said feature amount calculating means.

41. A data compressing/expanding system comprising a code book server for holding at least one code book, a data compressing system, and a data expanding system, characterized in that

> said code book server supplies one of the held code books in accordance with a request from said data compressing system or said data expanding system.

42. A data compressing/expanding system according to claim 41, characterized in that said code book server comprises:

> code book holding means for holding at least one code book;
> code book making means for making a code book matching the request from said data compressing system or said data expanding system; and
> code book management means for supplying the code book held in said code book holding means or the code book made by said code book making means in accordance with the request from said data compressing system or said data expanding system.

43. A data compressing method in which a data string including at least one unit of data is segmented into blocks forming vectors, a code vector similar to a vector extracted from a compression target is searched from a code book prepared in advance, and a code corresponding to the code vector is output, characterized in that

> the block forming the vector is a line block in which data positions are one-dimensionally arrayed.

44. A data compressing method in which a data string including at least one unit of data is segmented into blocks forming vectors, a code vector similar to a vector extracted from a compression target is searched from a code book prepared in advance, and a code corresponding to the code vector is output, characterized in that:

> the block forming the vector of the compression target is extracted from the compression target while shifting a spatial position in a horizontal direction at least between blocks close to each other in a vertical direction.

45. A data compressing method according to claim 44, characterized in that the block forming the vector is a line block in which data positions are one-dimensionally arrayed.

46. A data expanding method in which a data string including at least one unit of data is used as a vector, and a code vector corresponding to a compression code is searched from a code book having at least one code vector and allocated to a corresponding block position to reconstruct original data, characterized in that:

> the block constructing the code vector searched from the code book is allocated while shifting a spatial position in a horizontal direction at least between blocks close to each other in a vertical direction.

47. A data expanding method according to claim 46, characterized in that the block forming the vector is a line block in which data positions are one-dimensionally arrayed.

48. A data compressing/expanding method in which a data string including at least one unit of data is segmented into blocks forming vectors, in data compression, a code vector similar to a vector extracted from a compression target is searched from a code book prepared in advance, and a code corresponding to the code vector is output, and in data expansion, a code vector corresponding to the code is searched from the code book and allocated to a corresponding block position to reconstruct original data, characterized in that:

> in the data compression, the block forming the vector of the compression target is extracted from the compression target while shifting a spatial position in a horizontal direction at least between blocks close to each other in a vertical direction; and
> in the data expansion, the block of the code vector searched from the code book is allocated while shifting the spatial position in the horizontal direction at least between the blocks close to each other in the vertical direction so that the shift amount becomes the same as in the data compression, and the direction is opposite to that in the data compression.

49. A data compressing/expanding method according to claim 48, characterized in that the block forming the vector is a line block in which data positions are one-dimensionally arrayed.

50. A data compressing method in which a data string including at least one unit of data is segmented into blocks forming vectors, a code vector similar to a vector extracted from a compression target is searched from a code book prepared in advance, and a code corresponding to the code vector is output, characterized by comprising:

the first vector quantizing step of, for data at each time in the compression target which changes along a time axis, extracting blocks from the data, searching a first code book for a code vector similar to the vector, and outputting a code string corresponding to the code vector at each time;

the code string rearrangement step of, of the code strings output in the first vector quantizing step at each time, combining codes at a corresponding address between units of data at each time to generate new vectors; and

the second vector quantizing step of, for each of the new vectors generated in the code string rearrangement step, searching a second code book for a code vector similar to the vector, and outputting a code string corresponding to the code vector.

51. A data compressing method in which a data string including at least one unit of data is segmented into blocks forming vectors, a code vector similar to a vector extracted from a compression target is searched from a code book prepared in advance, and a code corresponding to the code vector is output, characterized by comprising:

the first vector quantizing step of, for data at each time in the compression target which changes along a time axis, extracting blocks from the data, searching a first code book for a code vector similar to the vector, and outputting a code string corresponding to the code vector at each time

the code string rearrangement step of, of the code strings output in the first vector quantizing step at each time, defining the code string of the data at the certain time as the reference code string, calculating a difference between the reference code string and the code string of the data at another time or between the codes at the corresponding address, and combining the differences at the corresponding address to generate new vectors; and

the second vector quantizing step of, for each of the new vectors generated in the code string rearrangement step, searching a second code book for a code vector similar to the vector, and outputting a code string corresponding to the code vector.

52. A data compressing method in which a data string including at least one unit of data is segmented into blocks forming vectors, a code vector similar to a vector extracted from a compression target is searched from a code book prepared in advance, and a code corresponding to the code vector is output, characterized by comprising:

the first vector quantizing step of, for data at each time in the compression target which changes along a time axis, extracting blocks from the data, searching a first code book for a code vector similar to the vector, and outputting a code string corresponding to the code vector at each time;

code string rearrangement step of, of the code strings output in the first vector quantizing step at each time, calculating a difference between the units of data adjacent in the time-axis direction or between the codes at the corresponding address, and combining the differences at the corresponding address to generate new vectors; and

the second vector quantizing step of, for each of the new vectors generated in the code string rearrangement step, searching a second code book for a code vector similar to the vector, and outputting a code string corresponding to the code vector.

53. A data compressing method according to any one of claims 50 to 52, characterized in that the code string rearrangement step comprises, in generating the new vectors, arranging elements in the new vector while shifting the elements in the time-axis direction at least between vectors close to each other.

54. A data compressing method in which a data string including at least one unit of data is segmented into blocks forming vectors, a code vector similar to a vector extracted from a compression target is searched from a code book prepared in advance, and a code corresponding to the code vector is output, characterized by comprising:

the vector quantizing step of, of data strings at times in the compression target which changes along a time axis, combining data at a corresponding address between units of data at the times to generate vectors, searching the code book for a code vector similar to each of the vectors, and outputting a code string corresponding to the code vectors.

55. A data compressing method according to claim 54, characterized in that, in extracting the vectors, elements in the vector are arranged while shifting the elements in the time-axis direction at least between vectors close to each other.

**56.** A data compressing method in which a data string including at least one unit of data is segmented into blocks forming vectors, a code vector similar to a vector extracted from a compression target is searched from a code book prepared in advance, and a code corresponding to the code vector is output, characterized in that:

at least one feature amount is extracted from the compression target, feature amount data is separated from basic pattern data obtained by excluding the feature amount from the compression target, and vector quantization for each of the separated feature amount data and basic pattern data is independently executed.

**57.** A data compressing method in which a data string including at least one unit of data is segmented into blocks forming vectors, a code vector similar to a vector extracted from a compression target is searched from a code book prepared in advance, and a code corresponding to the code vector is output, characterized by comprising:

the vector quantizing step of, for data at each time in the compression target which changes along a time axis, extracting blocks from the data, searching the code book for a code vector similar to each of the vectors, and outputting a code string corresponding to the code vectors at each time; and

the output step of, for the code string output in the vector quantizing step at each time, obtaining correlation between codes at a corresponding address between units of data adjacent in the time-axis direction and outputting the code only for an address where the correlation is smaller than a predetermined value.

**58.** A data compressing method in which a data string including at least one unit of data is segmented into blocks forming vectors, a code vector similar to a vector extracted from a compression target is searched from a code book prepared in advance, and a code corresponding to the code vector is output, characterized in that:

a code book for luminance signals and a code book for chrominance signals are prepared, said code book for luminance signals being assigned a larger number of code vectors than said code book for chrominance signals.

**59.** A data compressing method according to claim 58, characterized in that a compression rate of a Y signal as the luminance signal and U and V signals as the chrominance signals is 4 : 1 : 1 or 4 : 2 : 2.

**60.** A data compressing method according to any one of claims 43 to 45 and 50 to 59, characterized in that a feature amount extracted from the compression target is compared with a feature amount related to each code vector in the code book, and on the basis of a comparison result, calculation for obtaining similarity between the code vector and the compression target vector is omitted.

**61.** A data compressing method according to claim 60, characterized by further comprising:

the absolute difference value calculating step of obtaining an absolute difference value between a feature amount of a certain code vector and the feature amount of the compression target vector, and

the omission determining step of, when the absolute difference value obtained in the absolute difference value calculating step is larger than a minimum value of a value representing similarity, which is already obtained for another code vector, omitting similarity calculation for the certain code vector.

**62.** A data compressing method according to claim 60 or 61, characterized in that, using feature amounts of different types, it is determined for each of the code vectors whether calculation for obtaining similarity to the compression target vector is to be omitted, on the basis of the feature amounts of the above types and feature amounts of the types extracted for the compression target vector.

**63.** A data compressing/expanding method in a data compressing/expanding system comprising a code book server for holding at least one code book, a data compressing system, and a data expanding system, characterized in that

the code book server supplies one of the held code books in accordance with a request from the data compressing system or the data expanding system.

**64.** A computer-readable recording medium characterized in that said recording medium records a program for causing a computer to realize the function of claim 1.

65. A computer-readable recording medium characterized in that said recording medium records a program for causing a computer to function as said means of any one of claims 2, 4, and 6.

66. A computer-readable recording medium characterized in that said recording medium records a program for causing a computer to function as said means of any one of claims 9 to 25.

67. A computer-readable recording medium characterized in that said recording medium records a program for causing a computer to execute a processing procedure of said code book making method of any one of claims 29 to 32.

68. A computer-readable recording medium characterized in that said recording medium records a program for causing a computer to function as said means of claim 34 or 40.

69. A computer-readable recording medium characterized in that said recording medium records a program for causing a computer to realize the function of claim 41.

70. A computer-readable recording medium characterized in that said recording medium records a program for causing a computer to execute the step of any one of claims 50 to 52, 54, and 57.

71. A computer-readable recording medium characterized in that said recording medium records a program for causing a computer to execute a processing procedure of said data compressing method of claim 56 or 60.

72. A computer-readable recording medium characterized in that said recording medium records a program for causing a computer to execute a processing procedure of said data compressing/expanding method of claim 63.

73. A data compressing device which segments a data string including at least one unit of data into blocks forming vectors, searches a code book prepared in advance for a code vector similar to a vector extracted from a compression target, and outputs a code corresponding to the code vector, characterized by comprising:

vector quantizing means for, for data at each time in the compression target which changes along a time axis, extracting blocks from the data, searching the code book for a code vector similar to each of the vectors, and outputting a code string corresponding to the code vectors at each time; and
output control means for, for feature amount of each code vector searched by said vector quantizing means at each time, obtaining correlation between feature amounts at a corresponding address between units of data adjacent in the time-axis direction and outputting the code only for an address where the correlation is smaller than a predetermined value.

74. A data compressing device according to claim 25 or 73, characterized in that said output control means outputs the code string output from said vector quantizing means for some or all addresses independently of whether the correlation is smaller than the predetermined value at a certain time.

75. A data compressing device according to claim 74, characterized in that each of some addresses for which the code string is output independently of whether the correlation is smaller than the predetermined value is an address including adjacent blocks present in the data as the compression target or an address including discrete blocks present in the data as the compression target.

76. A data compressing device according to claim 74 or 75, characterized in that some addresses for which the code string is output independently of whether the correlation is smaller than the predetermined value are changed along with an elapse of time.

77. A data compressing method in which a data string including at least one unit of data is segmented into blocks forming vectors, a code vector similar to a vector extracted from a compression target is searched from a code book prepared in advance, and a code corresponding to the code vector is output, characterized by comprising:

the vector quantizing step of, for data at each time in the compression target which changes along a time axis, extracting blocks from the data, searching the code book for a code vector similar to each of the vectors, and outputting a code string corresponding to the code vectors at each time; and

the output step of, for feature amount of each code vector searched in the vector quantizing step at each time, obtaining correlation between feature amounts at a corresponding address between units of data adjacent in the time-axis direction and outputting the code only for an address where the correlation is smaller than a predetermined value.

**78.** A data compressing method according to claim 57 or 77, characterized in that the output step comprises outputting the code string output in the vector quantizing step for some or all addresses independently of whether the correlation is smaller than the predetermined value at a certain time.

**79.** A data compressing method according to claim 78, characterized in that each of some addresses for which the code string is output independently of whether the correlation is smaller than the predetermined value is an address including adjacent blocks present in the data as the compression target or an address including discrete blocks present in the data as the compression target.

**80.** A data compressing method according to claim 78 or 79, characterized in that some addresses for which the code string is output independently of whether the correlation is smaller than the predetermined value are changed along with an elapse of time.

**81.** A vector quantizing device which includes search means for searching template vector data similar to input vector data from units of template vector data stored and outputting a code of the searched template vector data, characterized by comprising:

search target selection means for, in executing the search, comparing a feature amount of the input vector data with a feature amount of the template vector data and selecting template vector data as a search target on the basis of a comparison result.

**82.** A vector quantizing device according to claim 81, characterized in that

said search means calculates a difference between each of elements of the template vector data and a corresponding one of elements of the input vector data and searches template vector data having a minimum Manhattan distance as a sum of absolute values of the differences; and
said search target selection means comprises
Manhattan distance calculating means for calculating the Manhattan distance M between certain template vector data and the input vector data,
difference calculating means for calculating an absolute difference value D between a feature amount of the input vector data and a feature amount of another template vector data different from the certain template vector data, and
calculation omitting means for, when comparison between the Manhattan distance M and the absolute difference value D reveals a relation $M \leqq D$, omitting calculation of the Manhattan distance from the input vector data for another template vector data.

**83.** A vector quantizing device which has search means for searching template vector data similar to input vector data from units of template vector data stored and outputting a code of the searched template vector data, characterized by comprising:

feature amount storage means for storing a feature amount obtained for each of the units of template vector data in advance;
feature amount calculating means for obtaining a feature amount of the input vector data; and
search target selection means for selecting template vector data as a search target on the basis of the feature amount of each template vector data, which is stored in said feature amount storage means, and the feature amount of the input vector data, which is obtained by said feature amount calculating means.

**84.** A vector quantizing device according to claim 83, characterized in that

said search target selection means comprises:
difference calculating means for obtaining an absolute difference value between a feature amount of certain template vector data and the feature amount of the input vector data; and
calculation omitting means for, when the absolute difference value obtained by said difference calculating means is not less than a minimum value of a value representing similarity which is already obtained for another code vector, omitting calculation of the Manhattan distance for the certain template vector data.

**85.** A vector quantizing device according to any one of claims 81 to 84, characterized in that the input vector data is formed from image data.

**86.** A vector quantizing device according to any one of claims 81 to 85, characterized in that the feature amount is a sum, an average value, or DC components of values of elements of vector data.

**87.** A vector quantizing device according to any one of claims 81 to 85, characterized in that the feature amount is a sum, an average value, or DC components of values of some of elements of the vector data after the values are operated and inverted with reference to an intermediate value of possible values.

**88.** A vector quantizing device according to any one of claims 81 to 85, characterized in that

the input vector data is a data string of a block formed from pixels on an image, and
the feature amount is a direction of change in value of each element of vector data in the block.

**89.** A vector quantizing device according to any one of claims 81 to 85, characterized in that

the input vector data is a data string of blocks each formed from pixels on an image, and
the feature amount is a form of change in value of each element of vector data in the block.

**90.** A vector quantizing device according to any one of claims 81 to 85, characterized in that the feature amount is variance of values of elements of vector data.

**91.** A vector quantizing device according to any one of claims 81 to 90, characterized in that said search target selection means selects the template vector data as the search target using feature amounts of different types.

**92.** A vector quantizing device according to claim 91, characterized in that said search target selection means compares a first feature amount of the input vector data with a first feature amount of the template vector data, narrows down a range of template vector data as search targets on the basis of a comparison result, compares a second feature amount of the input vector data with a second feature amount of the template vector data, and further narrows down the range of template vector data as search targets on the basis of a comparison result.

**93.** A vector quantizing device according to any one of claims 81 to 92, characterized in that all elements of the vector data are divided into parts, and the template vector data as the search target is selected using a feature amount of each divided element.

**94.** A vector quantizing device according to any one of claims 81 to 93, characterized in that said search means executes search in the order of the feature amounts of the template vector data.

**95.** A vector quantizing device according to claim 94, characterized in that said search means executes search starting from template vector data which is determined to be closest to an answer on the basis of the feature amount of the input vector data and the feature amount of the template vector data.

**96.** A vector quantizing device according to claim 94 or 95, characterized in that the template vector data are arranged in a storage unit in the order of feature amounts, and the template vector data are multi-dimensionally arranged using feature amounts.

**97.** A vector quantizing device according to any one of claims 81 to 96, characterized in that said search means comprises:

two or more similarity calculating means for parallelly reading units of template vector data selected by said search target selection means as the search targets and parallelly searching for template vector data similar to the input vector data; and
template specifying means for specifying template vector data most similar to the input vector data on the basis of calculation results from said two or more similarity calculating means and outputting a corresponding code.

**98.** A vector quantizing method in which template vector data similar to input vector data is searched from units of template vector data stored, and a code of the searched template vector data is output, characterized in that:

in executing the search, a feature amount of the input vector data is compared with a feature amount of the template vector data and template vector data is selected as a search target on the basis of a comparison result.

**99.** A vector quantizing method according to claim 98, characterized in that:

the search processing is to calculate a difference between each of elements of the template vector data and a corresponding one of elements of the input vector data and to search template vector data having a minimum Manhattan distance as a sum of absolute values of the differences, wherein,
as for a certain unit of template vector data, the Manhattan distance M is calculated between the template vector data and the input vector data, an absolute difference value D between a feature amount of the input vector data and a feature amount of another template vector data different from the above template vector data is calculated, and when comparison between the Manhattan distance M and the absolute difference value D reveals a relation $M \leqq D$, calculation of the Manhattan distance from the input vector data is omitted for the other template vector data.

**100.** A vector quantizing device according to claim 98 or 99, characterized in that the template vector data is selected as the search target using feature amounts of different types.

**101.** A vector quantizing method according to any one of claims 98 to 100, characterized in that all elements of the vector data are divided into parts and the template vector data is selected as the search target using a feature amount of each divided element.

**102.** A vector quantizing method according to any one of claims 98 to 101, characterized in that units of template vector data are parallelly read as the search targets parallelly to search for template vector data similar to the input vector data.

**103.** A computer-readable recording medium characterized in that said recording medium records a program for causing a computer to function as said means of any one of claims 81 to 84.

**104.** A computer-readable recording medium characterized in that said recording medium records a program for causing a computer to realize the function of any one of claims 91 to 95.

**105.** A computer-readable recording medium characterized in that said recording medium records a program for causing a computer to execute a processing procedure of said vector quantizing method of any one of claims 98 to 102.

# F I G. 1

```
          ┌──────────────┐
          │    IMAGE     │
          │    INPUT     │～1
          │   SECTION    │
          └──────────────┘
                 │
                 ▼
┌─────────────┐ 3  ┌──────────────┐
│    READ     │～   │    IMAGE     │～2
│   SECTION   │───▶│    MEMORY    │
└─────────────┘    └──────────────┘
                          │
                          ▼
┌─────────────┐ 5  ┌──────────────┐
│  CODE BOOK  │～   │   BLOCKING   │～4
│   STORAGE   │───▶│   SECTION    │
│   SECTION   │    └──────────────┘
└─────────────┘           │
                          ▼
                   ┌──────────────┐
                   │    VECTOR    │～6
                   │  QUANTIZING  │
                   │   SECTION    │
                   └──────────────┘
                          │
                          ▼
                    CODE NUMBER
```

# F I G. 2

```
                              ┌──────────────┐
                              │ CODE NUMBER  │
                              │    INPUT     │~7
                              │   SECTION    │
                              └──────┬───────┘
                                     │
                                     ▼
┌──────────────┐             ┌──────────────┐
│    READ      │~9           │    CODE      │~8
│   SECTION    │────────────▶│   MEMORY     │
└──────────────┘             └──────┬───────┘
                                    │
                                    ▼
┌──────────────┐   10        ┌─────────────────────┐
│  CODE BOOK   │~            │   RECONSTRUCTED      │~11
│   STORAGE    │────────────▶│ IMAGE GENERATING     │
│   SECTION    │             │     SECTION          │
└──────────────┘             └──────────┬──────────┘
                                        │
                                        ▼
                              ┌──────────────┐
                              │    BLOCK     │~12
                              │    SHIFT     │
                              │   SECTION    │
                              └──────┬───────┘
                                     │
                                     ▼
                              ┌──────────────┐
                              │ IMAGE MEMORY │~13
                              └──────┬───────┘
                                     │
                                     ▼
                       DISPLAY ON DISPLAY DEVICE
```

51

# F I G. 3

START

INITIALIZATION

CLEAR BLOCK COUNTER,
CLEAR IMAGE BUFFER,
AND CLEAR CODE BUFFER — S1

LOADING OF
INPUT IMAGE

STORE IMAGE DATA IN
IMAGE BUFFER — S2

READ OF BLOCK DATA

READ X × Y PIXEL BLOCK
WHILE SHIFTING IT IN
HORIZONTAL DIRECTION — S3

VECTOR QUANTIZATION

DETERMINE WINNER CODE
HAVING HIGHEST
CORRELATION RATIO
FROM CODE BOOK — S4

RESULT SAVING

STORE WINNER CODE
IN CODE BUFFER — S5

ALL BLOCK PROCESSED? — S6

NO → INCREMENT BLOCK COUNTER BY ONE — S7

YES

END

# F I G. 4

START

INITIALIZATION

CLEAR BLOCK COUNTER,
CLEAR RECONSTRUCTED
IMAGE BUFFER,
AND CLEAR CODE BUFFER — S8

LOAD OF
WINNER CODE

STORE WINNER CODE
IN CODE BUFFER — S9

DECODING

STORE IMAGE OF WINNER
CODE IN RECONSTRUCTED
IMAGE BUFFER WHILE
SHIFTING IT IN
HORIZONTAL DIRECTION — S10

S11

ALL BLOCK
PROCESSED? — NO — INCREMENT BLOCK
COUNTER BY ONE S12

YES

END

MACROBLOCK

LINE BLOCK

CODE BOOK MEMORY

DISPLAY MEMORY

ADDRESS CONVERSION

NECESSARY

UNNECESSARY

(a)

(b)

F I G. 5

EP 1 079 635 A1

54

NORMAL ARRANGEMENT

LINE BLOCK

SLIDE ARRANGEMENT

F I G. 6

FIG. 7

# F I G. 8

VECTOR QUANTIZATION BOARD

22

23

IMAGE

CODE BOOK

CODE

21 MEMORY

RECONSTRUCTED IMAGE AFTER VECTOR QUANTIZATION

# F I G. 9

```
                              ┌──────────┐
                              │  IMAGE   │
                              │  INPUT   │～31
                              │ SECTION  │
                              └──────────┘
                                    │
                                    ▼
          33                  ┌──────────┐
           ⌇                  │  IMAGE   │
     ┌──────────┐   ┌────────▶│ MEMORY   │～32
     │   READ   │   │         └──────────┘
     │ SECTION  │───┘               │
     └──────────┘                   ▼
                              ┌──────────┐
          37                  │ BLOCKING │～34
           ⌇                  │ SECTION  │
     ┌───────────┐            └──────────┘
     │CALCULATION│
     │   MODE    │        ┌─────────────────┐
     │SPECIFYING │────┐   │ TIME-AXIS CODE  │
     │  SECTION  │    │   │ BOOK STORAGE    │～40
     └───────────┘    │   │    SECTION      │
                      │   └─────────────────┘
     ┌──────────┐     ▼            │
     │  SPACE   │  ┌──────────────┐│
     │DIRECTION │  │ CORRELATION  │◀──────────  TO 37
     │CODE BOOK │──▶│    RATIO     │              ▲
     │ STORAGE  │  │ CALCULATION  │              ┆
     │ SECTION  │  │   SECTION    │◀──┐    TIME-AXIS VECTOR
     └──────────┘  └──────────────┘   │    QUANTIZATION
          ⌇               │           │    START SIGNAL
          35              ▼   36      │
                   ┌──────────────┐   │
                   │    CODE      │～38 │
                   │ DETERMINING  │───┐└─┌──────────────┐
                   │   SECTION    │   │  │SPACE DIRECTION│
                   └──────────────┘   └─▶│    CODE      │～39
                          │             │REARRANGEMENT │
                          ▼             │ CALCULATING  │
                   WINNER CODE OUTPUT   │   SECTION    │
                                       └──────────────┘
```

# F I G. 10

```
                                    ┌─────────────┐
                                    │  TIME-AXIS  │
                                    │    CODE     │
                                    │    INPUT    │~41
                                    │   SECTION   │
                                    └─────────────┘
                                           │
                                           ▼
        ┌─────────────┐            ┌─────────────┐
   43 ─ │    READ     │            │  TIME-AXIS  │~42
        │   SECTION   │───────────▶│    CODE     │
        └─────────────┘            │   MEMORY    │
                                   └─────────────┘
                                           │
                                           ▼
        ┌─────────────┐            ┌─────────────┐
   45 ─ │  TIME-AXIS  │            │    SPACE    │
        │  CODE BOOK  │            │  DIRECTION  │
        │   STORAGE   │──────────▶ │    CODE     │
        │   SECTION   │            │RECONSTRUCTING│
        └─────────────┘            │   SECTION   │~44
                                   └─────────────┘
                                           │
                                           ▼
        ┌─────────────┐            ┌─────────────────┐
   47 ─ │    READ     │            │ SPACE DIRECTION │~46
        │   SECTION   │──────────▶ │  CODE MEMORY    │
        └─────────────┘            └─────────────────┘
                                           │
                                           ▼
        ┌─────────────────┐        ┌─────────────────┐
   49 ─ │ SPACE DIRECTION │        │  RECONSTRUCTED  │
        │   CODE BOOK     │─────▶  │ IMAGE GENERATION│~48
        │ STORAGE SECTION │        │    SECTION      │
        └─────────────────┘        └─────────────────┘
                                           │
                                           ▼
                                   ┌─────────────┐
                                   │    IMAGE    │~50
                                   │   MEMORY    │
                                   └─────────────┘
                                           │
                                           ▼
```

DISPLAY ON DISPLAY DEVICE
OR STORE IN STORAGE DEVICE

# F I G. 11

SPACE DIRECTION VECTOR QUANTIZATION

640 / 480

FRAME 1 → 127,198___

FRAME 2 → 287,587___

FRAME 3 → 58,1587___

FRAME 15 → 1483,198___

FRAME 16 → 876,1111___

SPACE DIRECTION VECTOR QUANTIZATION
CODE NUMBER DATA LIST

REARRANGEMENT OF SPACE DIRECTION
VECTOR QUANTIZATION CODE NUMBERS

(127,287,58, ___,1483,876)
(198,587,1587, ___,198 1111)

CODE NUMBER DATA LIST
OF 16 FRAMES

TIME-AXIS VECTOR QUANTIZATION

→ 10,984,___

TIME-AXIS VECTOR QUANTIZATION
CODE NUMBER DATA LIST

(TRANSMISSION DATA)

EP 1 079 635 A1

# F I G. 12

SPACE DIRECTION VECTOR QUANTIZATION

640
480
FRAME 1 → 127,198___ ──────────────→ 127,198___
(REFERENCE FRAME DATA)

FRAME 2 → 287,587___ → FRAME 2-FRAME 1

FRAME 3 → 58,1587___ → FRAME 3-FRAME 1

REARRANGEMENT OF SPACE DIRECTION VECTOR QUANTIZATION INTERFRAME DIFFERENCE CODE NUMBERS

(160,-69,30, ___,749,743)
(198,-65,130, ___,198 1111)

TIME-AXIS VECTOR QUANTIZATION

→ 10,984,___

FRAME 15 → 1483,198___ → FRAME 15-FRAME 1

CODE NUMBER DATA LIST OF 17 FRAMES

TIME-AXIS VECTOR QUANTIZATION CODE NUMBER DATA LIST

(TRANSMISSION DATA)

FRAME 16 → 876,1111___ → FRAME 16-FRAME 1

FRAME 17 → 870,1100___ → FRAME 17-FRAME 1

SPACE DIRECTION VECTOR QUANTIZATION CODE NUMBER DATA LIST

EP 1 079 635 A1

# F I G. 13

FRAME 1
640
480

SPACE DIRECTION VECTOR QUANTIZATION

127,198___ → 127,198___
(REFERENCE FRAME DATA)

FRAME 2
287,587___ → FRAME 2-FRAME 1

FRAME 3
58,1587___ → FRAME 3-FRAME 2

FRAME 15
1483,198___ → FRAME 15-FRAME 14

FRAME 16
876,1111___ → FRAME 16-FRAME 15

FRAME 17
870,1100___ → FRAME 17-FRAME 16

SPACE DIRECTION VECTOR QUANTIZATION
CODE NUMBER DATA LIST

REARRANGEMENT OF SPACE DIRECTION
VECTOR QUANTIZATION INTERFRAME
DIFFERENCE CODE NUMBERS

(160,-229,58, ___,-607,-6)
(198,-65,1587, ___,198 1111)

CODE NUMBER DATA LIST
OF 17 FRAMES

TIME-AXIS VECTOR QUANTIZATION

10,984,___

TIME-AXIS VECTOR QUANTIZATION
CODE NUMBER DATA LIST

(TRANSMISSION DATA)

EP 1 079 635 A1

# F I G. 14

.

```
                    ┌─────────────────────────────┐
                    │  TIME-AXIS CODE         48a  │
                    │  REARRANGEMENT               │
                    │  CALCULATING SECTION         │ 48
                    │           │                  │
                    │  ┌─────────────┐ 48b         │
                    │  │ TIME-AXIS   │             │
                    │  │ SHIFT SECTION│            │
                    │  └─────────────┘             │
                    │           │                  │
                    │  ┌──────────────┐ 48c        │  ┌──────────────────┐
                    │  │ SPACE DIRECTION│◄─────────┼──│ SPACE DIRECTION 49│
                    │  │ DECODING SECTION│         │  │ CODE BOOK         │
                    │  └──────────────┘            │  │ STORAGE SECTION   │
                    └─────────────────────────────┘  └──────────────────┘
```

RECONSTRUCTED IMAGE

# F I G. 15

IMAGE
INPUT
SECTION ~31

33

READ
SECTION

IMAGE
MEMORY ~32

BLOCKING
SECTION ~34

51~ DC COMPONENT
DETECTING/
REMOVING
SECTION

MINIMUM
LUMINANCE
VALUE

SPACE
DIRECTION DC
COMPONENT
REARRANGEMENT ~54
CALCULATING
SECTION

52

CALCULATION
MODE
SPECIFYING
SECTION

INPUT IMAGE
BLOCK AFTER
REMOVAL OF
DC COMPONENT

TIME-AXIS VECTOR
QUANTIZATION
START SIGNAL

TO 52

SPACE
DIRECTION
CODE BOOK
STORAGE
SECTION

CORRELATION
RATIO
CALCULATION
SECTION

TIME-AXIS DC
COMPONENT
CODE BOOK
STORAGE
SECTION
~56

53

36

TIME-AXIS
CODE BOOK
STORAGE
SECTION

TO 52

55

TIME-AXIS VECTOR
QUANTIZATION
START SIGNAL

~38
CODE
DETERMINING
SECTION

SPACE DIRECTION
CODE
REARRANGEMENT ~39
CALCULATING
SECTION

WINNER CODE OUTPUT

64

# F I G. 16

640

480

(127,287,58,⋯,283,276)
(198,187,187,⋯,198,111)

TIME-AXIS
VECTOR
QUANTIZATION

TIME-AXIS VECTOR
QUANTIZATION
CODE NUMBER
DATA LIST (1)

EXECUTE VQ USING
SPACE DIRECTION CODE
BOOK FORMED FROM
ONLY BASIC PATTERNS
(GENERATE SPACE
DIRECTION VQ CODE
NUMBER DATA LIST)

GENERATE CODE
NUMBER DATA
LIST OF
ALL FRAMES

640

480

ORIGINAL IMAGE

DETECT MINIMUM
LUMINANCE
VALUE IN BLOCK
AND SUBTRACT
MINIMUMLUMINANCE
VALUE FROM ALL PIXELS

160

120

(60,50,58,⋯,76,77)
(40,46,48,⋯,53,59)

TIME-AXIS
VECTOR
QUANTIZATION

TIME-AXIS VECTOR
QUANTIZATION
CODE NUMBER
DATA LIST (2)

EXTRACT ONLY
MINIMUMLUMINANCE
VALUE OF EACH BLOCK
(GENERATE MINIMUM
LUMINANCE VALUE
DATA LIST)

GENERATE MINIMUM
LUMINANCE VALUE
DATA LIST OF
ALL FRAMES

EP 1 079 635 A1

# F I G. 17

```
        IMAGE INPUT          61
          SECTION

              ↓

   COMPRESSION SECTION    63        CODE BOOK         62
       USING CODE                STORAGE SECTION
      BOOK SCHEME

              ↓

       CODE STRING         64
     STORAGE SECTION

              ↓

       CODE STRING         65
    COMPARISON SECTION

              ↓

     OUTPUT SECTION        66

              ↓

        MEDIUM             67
```

# F I G. 18

```
        61                    68
         ↓                     ↓

  ┌──────────────┐      ┌──────────────┐      ┌──────────┐
  │ IMAGE INPUT  │ ───→ │              │ ───→ │ MEDIUM   │~67
  │   SECTION    │      │     CPU      │      └──────────┘
  └──────────────┘      └──────────────┘
                               ↕
                                           ┌──────────────────────┐
                                     ↕ ────→│    COMPRESSION        │~63
                                           │ SECTION USING CODE    │
                                           │   BOOK SCHEME         │
                                           └──────────────────────┘

  ┌─────────────────────────────┐
  │  ┌──────────────────┐~69a    │
  │  │   CODE BOOK       │        │
  │  │ STORAGE  AREA     │        │
  │  └──────────────────┘        │
  │  ┌──────────────────┐~69b    │
  │  │   CODE STRING     │        │
  │  │ STORAGE  AREA     │        │
  │  └──────────────────┘        │
  │  ┌──────────────────┐~69c    │
  │  │ POINTER/COUNTER   │        │
  │  │      AREA         │        │
  │  └──────────────────┘        │
  │  ┌──────────────────┐~69d  ~69│
  │  │ THRESHOLD  VALUE  │        │
  │  │ STORAGE  AREA     │        │
  │  └──────────────────┘        │
  │                    MEMORY    │
  └─────────────────────────────┘
```

# F I G. 19

START

TRANSFER CODE BOOK FROM CODE BOOK STORAGE AREA TO CODE-BOOK-SCHEME COMPRESSION SECTION ~S21

SET THRESHOLD VALUE ~S22

INITIALIZE POINTER ~S23

READ ONE MACROBLOCK ~S24

COMPRESS MACROBLOCK BY CODE-BOOK-SCHEME COMPRESSION SECTION ~S25

CALCULATE ABSOLUTE DIFFERENCE VALUE BETWEEN OUTPUT CODE AND CODE STORED IN CODE STORAGE AREA ~S26

ABSOLUTE DIFFERENCE VALUE > THRESHOLD VALUE? S27

Y → TRANSFER OUTPUT CODE AND OUTPUT CODE ADDRESS S28

N

STORE OUTPUT CODE IN CODE STORAGE AREA ~S29

POINTER+1 ~S30

DETA PROCESSED ? S31

N

Y

END

# F I G. 20

IMAGE INPUT
SECTION `71`

READ SECTION `73`

IMAGE MEMORY `72`

Y/U/V SIGNAL
SEPARATING SECTION `74`

Y   U   V

SIGNAL TYPE
DESIGNATION SIGNAL

BLOCKING SECTION `75`

SPACE DIRECTION
CODE BOOK
STORAGE SECTION `76`

CORRELATION RATIO
CALCULATION SECTION `77`

CODE DETERMINING
SECTION `78`

WINNER CODE OUTPUT

# F I G. 21

INITIAL CODE BOOK    IMAGE BLOCK INPUT

```
              ┌─────────────────────┐
              │  DETECT CODE BOOK    │
              │ VECTOR MOST SIMILAR  │
              │ TO IMAGE BLOCK (VQ)  │
              └─────────────────────┘
REPEAT BY
LEARNING COUNT c
              ┌─────────────────────┐
              │  REWRITE CODE BOOK   │
              │ (GAIN k AND RANGE Nc)│
              └─────────────────────┘
```

OPTIMIZED CODE BOOK

# F I G. 22

F I G. 23

REWRITE RANGE

METHOD OF ONE-DIMENSIONALLY APPLYING RANGE AND REDUCING IT AS THE NUMBER OF TIMES OF UPDATE INCREASES
(a)

A METHOD OF TWO-DIMENSIONALLY APPLYING RANGE AND REDUCING IT AS THE NUMBER OF TIMES OF UPDATE INCREASES
(b)

ONE-DIMENSIONAL

TWO-DIMENSIONAL

PSNR [dB]

Compression Ratio

# F I G. 24

# F I G. 25

# F I G. 26

# F I G. 27

# F I G. 28

ADDRESS COUNTER
m
88

MINIMUM DISTANCE
ADDRESS STORAGE
SECTION
minA
89

CODE NUMBER

| FEATURE AMOUNT STORAGE SECTION | CODE BOOK STORAGE SECTION |
|---|---|
| $\Sigma T_1 = 195$ | $T_1 = (14,25,21,51,70,14)$ |
| $\Sigma T_2 = 261$ | $T_2 = (36,48,27,53,69,28)$ |
| $\Sigma T_3 = 311$ | $T_3 = (56,49,34,59,77,36)$ |
| $\Sigma T_4 = 108$ | $T_4 = (--)$ |

82

81

~D5

~D2

INPUT VECTOR DATA
$I = (34,45,23,54,75,34)$

D1

FEATURE AMOUNT CALCULATING SECTION
265
85

D4

FEATURE AMOUNT DIFFERENCE CALCULATING SECTION
86

MANHATTAN DISTANCE CALCULATING SECTION
83

~D3

~D7

CALCULATION OMISSION DETERMINING SECTION
87

MINIMUM MANHATTAN DISTANCE STORAGE SECTION
minM
84

D6

COUNTER INCREMENT CONTROL

UPDATE CONTROL

EP 1 079 635 A1

# F I G. 29

START

INPUT INPUT VECTOR DATA "1" — S41

CALCULATE SUM OF ELEMENTS OF INPUT VECTOR DATA  S42
$$\sum_{i=1}^{n} Ii$$

S43

INITIALIZE NUMBER(ADDRESS) OF TEMPLATE VECTOR
DATA TO BE SEARCHED
$m=1$ , $minA=1$
INITIALIZE MINIMUM MANHATTAN DISTANCE CURRENTLY KNOWN
$minM=\infty$

S44

$m>k?$  —  Y

S50

$m=m+1$

N

END

DIFFERENCE IN SUM OF ELEMENTS BETWEEN
TEMPLATE VECTOR DATA TO BE SEARCHED
AND INPUT VECTOR DATA
$$Dm=\left|\sum_{i=1}^{n} Ii - \sum_{i=1}^{n} Tmi\right|$$
S45

S46

Y — $Dm>min\ M\ ?$

N

CALCULATE MANHATTAN DISTANCE
$$Mm=\sum_{i=1}^{n} |Ii - Tmi|$$
S47

S48

Y — $Mm \geq min\ M\ ?$

N

UPDATE MINIMUM MANHATTAN
DISTANCE CURRENTLY KNOWN
$minM=Mm$
RECORD NUMBER (ADDRESS) OF
SEARCHED TEMPLATE VECTOR DATA
$minA=m$
S49

# F I G. 30

91

92

SIMILAR PATTERN

93

ORIGINAL IMAGE

TEMPLATE VECTOR
DATA NUMBER
(OR ADDRESS IN
STORAGE DEVICE)

#1  #2  #3  #4

#5  #6  #7  #8

#9  #10  #11  #12

94

"2"

RECONSTRUCTED IMAGE

CODE BOOK

EP 1 079 635 A1

# F I G. 31

IMAGE BLOCK CORRESPONDING TO INPUT VECTOR
DATA

IMAGE BLOCK CORRESPONDING TO TEMPLATE VECTOR
DATA

FIG. 32

EP 1 079 635 A1

# F I G. 33

INVERTED IMAGE SUM OF LUMINANCE VALUES

INVERTED PATTERN    BLOCK    OF PIXELS

(2336)

112    115    118

INITIAL IMAGE
BLOCK

111

(1456)

113    116    119

(2736)

114    117    120

EP 1 079 635 A1

INITIAL IMAGE
BLOCK

INVERTED PATTERN

INVERTED IMAGE
BLOCK

SUM OF LUMINANCE VALUES
OF PIXELS

(2736)

(1360)

121

123

124

126

122

125

127

F I G. 34

# F I G. 35

IMAGE BLOCK

FOUR CORNERS
OF IMAGE BLOCK

131

133

132

134

(a)

MAGNITUDE COMPARISON PATTERN
BETWEEN PIXELS AT
FOUR CORNERS OF IMAGE BLOCK

No.1

No.2

PATTERN NUMBER
(FEATURE AMOUNT)

(b)

# F I G. 36

IMAGE BLOCK

142

141

# F I G. 37

EP 1 079 635 A1

# F I G. 38

COMPRESSED DATA →

161 — CODE-BOOK-SCHEME COMPRESSING SYSTEM → NETWORK → CODE-BOOK-SCHEME EXPANDING SYSTEM — 167

166

CODE BOOK DATA ↑ 165

NETWORK 164

CODE BOOK REQUEST ↓ 163

CODE BOOK DATA ↑ 170

NETWORK 169

CODE BOOK REQUEST ↓ 168

162

| 171 — CODE BOOK STORAGE UNIT | CODE BOOK REGISTERING UNIT — 173 |
| 172 — CODE BOOK MANAGEMENT UNIT | CODE BOOK MAKING UNIT — 174 |

CODE BOOK SERVER SYSTEM

EP 1 079 635 A1

# F I G. 39

SDVQ CODE NUMBER

4×4pixels
SDVQ

| 15 | 30 |
| 10 | 20 |

ORIGINAL IMAGE

Flame

SDVQ-MACROBLOCK
(4×4pixels)

TDVQ-MACROBLOCK
(2×2)×4

# F I G. 40

EP 1 079 635 A1

# F I G. 41

IMAGE INPUT SECTION ~31

READ SECTION ~33

IMAGE MEMORY ~32

BLOCKING SECTION ~34

CALCULATION MODE SPECIFYING SECTION ~37

TIME-AXIS CODE BOOK STORAGE SECTION ~40

SPACE DIRECTION CODE BOOK STORAGE SECTION ~35

CORRELATION RATIO CALCULATION SECTION ~36

TO 37

TIME-AXIS VECTOR QUANTIZATION START SIGNAL

CODE DETERMINING SECTION ~38

WINNER CODE OUTPUT

SPACE DIRECTION CODE REARRANGEMENT CALCULATING SECTION ~39

SPACE DIRECTION CODE REARRANGEMENT METHOD SPECIFYING SECTION ~181

# F I G. 42

```
                          ┌──────────────┐
                          │  TINE-AXIS   │
                          │    CODE      │
                          │   INPUT      │~41
                          │  SECTION     │
                          └──────┬───────┘
                                 │
      43                         ▼
 ┌──────────────┐        ┌──────────────┐
 │   READ       │───────▶│  TINE-AXIS   │~42
 │  SECTION     │        │    CODE      │
 └──────────────┘        │  MEMORY      │
                         └──────┬───────┘
      45                        │
 ┌──────────────┐               ▼
 │  TIME-AXIS   │        ┌──────────────┐
 │ CODE BOOK    │───────▶│    SPACE     │
 │ STORAGE      │        │  DIRECTION   │
 │ SECTION      │     ┌─▶│    CODE      │
 └──────────────┘     │  │RECONSTRUCTING│
                      │  │  SECTION     │~44
 ┌──────────────┐     │  └──────┬───────┘
 │SPACE DIRECTION│    │         │
 │    CODE       │    │         │
 │RECONSTRUCTION │────┘         │   182
 │   METHOD      │              │
 │ SPECIFYING    │              │
 │  SECTION      │              │
 └──────────────┘              │
      47                        ▼
 ┌──────────────┐        ┌──────────────┐
 │   READ       │───────▶│SPACE DIRECTION│~46
 │  SECTION     │        │ CODE MEMORY  │
 └──────────────┘        └──────┬───────┘
      49                        │
 ┌──────────────┐               ▼
 │SPACE DIRECTION│       ┌──────────────┐
 │  CODE BOOK    │──────▶│ RECONSTRUCTED │
 │STORAGE SECTION│       │IMAGE GENERATION│~48
 └──────────────┘        │  SECTION     │
                         └──────┬───────┘
                                │
                                ▼
                         ┌──────────────┐
                         │    IMAGE     │~50
                         │   MEMORY     │
                         └──────┬───────┘
                                │
                                ▼
                    DISPLAY ON DISPLAY
                    DEVICE OR STORE
                    STORAGE DEVICE
```

# F I G. 43

SPACE DIRECTION
VECTOR QUANTIZATION

640

160

480

| 127,198 | 186,186 | — — |
| 127,198 | 186,186 | |
| — — | — — | — — |

120

FRAME 1

REFERENCE
FRAME DATA

| 127,198 | 186,186 | — — |
| 127,198 | 186,186 | |
| — — | — — | — — |

| 127,198 | 186,186 | — — |
| 107,154 | 178,178 | |
| — — | — — | — — |

FRAME 2

FRAME 2-FRAME 1

| 107,154 | 178,178 | — — |
| 107,154 | 178,178 | |
| — — | — — | — — |

FRAME 3

FRAME 3-FRAME 2

REARRANGEMENT OF
SPACE DIRECTION
VECTOR QUANTIZATION
CODE NUMBER

| 96,128 | 164,164 | — — |
| 96,128 | 164,164 | |
| — — | — — | — — |

FRAME 4

FRAME 4-FRAME 3

(0,0,-20,-44,-20,-44,-20,-44,-31,-70,-31,-70,-20,-44,-20,-44)
(0,0,-8,-8,-8,-8,-8,-8,-24,-24,-24,-4,-8,-8,-8,-8,)
— — — — — — — — — — — — — — — —
— — — — — — — — — — — — — — — —

| 107,154 | 178,178 | — — |
| 107,154 | 178,178 | |
| — — | — — | — — |

FRAME 5

FRAME 5-FRAME 4

SPACE DIRECTION
VECTOR QUANTIZATION
CODE NUMBER
DATA LIST

TIME-AXIS VECTOR
QUANTIZATION

10,984,----

TRANSMISSION DATA

EP 1 079 635 A1

# F I G. 44

SPACE DIRECTION
VECTOR QUANTIZATION

640

160

480

120

127,198, 186,186 --
127,198, 186,186 --
-- -- -- -- -- --

FRAME 1

127,198, 186,186 --
127,198, 186,186 --
-- -- -- -- -- --

REFERENCE
FRAME DATA

127,198, 186,186 --
107,154, 178,178 --
-- -- -- -- -- --

FRAME 2

FRAME 2-FRAME 1

107,154, 178,178 --
107,154, 178,178 --
-- -- -- -- -- --

FRAME 3

FRAME 3-FRAME 2

REARRANGEMENT OF
SPACE DIRECTION
VECTOR QUANTIZATION
CODE NUMBER

96,128, 164,164 --
96,128, 164,164 --
-- -- -- -- -- --

FRAME 4

FRAME 4-FRAME 3

(0,0,−20,−44,−20,−44,0,0,−11,−26,−11,−26,11,26,11,26)
(0,0,−88,−8,−8,−8,0,0,−14,−14,−14,−14,.14,14,14,14,14)
-- -- -- -- -- -- -- -- -- -- -- --
-- -- -- -- -- -- -- -- -- -- -- --

107,154, 178,178 --
107,154, 178,178 --
-- -- -- -- -- --

FRAME 5

FRAME 5-FRAME 4

SPACE DIRECTION
VECTOR QUANTIZATION
CODE NUMBER
DATA LIST

TIME-AXIS VECTOR
QUANTIZATION

10,984,----

TRANSMISSION DATA

EP 1 079 635 A1

# F I G. 45

```
                    ┌─────────────┐
                    │    IMAGE    │
                    │    INPUT    │ ～31
                    │   SECTION   │
                    └─────────────┘
  33                       │
   │                       ▼
┌─────────┐         ┌─────────────┐                          ┌──────────────────┐
│  READ   │────────▶│    IMAGE    │ ～32                     │      SPACE       │
│ SECTION │         │   MEMORY    │                          │  DIRECTION DC    │
└─────────┘         └─────────────┘                          │   COMPONENT      │ ～183
                           │                                 │ REARRANGEMENT    │
                           ▼                                 │     METHOD       │
                    ┌─────────────┐                          │   SPECIFYING     │
                    │  BLOCKING   │ ～34                     │    SECTION       │
                    │   SECTION   │                          └──────────────────┘
                    └─────────────┘                                   │
                           │                                          ▼
        ┌──────────────────┴──┐  MINIMUM            ┌──────────────────────┐
  51 ～  │  DC COMPONENT       │  LUMINANCE          │      SPACE           │
        │  DETECTING/         │  VALUE              │  DIRECTION DC        │
        │  REMOVING           │──────────────────▶  │   COMPONENT          │ ～54
        │  SECTION            │                     │  REARRANGEMENT       │
        └─────────────────────┘                     │  CALCULATING         │
   52              │                                │    SECTION           │
    │              │  INPUT IMAGE                   └──────────────────────┘
┌─────────────┐    │  BLOCK AFTER                             │
│ CALCULATION │    │  REMOVAL OF                     TIME-AXIS VECTOR
│    MODE     │    │  DC COMPONENT                   QUANTIZATION
│ SPECIFYING  │    │                                 START SIGNAL
│  SECTION    │    │        ┌──────────────────┐
└─────────────┘    │        │ TIME-AXIS DC     │            TO 52
        │          ▼        │  COMPONENT       │
┌─────────────┐ ┌──────────┐│  CODE BOOK       │
│    SPACE    │ │CORRELATION││  STORAGE         │ ～56
│  DIRECTION  │ │   RATIO   ││  SECTION         │
│ CODE BOOK   │▶│CALCULATION│└──────────────────┘
│  STORAGE    │ │  SECTION  │┌──────────────────┐        TO 52
│  SECTION    │ │           ││  TIME-AXIS       │
└─────────────┘ └──────────┘│  CODE BOOK       │
        │          │        │  STORAGE         │
       53          │       36│  SECTION         │
                   │        └──────────────────┘ 55   TIME-AXIS VECTOR
                   │                                   QUANTIZATION
                   │                                   START SIGNAL
                   ▼   ～38
            ┌─────────────┐            ┌──────────────────────┐
            │    CODE     │            │  SPACE DIRECTION     │
            │ DETERMINING │───────────▶│      CODE            │ ～39
            │  SECTION    │            │  REARRANGEMENT       │
            └─────────────┘            │ CALCULATING SECTION  │
                   │                   └──────────────────────┘
                   ▼                             ▲
          WINNER CODE OUTPUT           ┌──────────────────────┐
                                       │  SPACE DIRECTION     │
                                       │      CODE            │
                                       │  REARRANGEMENT       │ ～181
                                       │ METHOD SPECIFYING    │
                                       │    SECTION           │
                                       └──────────────────────┘
```

# F I G. 46

RELATIONSHIP BETWEEN COMPRESSION RATIO AND
SPACE DIRECTION CODE REARRANGEMENT METHOD

| METHOD OF EXTRACTING MACROBLOCK OF SPACE DIRECTION CODE | COMPRESSION TARGET FRAME | COMPRESSION RATIO |
|---|---|---|
| 1×1 | 16 FRAMES | 1/341 |
| 2×2 | 4 FRAMES | 1/341 |
| 4×1 | 4 FRAMES | 1/341 |
| 4×4 | 2 FRAMES | 1/341 |
| 3×3 | 3 FRAMES | 1/576 |
| 3×3 | 4 FRAMES | 1/768 |
| 4×4 | 4 FRAMES | 1/1365 |
| 6×6 | 6 FRAMES | 1/4608 |
| 8×8 | 8 FRAMES | 1/10922 |

EP 1 079 635 A1

# F I G. 47

IMAGE INPUT
SECTION ~61

↓

IMAGE PROCESSING
SECTION ~191

↓

COMPRESSION SECTION
USING CODE
BOOK SCHEME ~63

CODE BOOK
STORAGE SECTION ~62

↓

CODE STRING
STORAGE SECTION ~64

CODE VECTOR
AT TIME t

CODE VECTOR
AT TIME
(t+1)

↓

FEATURE AMOUNT
CORRELATION RATIO
CALCULATION SECTION ~192

↓

OUTPUT SECTION ~66

↓

MEDIUM ~67

# F I G. 48

200

4×4 PIXEL MB

(a) FRAME AT TIME t

200

(b) TIME (t+1)

(c) TIME (t+2)

(d) TIME (t+3)

# F I G. 49

(a) FRAME AT TIME t

(b) TIME (t+1)

(c) TIME (t+2)

(d) TIME (t+3)

# F I G. 50

VECTOR QUANTIZING DEVICE

1101 TEMPLATE STOREGE SECTION

1104 FEATURE AMOUNT STORAGE SECTION

1107 ADDRESS INSTRUCTING SECTION

CODE NUMBER

INPUT VECTOR DATA

1A

1E

1B

1102 SIMILARITY CALCULATING SECTION

1105 FEATURE AMOUNT CALCULATING SECTION

1F

1106 CALCULATION OMISSION DETEMINING SECTION

1D

1103 MAXIMUM SIMILARITY SEARCH SECTION

1G CALCULATION OMISSION DETERMINING SIGNAL

EP 1 079 635 A1

# F I G. 51

# F I G. 52

EP 1 079 635 A1

# F I G. 53

TEMPLATE VECTOR DATA

INPUT VECTOR DATA

MAXIMUM SIMILARITY

MAXIMUM SIMILARITY ROW ADDRESS

SEARCH ROW ADDRESS

# F I G. 54

START

INITIALIZE ~ S111

CALCULATE FEATURE AMOUNT
OF INPUT VECTOR DATA ~ S112

DETERMINE SEARCH START ROW BY
REFERRING TO FEATURE AMOUNT RANGE
STORAGE UNIT ~ S113

SET SEARCH START ROW IN
SEARCH ROW COUNTER ~ S114

INCREMENT
SEARCH ROW
COUNTER ~ S117

SEARCH FOR TEMPLATE VECTOR
DATA OF ROW INDICATED
BY SEARCH ROW COUNTER ~ S115

SEARCH
ROW COUNTER WITHIN
SEARCH RANGE ? ~ S116

Y

N

SPECIFY ADDRESS OF TEMPLATE
VECTOR DATA HAVING MAXIMUM
SIMILARITY IN SEARCHED
TEMPLATE VECTOR DATA ~ S118

END

## INTERNATIONAL SEARCH REPORT

International application No.

PCT/JP99/02049

| A. CLASSIFICATION OF SUBJECT MATTER |
|---|
| Int.Cl⁶ H04N7/28, H03M7/30 |

According to International Patent Classification (IPC) or to both national classification and IPC

| B. FIELDS SEARCHED |
|---|
| Minimum documentation searched (classification system followed by classification symbols) |
| Int.Cl⁶ H04N7/24-7/68, H04N1/41-1/419, H03M3/00-11/26 |

Documentation searched other than minimum documentation to the extent that such documents are included in the fields searched

| Jitsuyo Shinan Koho | 1922-1996 | Toroku Jitsuyo Shinan Koho | 1994-1999 |
|---|---|---|---|
| Kokai Jitsuyo Shinan Koho | 1971-1999 | Jitsuyo Shinan Toroku Koho | 1996-1999 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP, 62-171389, A (Nippon Telegraph & Telephone Corp.), 28 July, 1987 (28. 07. 87) (Family: none) | 1-8, 43-49, 64-69 |
| Y | Takahiko Fubatsu, "Gazou no digital shingou shori", 1st edition, 3rd print, Industrial Daily News, 1983, p.192-193 (Fig. 9.31(b)) | 1-8, 43-49, 64-69 |
| Y | "Digital shingou shori handbook", 1st edition, 1st print, edited by IEICE, Omusha Ltd, 1993, p.358-359 (Fig. 2·24) | 1-8, 43-49, 64-69 |
| Y | JP, 07-086954, A (NEC Corp.), 31 March, 1995 (31. 03. 95) & US, 5583888, A | 9-25, 50-57, 70-76 |
| Y | JP, 09-172378, A (AT&T CORP.), 30 June, 1997 (30. 06. 97) & US, 5828413, A & EP, 765085, A2 | 9-25, 50-57, 70-76 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | |
| "O" document referring to an oral disclosure, use, exhibition or other means | "Y" document of particular relevance; the claimed invention cannot be considered to involve an inventive step when the document is combined with one or more other such documents, such combination being obvious to a person skilled in the art |
| "P" document published prior to the international filing date but later than the priority date claimed | "&" document member of the same patent family |

| Date of the actual completion of the international search | Date of mailing of the international search report |
|---|---|
| 25 June, 1999 (25. 06. 99) | 6 July, 1999 (06. 07. 99) |

| Name and mailing address of the ISA/ | Authorized officer |
|---|---|
| Japanese Patent Office | |
| Facsimile No. | Telephone No. |

Form PCT/ISA/210 (second sheet) (July 1992)